(19) Europäisches Patentamt
European Patent Office
Office européen des brevets

(11) EP 2 360 529 B1

(12) **EUROPEAN PATENT SPECIFICATION**

(45) Date of publication and mention of the grant of the patent:
**24.08.2016 Bulletin 2016/34**

(21) Application number: **09829114.9**

(22) Date of filing: **26.11.2009**

(51) Int Cl.:
***G03F 7/32*** *(2006.01)* ***G03F 7/00*** *(2006.01)*
***G03F 7/027*** *(2006.01)* ***G03F 7/032*** *(2006.01)*

(86) International application number:
**PCT/JP2009/069904**

(87) International publication number:
**WO 2010/061869 (03.06.2010 Gazette 2010/22)**

(54) **METHOD FOR MANUFACTURING LITHOGRAPHIC PRINTING PLATE, DEVELOPER FOR ORIGINAL LITHOGRAPHIC PRINTING PLATE, AND REPLENISHER FOR DEVELOPING ORIGINAL LITHOGRAPHIC PRINTING PLATE**

VERFAHREN ZUR HERSTELLUNG EINER LITHOGRAFIEPLATTE, ENTWICKLER FÜR ORIGINALLITHOGRAFIEPLATTE UND NACHFÜLLLÖSUNG ZUR ENTWICKLUNG EINER ORIGINALLITHOGRAFIEPLATTE

PROCÉDÉ DE FABRICATION D'UNE PLAQUE D'IMPRESSION LITHOGRAPHIQUE, RÉVÉLATEUR POUR PLAQUE D'IMPRESSION LITHOGRAPHIQUE ORIGINALE, ET SOLUTION D'ENTRETIEN POUR LE DÉVELOPPEMENT D'UNE PLAQUE D'IMPRESSION LITHOGRAPHIQUE ORIGINALE

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **26.11.2008 JP 2008300699**
**19.03.2009 JP 2009069124**

(43) Date of publication of application:
**24.08.2011 Bulletin 2011/34**

(73) Proprietor: **FUJIFILM Corporation**
**Tokyo 106-8620 (JP)**

(72) Inventors:
- **TAGUCHI, Yoshinori**
  **Shizuoka 421-0396 (JP)**
- **YOSHIDA, Susumu**
  **Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A2- 0 118 096**
**JP-A- 9 281 707**
**JP-A- 2002 287 379**
**JP-A- 2008 241 926**
**US-A- 5 910 391**
**US-B1- 6 280 912**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

The present invention relates to a process for making lithographic printing plate, a developer for lithographic printing plate precursor, and a replenisher for lithographic printing plate precursor development.

In general, a lithographic printing plate is formed from a lipophilic image area for accepting ink and a hydrophilic non-image area for accepting dampening water in a printing process. Lithographic printing is a printing process in which the property of water and printing ink repelling each other is utilized so as to cause a difference in ink attachment on the surface of a lithographic printing plate with a lipophilic image area of the lithographic printing plate as an ink-accepting area and a hydrophilic non-image area as a dampening water-accepting area (non-ink-accepting area), and after inking only the image area ink is transferred to a printing substrate such as paper.

In order to make this lithographic printing plate, a lithographic printing plate precursor (PS plate) formed by providing a lipophilic photosensitive resin layer (photosensitive layer, image recording layer) on a hydrophilic support is widely used in the art. A lithographic printing plate is usually obtained by a process in which, after the lithographic printing plate precursor is exposed through an original image such as a lith film, an area that becomes an image area of the image recording layer is made to remain, and unwanted image recording layer other than this is removed by dissolving using an alkaline developer or an organic solvent to thus form a non-image area in which the surface of the hydrophilic support is exposed.

In this way, in the conventional known plate-making process of a lithographic printing plate precursor, after the exposure as described above, a step of removing unnecessary image recording layer by dissolving, for example, with a developer is required, but from the viewpoint of the environment and safety carrying out processing with a developer that is closer to neutral or reducing the amount of liquid waste are issues. In particular, since in recent years the disposal of liquid waste discharged accompanying wet treatment has become a great concern throughout the industrial world from the viewpoint of consideration for the global environment, the demand for a solution to the above-mentioned issues has been increasing more and more.

On the other hand, digitization techniques involving electronically processing, storing, and outputting image information by computer have been widespread in recent years, and various new image output methods responding to such digitization techniques have been put into practical use. Accompanying this, a computer-to-plate (CTP) technique has been attracting attention in which digitized image information is carried on a highly convergent radiant ray such as laser light and a lithographic printing plate precursor is scan-exposed by this light to directly produce a lithographic printing plate without intervention of a lith film. Therefore, obtaining a lithographic printing precursor suitable for these techniques has become one of the important technological challenges.

As described above, there has been an increasingly strong desire for decreasing the alkalinity of a developer and simplifying the processing step from the viewpoints of both the concerns for the global environment and the conformity with space saving and low running cost.

However, as described above, the conventional development process generally comprises three steps, that is, developing using an aqueous solution of an alkali having a pH of at least 11, then washing away alkali agent using a water washing bath, and subsequently treating using a gumming liquid containing a hydrophilic resin as a main component; because of this an automatic processor itself occupies a large space, and there are still problems in terms of the environment and running cost such as disposal of development effluent, water washing effluent, and gumming effluent.

As a measure thereagainst, Patent Document 1 for example proposes a development method in which processing is carried out using a developer comprising an alkali metal carbonate and bicarbonate, the developer having a pH of 8.5 to 11.5 and a conductivity of 3 to 30 mS/cm.

An example of Patent Document 2 describes processing using a developer comprising a water-soluble polymer compound and having a pH of 11.9 to 12.1. Moreover, Patent Document 3 describes processing using a developer comprising a water-soluble polymer compound and having a pH of 3 to 9.

On the other hand, Patent Document 4 describes a method for forming an image in which, after a photosensitive material comprising a polymerizable compound or a crosslinkable polymer is imagewise cured by utilizing the photosensitivity of a silver halide, an uncured area is removed so as to form an image from a cured area, the amount of gelatin used for dispersing the silver halide in the photosensitive layer being specified, and an alkaline dissolution liquid used for removing the uncured area comprising a protein-decomposing enzyme.

Patent Document 1: JP-A-11-65126 (JP-A denotes a Japanese unexamined patent application publication)
Patent Document 2: EP-A-1868036
Patent Document 3: Published Japanese translation 2007-538279 of a PCT application
Patent Document 4:JP-A-9-281707

The invention described in Patent Document 1 requires water washing and gumming liquid treatment steps,

and environmental and running cost problems cannot be solved. Furthermore, if processing is carried out using a developer having a reduced pH as in Patent Document 1, when a large quantity is processed there is the problem that ethylenically unsaturated compound-derived residue is easily formed in the developer, and there is the problem of degradation in developability.

In the invention described in Patent Document 2, alkali having a pH of 12 adheres to the plate surface of a printing plate thus obtained; there is a problem in terms of operator safety, and when after the printing plate is prepared there is a long time interval before printing, an image area gradually dissolves, thus leading to problems with degraded laydown or printing durability. Furthermore, the effluent treatment, environmental, and running cost problems are not solved.

Since the processing solution described in Patent Document 3 does not contain a base component, it is necessary to make a polymer in a photosensitive layer hydrophilic so as to make it developable, and there is therefore the problem that the printing durability is greatly degraded.

The invention of Patent Document 4 is a process for forming a polymer image by imagewise exposing a photosensitive material comprising a silver halide, a reducing agent, and a polymerizable compound, and thermally developing the silver halide to thereby imagewise polymerize the polymerizable compound. Furthermore, the protein-decomposing enzyme added to the alkaline dissolution liquid is added for the purpose of decomposing gelatin in the photosensitive layer. Since the invention described in Patent Document 4 employs a photosensitive layer comprising a silver halide, silver being a heavy metal, and carries out development using a strongly alkaline developer, there are still problems in terms of treatment of development effluent and water washing effluent, the environment, and running cost. Moreover, with regard to the protein-decomposing enzyme described in Patent Document 4, hydrolysis of an ethylenically unsaturated compound, etc. is not suggested.

An object of the present invention is therefore to provide a process for making a lithographic printing plate that overcomes the defects of the above-mentioned conventional techniques and, specifically, to provide a process for making a Lithographic printing plate that has excellent developability, enables a lithographic printing plate having good printing capabilities such as printing durability and staining resistance to be prepared, enables the occurrence of development residue due to an ethylenically unsaturated compound, etc. to be suppressed, and has excellent processing capability, a developer for a lithographic printing plate precursor, and a replenisher for lithographic printing plate precursor development.

The object of the present invention has been solved by means described below.

1. A developer for a lithographic printing plate precursor, comprising

(a) an enzyme selected from the EC3 group and
(b) a surfactant.

2. The developer for a lithographic printing plate precursor according to Claim 1, wherein the enzyme is selected from the EC3.1 group or the EC3.4 group.

3. The developer for a lithographic printing plate precursor according to Claim 1 or 2, wherein the enzyme is selected from the group consisting of EC3.1.1.3 (triacylglycerol lipase), EC3.4.11.1 (leucine aminopeptidase), EC3.4.21.62 (subtilisin), EC3.4.21.63 (oryzin), EC3.4.22.2 (papain), EC3.4.22.32 (stem bromelain), EC3.4.23.18 (aspergillo pepsin I), EC3.4.24.25 (vibriolysin), EC3.4.24.27 (thermolysin), and EC3.4.24.28 (bacillolysin).

4. The developer for a lithographic printing plate precursor according to any one of Claims 1 to 3, wherein the enzyme has an optimum pH in an alkaline region.

5. The developer for a lithographic printing plate precursor according to any one of Claims 1 to 4, wherein the developer has a pH of at least 6.5 but no greater than 11.

6. The developer for a lithographic printing plate precursor according to any one of Claims 1 to 5, wherein the developer further comprises a water-soluble polymer compound.

7. The developer for a lithographic printing plate precursor according to any one of Claims 1 to 6, wherein the developer has buffer capacity.

8. A process for making a lithographic printing plate, comprising:

(A) a step of preparing a lithographic printing plate precursor comprising above a support a photosensitive layer comprising

(i) a binder polymer,
(ii) an ethylenically unsaturated compound comprising at least one type selected from the group consisting of an ester bond, an amide bond, a tertiary amino group, a urethane bond, a urea bond, a thiourethane bond, and a thiourea bond, and

(iii) a radical polymerization initiator;

(B) an exposure step of exposing the lithographic printing plate precursor; and

(C) a development step of removing the photosensitive layer of a non-exposed area of the lithographic printing plate precursor;
the development step (C) being carried out by means of a developer as defined in any one of the Claims 1 to 7.

9. The plate making process according to Claim 8, wherein the development step (C) is a step in which development-processing is carried out while supplying the enzyme to the developer.
10. The plate making process according to Claim 8 or 9, wherein the developer further comprises a water-soluble polymer compound.
11. The plate making process according to any one of the Claim 8 to 10, wherein the development step is carried out using a single solution.
12. A replenisher for lithographic printing plate precursor development, comprising an enzyme selected from the EC3 group.

In accordance with the present invention, there can be provided a process for making a lithographic printing plate that has excellent developability, enables a lithographic printing plate having good printing capabilities such as printing durability and staining resistance to be prepared, enables the occurrence of development residue due to an ethylenically unsaturated compound, etc. to be suppressed, and has excellent processing capability, a developer for a lithographic printing plate precursor, and a replenisher for lithographic printing plate precursor development.

Brief Description of Drawings

FIG. 1 An explanatory diagram showing the structure of an automatic development processor used in processing the lithographic printing plate precursor of the present invention.
FIG. 2 An explanatory diagram showing the structure of another automatic development processor used in processing the lithographic printing plate precursor of the present invention.

The developer for a lithographic printing plate precursor (hereinafter, also simply called the 'developer') of the present invention comprises (a) an enzyme selected from the EC3 group and (b) a surfactant.
Moreover, in the present invention, the replenisher for lithographic printing plate precursor development (hereinafter, also simply called the 'replenisher') comprises an enzyme selected from the EC3 group.
Further, the process for making a lithographic printing plate of the present invention comprises

(A) a step of preparing a lithographic printing plate precursor comprising above a support a photosensitive layer comprising (i) a binder polymer, (ii) an ethylenically unsaturated compound comprising at least one type selected from the group consisting of an ester bond, an amide bond, a tertiary amino group, a urethane bond, a urea bond, a thiourethane bond, and a thiourea bond, and (iii) a radical polymerization initiator;
(B) an exposure step of exposing the lithographic printing plate precursor; and
(C) a development step of removing the photosensitive layer of a non-exposed area of the lithographic printing plate precursor, the development step (C) being carried out by means of the developer of the present invention as defined above.

Furthermore, the process the process for making a lithographic printing plate of the present invention may also make use of the above replenisher for lithographic printing plate precursor development.
Although the mechanism of action of the present invention is not clear, it is surmised to be as follows. The ethylenically unsaturated compound used in the photosensitive layer of the lithographic printing plate precursor is heavily involved in the developability, development residue dispersibility, and sensitivity of the lithographic printing plate precursor, and the printing durability of a lithographic printing plate prepared. When the hydrophilicity of the ethylenically unsaturated compound increases, although the developability and development residue dispersibility improve, the sensitivity and printing durability are degraded. It is surmised that this is due to improvement of developer penetration into an image area and compatibility with the binder polymer.
Conventionally, as the ethylenically unsaturated compound, from the viewpoint of printing durability, hydrophobic (meth)acryloyl compounds are suitably used. It is thought that since these ethylenically unsaturated compounds undergo,

for example, partial hydrolysis of an ester bond moiety, etc. of the ethylenically unsaturated compound by means of a highly basic developer (e.g. pH = about 12) and become hydrophilic, the occurrence of development residue during development-processing is suppressed. On the other hand, in a low alkalinity development system, it is surmised that it is difficult for the above hydrolysis reaction, etc. to progress with a hydrophobic ethylenically unsaturated compound, dispersing and solubilizing cannot be carried out, and it easily becomes development residue.

In the present invention, it is surmised that by carrying out processing using a developer comprising an enzyme selected from the EC3 group, the ethylenically unsaturated compound comprising at least one type selected from the group consisting of an ester bond, an amide bond, a tertiary amino group, a urethane bond, a urea bond, a thiourethane bond, and a thiourea bond undergoes hydrolysis, etc. in the developer to thus improve its hydrophilicity, thereby suppressing the occurrence of development residue. Furthermore, when an ester group is hydrolyzed, since polarity inversion (polarity inversion from being hydrophobic to being hydrophilic) is utilized, it is surmised that it is difficult for developer penetration into an image area to occur, and the occurrence of development residue can be suppressed while maintaining sensitivity and printing durability.

In the explanation below, the notation 'lower limit to upper limit', which expresses a numerical range, means 'at least the lower limit but no greater than the upper limit' unless otherwise specified, and the notation 'upper limit to lower limit' means 'no greater than the upper limit but at least the lower limit'. That is, they mean numerical ranges that include the upper limit and the lower limit, which are end points.

Lithographic printing plate precursor

With regard to the lithographic printing plate precursor used in the present invention, in particular a photopolymerizable lithographic printing plate precursor, the constitution thereof is now explained in sequence.

In the present invention, the lithographic printing plate precursor comprises above a support a photosensitive layer comprising (i) a binder polymer, (ii) an ethylenically unsaturated compound comprising at least one type selected from the group consisting of an ester bond, an amide bond, a tertiary amino group, a urethane bond, a urea bond, a thiourethane bond, and a thiourea bond, and (iii) a radical polymerization initiator. The photosensitive layer is preferably a photopolymerizable photosensitive layer. Furthermore, it may comprise an undercoat layer between the photosensitive layer and the support, and it may comprise a back coat layer on the side of the support opposite to the side where the photosensitive layer is formed.

In the present invention, the lithographic printing plate precursor is a negative-working lithographic printing plate precursor and is suitably developed by means of a developer comprising an enzyme selected from the EC3 group.

Support

In the present invention, the support used for the lithographic printing plate precursor is not particularly limited and may be a dimensionally stable plate-form hydrophilic support. Examples thereof include paper, paper laminated with a plastic (e.g. polyethylene, polypropylene, polystyrene, etc.), a metal plate (e.g. aluminum, zinc, copper, etc.), a plastic film (e.g. cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), and paper or plastic film on which a metal such as aluminum, zinc, copper, etc. is laminated or vapor-deposited. Preferred examples of the support include a polyester film and an aluminum plate. Among them, an aluminum plate is preferable since dimensional stability is good and it is relatively inexpensive.

The aluminum sheet is a pure aluminum sheet, an alloy sheet containing aluminum as a main component and a small amount of a different element, or a thin film of aluminum or an aluminum alloy laminated with a plastic. Examples of the different element contained in the aluminum alloy include silicon, iron, manganese, copper, magnesium, chromium, zinc, bismuth, nickel, and titanium. The content of the different element in the alloy is preferably equal to or less than 10 wt%. In the present invention, a pure aluminum sheet is preferable, but since it is difficult to produce completely pure aluminum because of the refining technique, a trace amount of a different element may be contained. The composition of the aluminum sheet is not specified, and a known generally used material may be utilized as appropriate.

The support preferably has a thickness of 0.1 to 0.6 mm, more preferably 0.15 to 0.4 mm, and yet more preferably 0.2 to 0.3 mm.

Prior to the aluminum sheet being used, it is preferably subjected to a surface treatment such as a surface roughening treatment or an anodizing treatment. Surface treatment makes it easy to improve the hydrophilicity and ensure that there is good adhesion between an image-forming layer and the support. Prior to the aluminum sheet being subjected to the surface roughening treatment, it may be subjected as desired to a degreasing treatment using a surfactant, an organic solvent, an aqueous alkaline solution, etc. in order to remove rolling oil on the surface.

The surface roughening treatment for the aluminum sheet surface may be carried out by various types of methods, and examples thereof include a mechanical surface roughening treatment, an electrochemical surface roughening treatment (a surface roughening treatment involving dissolving the surface electrochemically), and a chemical surface roughening treatment (a surface roughening treatment involving selectively dissolving the surface chemically). As these treatments, the methods described in paragraph Nos. [0241] to [0245] of in JP-A-2007-206217 are preferably used.

As a method for the mechanical surface roughening treatment, a known method such as a ball grinding method, a brush grinding method, a blast grinding method, or a buff grinding method may be used.

As a method for the electrochemical surface roughening treatment, for example, a method in which alternating current or direct current is applied in an electrolyte solution containing an acid such as hydrochloric acid or nitric acid can be cited. It is also possible to employ a method as described in JP-A-54-63902 in which a mixed acid is used.

The aluminum sheet subjected to a surface roughening treatment is subjected as necessary to an alkali etching treatment using an aqueous solution of potassium hydroxide, sodium hydroxide, etc.; furthermore, after neutralization, it may be subjected to an anodizing treatment as desired in order to improve the abrasion resistance.

As an electrolyte that may be used for the anodizing treatment of the aluminum sheet, various types of electrolytes that form a porous oxide film may be used. In general, sulfuric acid, hydrochloric acid, oxalic acid, chromic acid, or a mixed acid thereof may be used. The concentration of the electrolyte may be determined as appropriate according to the type of electrolyte.

Conditions for the anodizing treatment depend on the type of electrolyte used and cannot be specified, but in general the electrolyte solution concentration is 1 to 80 wt%, the solution temperature is 5°C to 70°C, the current density is 5 to 60 A/dm$^2$, the voltage is 1 to 100V, and the electrolysis time is 10 sec. to 5 min. The amount of anodized film formed is preferably 1.0 to 5.0 g/m$^2$, and more preferably 1.5 to 4.0 g/m$^2$. It is preferable for it to be in this range since good printing durability and good scratch resistance of a non-image area of a lithographic printing plate can be obtained.

As the support that can be used in the present invention, a substrate that has been subjected to the above-mentioned surface treatment and has an anodized film may be used as it is, but in order to further improve the adhesion to the upper layer, and the hydrophilicity, the contamination resistance, insulation ability, etc., the substrate may appropriately be subjected as necessary to a treatment for enlarging micropores of the anodized film, a sealing treatment, or a surface hydrophilization treatment involving immersion in an aqueous solution containing a hydrophilic compound, which are described in JP-A-2001-253181 or JP-A-2001-322365. These enlarging and sealing treatments are not limited to those described therein, and any conventionally known methods may be employed.

The sealing treatment may be vapor sealing, a treatment with an aqueous solution containing an inorganic fluorine compound such as a single treatment with fluorozirconic acid or a treatment with sodium fluoride, vapor sealing with added lithium chloride, or a sealing treatment with hot water.

Among these, the sealing treatment with an aqueous solution containing an inorganic fluorine compound, the sealing treatment with vapor, and the sealing treatment with hot water are preferable.

In the lithographic printing plate precursor, it is desirable to subject the support surface to a hydrophilization treatment or provide an undercoat layer between the support and the photosensitive layer in order to improve the hydrophilicity of a non-image area and prevent print staining. The undercoat layer is described later.

Examples of the hydrophilization treatment of the support surface include an alkali metal silicate treatment method in which a support is subjected to electrolysis or an immersion treatment in an aqueous solution of sodium silicate, etc., a method involving treatment with potassium fluorozirconate, and a method involving treatment with polyvinylphosphonic acid.

The alkali metal silicate treatment method is described in U.S. Pat. Nos. 2,714,066, 3,181,461, 3,280,734, and 3,902,734, and in this method a support is subjected to electrolysis or an immersion treatment using an aqueous solution of sodium silicate, etc. The method involving treatment with potassium fluorozirconate is described in JP-B-36-22063 (JP-B denotes a Japanese examined patent application publication), and the method involving treatment with polyvinylphosphonic acid is described in U.S. Pat. Nos. 3,276,868, 4,153,461, and 4,689,272.

Among them, the method involving an immersion treatment with an aqueous solution of polyvinylphosphonic acid is preferably used.

When a support having insufficient surface hydrophilicity such as a polyester film is used as a support, it is preferable to coat the surface with a hydrophilic layer so as to make the surface hydrophilic.

As the hydrophilic layer, a hydrophilic layer, described in JP-A-2001-199175, formed by coating with a coating liquid containing a colloid of an oxide or hydroxide of at least one element selected from the group consisting of beryllium, magnesium, aluminum, silicon, titanium, boron, germanium, tin, zirconium, iron, vanadium, antimony, and a transition metal, a hydrophilic layer, described in JP-A-2002-79772, having an organic hydrophilic matrix obtained by crosslinking or pseudo-crosslinking an organic hydrophilic polymer, a hydrophilic layer having an inorganic hydrophilic matrix obtained by sol-gel exchange involving dehydration and condensation reactions of a polyalkoxysilane, titanate, zirconate or aluminate, or a hydrophilic layer formed from an inorganic thin film having a surface containing a metal oxide is preferable. Among them, a hydrophilic layer formed by coating with a coating liquid containing a colloid of an oxide or hydroxide of silicon is preferable.

In the present invention, when a polyester film, etc. is used as a support, it is preferable to provide an antistatic layer on a hydrophilic layer side, the opposite side, or both sides of the support. When an antistatic layer is provided between the support and a hydrophilic layer, it also contributes to an improvement in adhesion to the hydrophilic layer. As an antistatic layer, a polymer layer, described in JP-A-2002-79772, in which metal oxide microparticles or a matting agent are dispersed, etc. may be used.
The support preferably has a center line average roughness of 0.10 to 1.2 μm. When in the above-mentioned range, good adhesion to the photosensitive layer, good printing durability, and good stain resistance can be obtained.
Moreover, the color density of the support is preferably 0.15 to 0.65 as a reflection density value. When in the above-mentioned range, it is possible to obtain good image formation properties by preventing halation during imagewise exposure and to obtain good ease of plate inspection after development.

Photosensitive layer

A photosensitive layer (hereinafter, also called an 'image-forming layer') in the lithographic printing plate precursor of the present invention comprises as fundamental components (i) a binder polymer, (ii) an ethylenically unsaturated compound comprising at least one type selected from the group consisting of an ester bond, an amide bond, a tertiary amino group, a urethane bond, a urea bond, a thiourethane bond, and a thiourea bond, and (iii) a radical polymerization initiator.

(i) Binder polymer

The binder polymer used in the present invention is now explained.
As the binder polymer, one that can support a photosensitive layer component above a support and that can be removed by a developer is used. The binder polymer is a polymer that functions as a film-forming agent of the photosensitive layer, and preferably comprises a linear organic polymer. As such a 'linear organic polymer', a known polymer may be used.
Such a binder polymer is preferably a polymer selected from the group consisting of a (meth)acrylic polymer, a polyvinyl acetal resin, a polyvinyl alcohol resin, a polyvinyl butyral resin, a polyvinyl formal resin, a polyurethane resin, a polyamide resin, an epoxy resin, a methacrylic resin, a styrene-based resin, and a polyester resin. Among them, a vinyl (co)polymer such as a (meth)acrylic polymer or a styrene-based resin or a polyurethane resin is more preferable, and a (meth)acrylic polymer or a polyurethane resin is yet more preferable. The '(meth)acrylic polymer' referred to here means a (meth)acrylic polymer containing as a (co)polymer component at least one type of (meth)acrylic acid and/or derivative thereof (e.g. a (meth)acrylic acid ester (alkyl ester, aryl ester, allyl ester, etc.), a (meth)acrylamide, a (meth)acrylamide derivative, etc.). The 'polyurethane resin' referred to here means a polymer formed by a condensation reaction of a compound having a plurality of isocyanate groups (preferably two) and a compound having a plurality of hydroxy groups (preferably two).
Preferred examples of the binder polymer in the present invention include a copolymer comprising a repeating unit comprising an acid group. Examples of the acid group include a carboxylic acid group, a sulfonic acid group, a phosphonic acid group, a phosphoric acid group, and a sulfonamide group, and a carboxylic acid group is particularly preferable. A polymer comprising (meth)acrylic acid as a polymerization monomer or a polymer comprising a repeating unit represented by Formula (I) below is particularly preferably used.

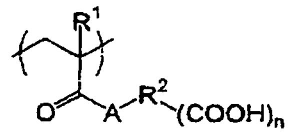

(I)

(In Formula (I), $R^1$ denotes a hydrogen atom or a methyl group, and $R^2$ denotes a single bond or an (n+1)-valent linking group. A denotes an oxygen atom or -$NR^3$-, and $R^3$ denotes a hydrogen atom or a monovalent hydrocarbon group having 1 to 10 carbons. n denotes an integer of 1 to 5.)
The linking group denoted by $R^2$ in Formula (I) comprises hydrogen, carbon, oxygen, nitrogen, sulfur, and halogen atoms, and the number of atoms is preferably 1 to 80. Specific examples include an alkylene, a substituted alkylene, an arylene, and a substituted arylene, and these divalent groups may have a structure in which a plurality thereof are linked via an amide bond or an ester bond. $R^2$ is preferably a single bond, an alkylene, or a substituted alkylene, particularly preferably a single bond, an alkylene having 1 to 5 carbons, or a substituted alkylene having 1 to 5 carbons, and most preferably a single bond, an alkylene having 1 to 3 carbons, or a substituted alkylene having 1 to 3 carbons.

As the substituent, a monovalent non-metal atomic group other than a hydrogen atom can be cited, and examples thereof include a halogen atom (-F, -Br,-Cl, -I), a hydroxy group, an alkoxy group, an aryloxy group, a mercapto group, an acyl group, a carboxy group and a conjugate base group thereof, an alkoxycarbonyl group, an aryloxycarbonyl group, a carbamoyl group, an aryl group, an alkenyl group, and an alkynyl group.

$R^3$ is preferably a hydrogen atom or a hydrocarbon group having 1 to 5 carbons, particularly preferably a hydrogen atom or a hydrocarbon group having 1 to 3 carbons, and most preferably a hydrogen atom or a methyl group. n is preferably 1 to 3, particularly preferably 1 or 2, and most preferably 1.

The proportion (mole%) of carboxylic acid group-containing copolymerization components in the total copolymerization components of the binder polymer is, from the viewpoint of developability, preferably 1% to 70%. From the viewpoint of a balance being achieved between developability and printing durability, it is more preferably 1% to 50%, and particularly preferably 1% to 30%.

Furthermore, crosslinking properties may be imparted to the binder polymer in order to improve the film strength of an image area.

In order to impart crosslinking properties to the binder polymer, a crosslinkable functional group such as an ethylenically unsaturated bond may be introduced into a main chain or side chain of the binder polymer (polymer). From the viewpoint of reactivity, a binder polymer containing a crosslinkable group in a side chain is preferably used. The crosslinkable functional group may be introduced by copolymerization or a polymer reaction.

The crosslinkable group referred to here is a group that crosslinks the polymer binder in the process of a radical polymerization reaction occurring in the photosensitive layer when the lithographic printing plate precursor is exposed. The group is not particularly limited as long as it has the above function, and examples thereof include, as a functional group that can undergo an addition polymerization reaction, an ethylenically unsaturated bond group, an amino group, and an epoxy group. It may be a functional group that can become a radical upon exposure to light, and examples of such a crosslinkable group include a thiol group, a halogen group, and an onium salt structure. Among them, an ethylenically unsaturated bond group is preferable, and as the ethylenically unsaturated bond group, a styryl group, a (meth)acryloyl group, and an allyl group are preferable.

As the ethylenically unsaturated bond group, functional groups represented by Formulae (1') to (3') below are particularly preferable.

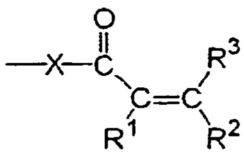

(1')

In Formula (1') above, $R^1$ to $R^3$ independently denote a monovalent organic group.

Preferred examples of $R^1$ include a hydrogen atom or an optionally substituted alkyl group (preferably 1 to 6 carbons), and among them a hydrogen atom or a methyl group is more preferable because of high radical reactivity.

Furthermore, $R^2$ and $R^3$ independently denote a hydrogen atom, a halogen atom, an amino group, a carboxy group, an alkoxycarbonyl group (preferably 1 to 20 carbons, more preferably 1 to 10 carbons, yet more preferably 1 to 6 carbons), a sulfo group, a nitro group, a cyano group, an optionally substituted alkyl group (preferably 1 to 20 carbons, more preferably 1 to 10 carbons, yet more preferably 1 to 6 carbons), an optionally substituted aryl group (preferably 6 to 20 carbons, more preferably 6 to 10 carbons), an optionally substituted alkoxy group (preferably 1 to 20 carbons, more preferably 1 to 10 carbons, yet more preferably 1 to 6 carbons), an optionally substituted aryloxy group (preferably 6 to 20 carbons, more preferably 6 to 10 carbons), an optionally substituted alkylamino group (preferably 1 to 20 carbons, more preferably 1 to 10 carbons, yet more preferably 1 to 6 carbons), an optionally substituted arylamino group (preferably 6 to 20 carbons, more preferably 6 to 10 carbons), an optionally substituted alkylsulfonyl group (preferably 1 to 20 carbons, more preferably 1 to 10 carbons, yet more preferably 1 to 6 carbons), an optionally substituted arylsulfonyl group (preferably 6 to 20 carbons, more preferably 6 to 10 carbons), etc., and among them a hydrogen atom, a carboxy group, an alkoxycarbonyl group having 1 to 6 carbons, an optionally substituted alkyl group having 1 to 6 carbons, and an optionally substituted aryl group having 6 to 10 carbons are preferable because of high radical reactivity.

X denotes an oxygen atom, a sulfur atom, or $N(R^{12})$, and $R^{12}$ denotes a hydrogen atom or a monovalent organic group. Here, examples of $R^{12}$ include an optionally substituted alkyl group (preferably 1 to 20 carbons, more preferably 1 to 10 carbons, yet more preferably 1 to 6 carbons, particularly preferably 1 to 4 carbons), and among them a hydrogen atom, a methyl group, an ethyl group, or an isopropyl group is preferable because of high radical reactivity.

Examples of the substituent that can be introduced here include an alkyl group (preferably 1 to 20 carbons, more preferably 1 to 10 carbons, yet more preferably 1 to 6 carbons), an alkenyl group (preferably 2 to 20 carbons, more preferably 2 to 10 carbons, yet more preferably 2 to 6 carbons), an alkynyl group (preferably 2 to 20 carbons, more preferably 2 to 10 carbons, yet more preferably 2 to 6 carbons), an aryl group (preferably 6 to 20 carbons, more preferably

6 to 10 carbons), an alkoxy group (preferably 1 to 20 carbons, more preferably 1 to 10 carbons, yet more preferably 1 to 6 carbons), an aryloxy group (preferably 6 to 20 carbons, more preferably 6 to 10 carbons), a halogen atom (fluorine atom, chlorine atom, bromine atom, iodine atom), an amino group, an alkylamino group (preferably 1 to 20 carbons, more preferably 1 to 10 carbons, yet more preferably 1 to 6 carbons), an arylamino group (preferably 6 to 20 carbons, more preferably 6 to 10 carbons), a carboxy group, an alkoxycarbonyl group (preferably 2 to 20 carbons, more preferably 2 to 10 carbons, yet more preferably 2 to 6 carbons), a sulfo group, a nitro group, a cyano group, an amide group, an alkylsulfonyl group (preferably 1 to 20 carbons, more preferably 1 to 10 carbons, yet more preferably 1 to 6 carbons), and an arylsulfonyl group (preferably 6 to 20 carbons, more preferably 6 to 10 carbons).

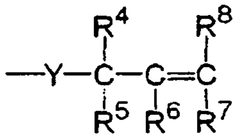
(2')

In Formula (2') above, $R^4$ to $R^8$ independently denote a monovalent organic group.

Preferred examples of $R^4$ to $R^8$ include a hydrogen atom, a halogen atom, an amino group, a dialkylamino group (each alkyl group preferably having 1 to 20 carbons, more preferably 1 to 10 carbons, and yet more preferably 1 to 6 carbons), a carboxy group, an alkoxycarbonyl group (preferably 1 to 20 carbons, more preferably 1 to 10 carbons, yet more preferably 1 to 6 carbons), a sulfo group, a nitro group, a cyano group, an optionally substituted alkyl group (preferably 1 to 20 carbons, more preferably 1 to 10 carbons, yet more preferably 1 to 6 carbons), an optionally substituted aryl group (preferably 6 to 20 carbons, more preferably 6 to 10 carbons), an optionally substituted alkoxy group (preferably 1 to 20 carbons, more preferably 1 to 10 carbons, yet more preferably 1 to 6 carbons), an optionally substituted aryloxy group (preferably 6 to 20 carbons, more preferably 6 to 10 carbons), an optionally substituted alkylamino group (preferably 1 to 20 carbons, more preferably 1 to 10 carbons, yet more preferably 1 to 6 carbons), an optionally substituted arytamino group (preferably 6 to 20 carbons, more preferably 6 to 10 carbons), an optionally substituted alkylsulfonyl group (preferably 1 to 20 carbons, more preferably 1 to 10 carbons, yet more preferably 1 to 6 carbons), and an optionally substituted arylsulfonyl group (preferably 6 to 20 carbons, more preferably 6 to 10 carbons), and among them a hydrogen atom, a carboxy group, an alkoxycarbonyl group having 1 to 6 carbons, an optionally substituted alkyl group having 1 to 6 carbons, and an optionally substituted aryl group having 6 to 10 carbons are more preferable.

Examples of substituents that can be introduced include the same substituents as for Formula (1').

Y denotes an oxygen atom, a sulfur atom, or $N(R^{12})$. $R^{12}$ has the same meaning as $R^{12}$ defined in Formula (1'), and preferred examples thereof are also the same.

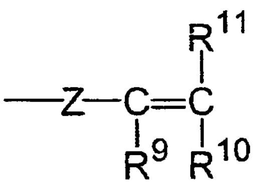
(3')

In Formula (3') above, $R^9$ to $R^{11}$ independently denote a monovalent organic group.

Preferred examples of $R^9$ include a hydrogen atom or an optionally substituted alkyl group (preferably 1 to 20 carbons, more preferably 1 to 10 carbons, yet more preferably 1 to 6 carbons), and among them a hydrogen atom or a methyl group is more preferable because of high radical reactivity.

Examples of $R^{10}$ and $R^{11}$ independently include a hydrogen atom, a halogen atom, an amino group, a dialkylamino group (each alkyl group having preferably 1 to 20 carbons, more preferably 1 to 10 carbons, and yet more preferably 1 to 6 carbons), a carboxy group, an alkoxycarbonyl group (preferably 1 to 20 carbons, more preferably 1 to 10 carbons, yet more preferably 1 to 6 carbons), a sulfo group, a nitro group, a cyano group, an optionally substituted alkyl group (preferably 1 to 20 carbons, more preferably 1 to 10 carbons, yet more preferably 1 to 6 carbons), an optionally substituted aryl group (preferably 6 to 20 carbons, more preferably 6 to 10 carbons), an optionally substituted alkoxy group (preferably 1 to 20 carbons, more preferably 1 to 10 carbons, yet more preferably 1 to 6 carbons), an optionally substituted aryloxy group (preferably 6 to 20 carbons, more preferably 6 to 10 carbons), an optionally substituted alkylamino group (preferably 1 to 20 carbons, more preferably 1 to 10 carbons, yet more preferably 1 to 6 carbons), an optionally substituted arylamino group (preferably 6 to 20 carbons, more preferably 6 to 10 carbons), an optionally substituted alkylsulfonyl group (preferably 1 to 20 carbons, more preferably 1 to 10 carbons, yet more preferably 1 to 6 carbons), and an optionally substituted arylsulfonyl group (preferably 6 to 20 carbons, more preferably 6 to 10 carbons), and among them a hydrogen atom, a carboxy group, an alkoxycarbonyl group having 2 to 6 carbons, an optionally substituted alkyl

group having 1 to 6 carbons, or an optionally substituted aryl group having 6 to 10 carbons is preferable because of high radical reactivity.

Examples of substituents that can be introduced include the same substituents as for Formula (1').

Z denotes an oxygen atom, a sulfur atom, $N(R^{13})$, or an optionally substituted phenylene group.

$R^{13}$ denotes an optionally substituted alkyl group having 1 to 6 carbon atoms, etc. Among them, a methyl group, an ethyl group, or an isopropyl group is preferable because of high radical reactivity.

Among them, a (meth)acrylic acid copolymer and a urethane resin, each having a crosslinkable group in a side chain thereof, are more preferable.

In the binder polymer having crosslinking properties, for example, a free radical (a polymerization initiating radical or a propagating radical in the process of polymerization of the polymerizable compound) is added to the crosslinkable functional group to cause addition-polymerization between polymers directly or through a polymerization chain of the polymerizable compound; as a result, crosslinking is formed between polymer molecules to effect curing. Alternatively, an atom (for example, a hydrogen atom on a carbon atom adjacent to the functional crosslinkable group) in the polymer is abstracted by a free radical to produce a polymer radical, and polymer radicals combine with each other to form crosslinking between polymer molecules to effect curing.

The content of the crosslinkable group (content of radically polymerizable unsaturated double bond determined by iodine titration) in the binder polymer is preferably 0.01 to 10.0 mmol, more preferably 0.05 to 7.0 mmol, yet more preferably 0.1 to 5.5 mmol, and particulary preferably 0.1 to 2.0 mmol, per g of the binder polymer.

Furthermore, the binder polymer used is appropriately selected according to the mode of development-processing so that a non-image area of the photosensitive layer is removed well in a plate making process for the lithographic printing plate. Details are described below.

The binder polymer used in the present invention may have, in addition to the above-mentioned acid group-containing polymerization unit and crosslinkable group-containing polymerization unit, an alkyl or aralkyl (meth)acrylate ester polymerization unit. The alkyl group of the alkyl (meth)acrylate ester is preferably an alkyl group having 1 to 5 carbons, and more preferably a methyl group. Examples of the aralkyl (meth)acrylate ester include benzyl (meth)acrylate.

The binder polymer preferably has a weight-average molecular weight of at least 5,000, and more preferably 10,000 to 300,000, and preferably has a number-average molecular weight of at least 1,000, and more preferably 2,000 to 250,000. The polydispersity (weight-average molecular weight/number-average molecular weight) thereof is preferably 1.1 to 10.

The binder polymer may be used on its own or as a mixture of two or more types. From the viewpoint of good strength of an image area and image formation properties, the content of the binder polymer is preferably 5 to 75 wt% relative to the total solids content of the photosensitive layer, more preferably 10 to 70 wt%, and yet more preferably 10 to 60 wt%.

Furthermore, the total content of the polymerizable compound and the binder polymer is preferably no greater than 80 wt% relative to the total solids content of the photosensitive layer. When it exceeds 80 wt%, the sensitivity and developability might be degraded. It is more preferably 35 to 75 wt%.

(i-1) Alkali-soluble binder polymer

In a mode in which development-processing is carried out using an alkaline developer, since it is necessary for a binder polymer to be dissolved in an alkaline developer, an organic polymer that is soluble in an aqueous alkali is preferably used, and an organic polymer that is soluble in an aqueous alkali preferably has a pH of 7.5 to 13, and more preferably 7.5 to 11.

In order to be soluble in an aqueous alkali, it is preferable to have an alkali-soluble group. The alkali-soluble group is preferably an acid group, and examples thereof include a carboxy group, a sulfonic acid group, a phosphoric acid group, and a hydroxy group. Among them, from the viewpoint of achieving a balance between film-forming properties, printing durability, and developability, a binder polymer having a carboxy group is particularly preferable.

As the carboxy group-containing binder polymer, a binder polymer having (meth)acrylic acid as a monomer unit is particularly preferable. The binder polymer having (meth)acrylic acid as a monomer unit is more preferably a binder polymer having a (meth)acrylic acid alkyl ester as a monomer unit, and the alkyl group of the alkyl ester is preferably an alkyl group having 1 to 5 carbon atoms.

Furthermore, crosslinking properties may be imparted to the alkali-soluble binder polymer as described above in order to improve the film strength of an image area. In order to impart crosslinking properties to the binder polymer, a crosslinkable functional group such as an ethylenically unsaturated bond is introduced into a main chain or side chain of the polymer. The crosslinkable functional group may be introduced by copolymerization or a polymer reaction.

The alkali-soluble binder polymer preferably has a weight-average molecular weight of 5,000 or more, and more preferably 10,000 to 300,000, and a number-average molecular weight of 1,000 or more, and more preferably 2,000 to 250,000. The polydispersity (weight-average molecular weight/number-average molecular weight) is preferably

1.1 to 10.

The alkali-soluble binder polymer may be any of a random polymer, a block polymer, a graft polymer, etc., and is preferably a random polymer.

The alkali-soluble binder polymer may be used singly or in a combination of two or more types as a mixture.

The content of the alkali-soluble binder polymer is preferably 5 to 90 wt% relative to the total solids content of the photosensitive layer, more preferably 10 to 70 wt%, and yet more preferably 10 to 60 wt%. When in the above-mentioned range, good strength for an image area and good image formation properties are obtained. Furthermore, when two or more types of binder polymers are used in combination, the total amount is preferably the above-mentioned content.

(i-2) Hydrophilic group-containing binder polymer

As a binder polymer that can be used in the photosensitive layer, in order to improve developability by the developer, a binder polymer having a hydrophilic group (hydrophilic group-containing binder polymer) may be used. In particular, when an acidic to weakly alkaline (a pH of 2 to 10) developer is used, a hydrophilic group-containing binder polymer is preferably used.

The hydrophilic group is selected from monovalent and di- or higher-valent hydrophilic groups, and preferred examples thereof include a hydroxy group, a sulfonic acid group, a carboxylic acid group, a phosphoric acid group, an alkyleneoxy group such as an ethyleneoxy group or a propyleneoxy group, a primary amino group, a secondary amino group, a tertiary amino group, a salt formed by neutralizing an amino group with an acid, a quaternary ammonium group, a sulfonium group, an iodonium group, a phosphonium group, an amide group, an ether group, and a salt formed by neutralizing an acid group such as a carboxylic acid, sulfonic acid, or phosphoric acid; particularly preferred examples thereof include a primary amino group, a secondary amino group, a tertiary amino group, a salt formed by neutralizing an amino group with an acid, a quaternary ammonium group, an amide group, a hydroxy group, a $-CH_2CH_2O-$ repeating unit, and a $-CH_2CH_2NH-$ repeating unit, and most preferred examples thereof include a tertiary amino group, a salt formed by neutralizing an acid group with an amino group-containing compound, a salt formed by neutralizing an amino group with an acid, and a quaternary ammonium group.

The hydrophilic group-containing binder polymer is preferably a copolymer, and from the viewpoint of developability the proportion of the copolymer component having a hydrophilic group described above in the total copolymer components of the copolymer is preferably 1 to 70 wt% relative to the total monomer units forming the copolymer, and from the viewpoint of a balance being achieved between developability and printing durability it is preferably 1 to 50 wt% and particularly preferably 1 to 30 wt%.

The hydrophilic group-containing binder polymer preferably has the type of crosslinkable group described above.

The content of the crosslinkable group (content of radically polymerizable unsaturated double bond determined by iodine titration) in the hydrophilic group-containing binder polymer is preferably 0.01 to 10.0 mmol, more preferably 0.05 to 5.0 mmol, and yet more preferably 0.1 to 2.0 mmol, per g of the hydrophilic group-containing binder polymer.

From the viewpoint of improvement of printing durability, the crosslinkable group is desirably in the vicinity of the hydrophilic group, and the hydrophilic group and the crosslinkable group may be present on the same monomer unit.

The hydrophilic group-containing binder polymer preferably has, in addition to the above-mentioned hydrophilic group-containing unit, crosslinkable group-containing unit, and hydrophilic group- and crosslinkable group-containing unit, an alkyl or aralkyl (meth)acrylate unit. The alkyl group of the alkyl (meth)acrylate is preferably an alkyl group having 1 to 5 carbon atoms, and more preferably a methyl group. Examples of the aralkyl (meth)acrylate include benzyl (meth)acrylate.

The hydrophilic group-containing binder polymer preferably has a weight-average molecular weight of 5,000 or more, and more preferably of 10,000 to 300,000, and a number-average molecular weight of 1,000 or more, and more preferably 2,000 to 250,000. The polydispersity (weight-average molecular weight/number-average molecular weight) is preferably 1.1 to 10.

The hydrophilic group-containing binder polymer may be any of a random polymer, a block polymer, a graft polymer, etc.

With regard to the hydrophilic group-containing binder polymer, one type may be used on its own or two or more types may be used as a mixture.

From the viewpoint of good strength of an image area and image formation properties, the content of the hydrophilic group-containing binder polymer is preferably 5 to 75 wt% relative to the total solids content of the photosensitive layer, more preferably 10 to 70 wt%, and yet more preferably 10 to 60 wt%. Furthermore, when two or more types of hydrophilic group-containing binder polymers are used in combination, the total amount of hydrophilic group-containing binder polymers is preferably the above-mentioned content.

Furthermore, the total content of the Ethylenically unsaturated compound (polymerizable compound) and the binder polymer is preferably no greater than 80 wt% relative to the total solids content of the photosensitive layer, and

more preferably 35 to 75 wt%. When in the above-mentioned range, sensitivity and developability are excellent.

Specific examples of monomer units constituting the hydrophilic group-containing binder polymer and specific examples of the hydrophilic group-containing binder polymer are shown below, but the present invention is not limited by these examples. Weight-average molecular weight (Mw, also expressed simply as 'molecular weight' in the table below) in the table below is measured by gel permeation chromatography (GPC) using polystyrene as a reference material. In the chemical formulae below, $TsO^-$ is an abbreviation for *p*-$CH_3C_6H_4SO_3^-$.

| Polymer No. | Binder Structure (mol %) | Molecular weight |
|---|---|---|
| P - 1 | 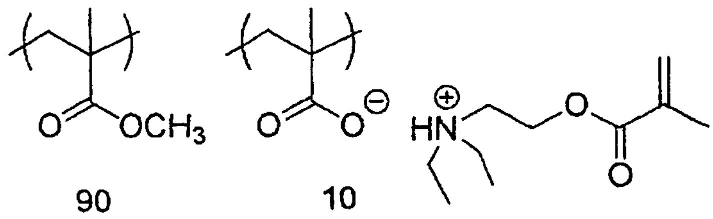 90 10 | 80, 000 |
| P - 2 | 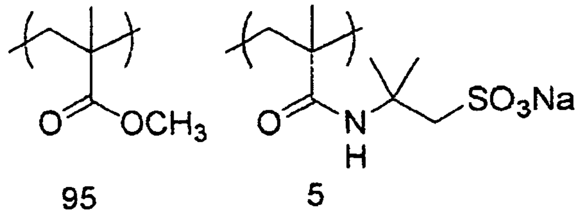 95 5 | 72, 000 |

| Polymer No. | Diisocyanate compound used (mol%) | Diol compound used (mol%) | Molecular weight |
|---|---|---|---|
| P - 3 | 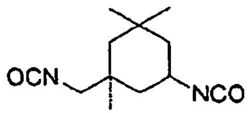 70 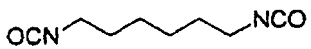 30 | 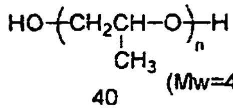 40 (Mw=400) 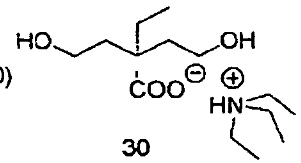 30 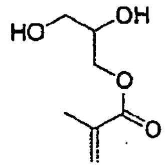 30 | 60, 000 |

| Polymer No. | Binder structure (mol %) | Molecular weight |
|---|---|---|
| P - 4 | 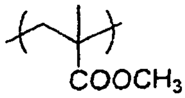 90 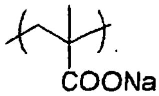 10 | 50, 000 |
| P - 5 | 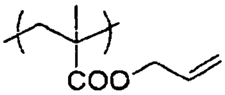 90 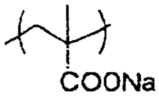 10 | 60, 000 |
| P - 6 | 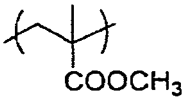 65 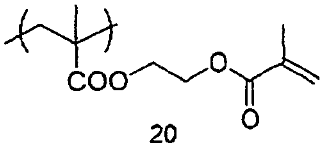 20 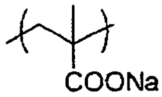 15 | 65, 000 |
| P - 7 | 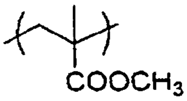 85 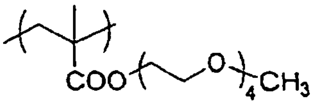 10 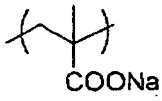 5 | 60, 000 |
| P - 8 | 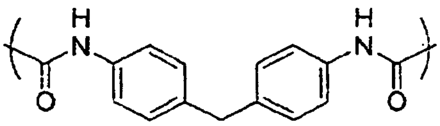 40 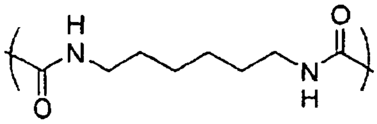 10 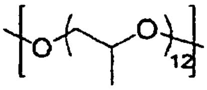 20 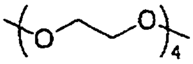 20 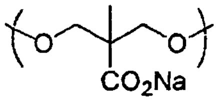 10 | 63, 000 |
| P - 9 | 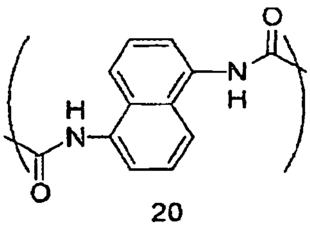 20 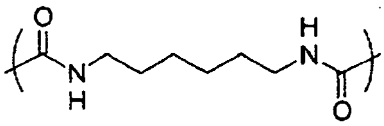 30 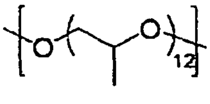 20 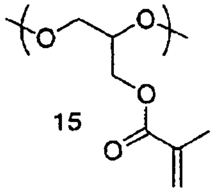 15 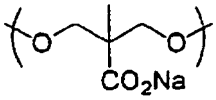 15 | 60, 000 |

| Polymer No. | Polymer structure | Composition ratio | Molecular weight |
|---|---|---|---|
| P - 10 | 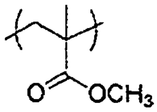 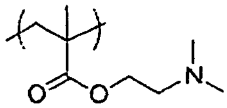 | 90/10 | 70, 000 |
| P - 11 | 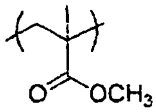 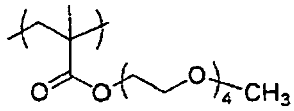 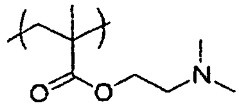 | 90/5/5 | 80, 000 |
| P - 12 | 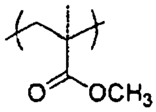 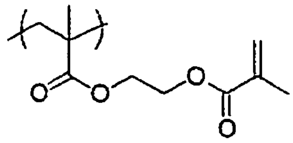 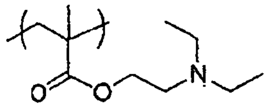 | 60/35/5 | 80, 000 |

| Polymer No. | Diisocyanate compound used (mol %) | Diol compound used (mol %) | Molecular weight |
|---|---|---|---|
| P - 13 | 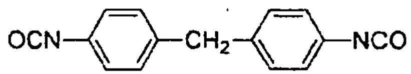 80 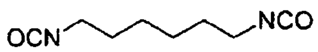 20 | 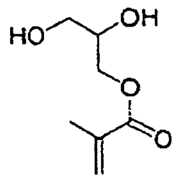 30 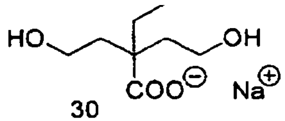 30 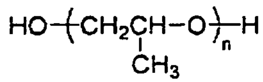 40 (Mw=400) | 57,000 |

| Polymer No. | Polymer structure | Composition ratio | Molecular weight |
|---|---|---|---|
| P - 14 | 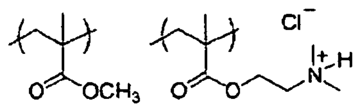 | 90/10 | 70, 000 |
| P - 15 | 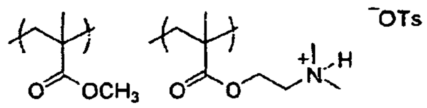 | 90/10 | 58, 000 |
| P - 16 | 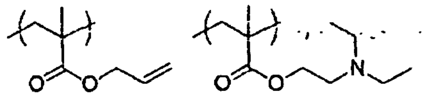 | 90/10 | 90, 000 |
| P - 17 | 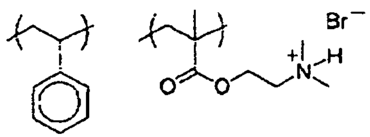 | 70/30 | 62, 000 |
| P - 18 | 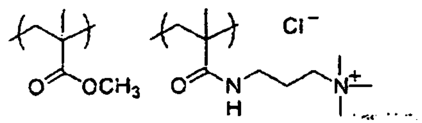 | 70/30 | 58, 000 |
| P - 19 | 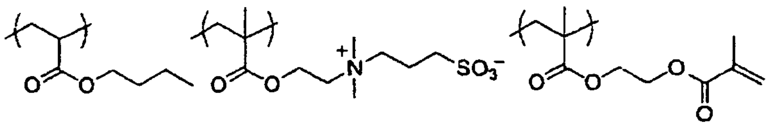 | 50/25/25 | 49, 000 |

| Polymer No. | Diisocyanate structure (mol%) | | Diol structure (mol%) | | | Mw |
|---|---|---|---|---|---|---|
| P-20 | 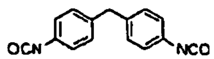 40 | 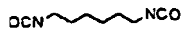 10 | 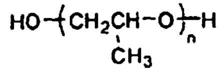 10 (Mw=1000) | 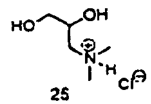 25 | 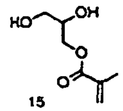 15 | 59, 000 |
| P-21 | 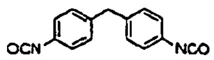 40 | 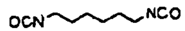 10 | 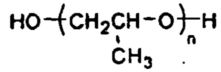 10 (Mw=1000) | 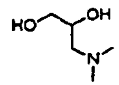 25 | 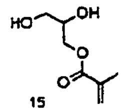 15 | 59, 000 |
| P-22 | 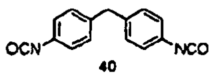 40 | 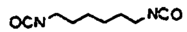 10 | 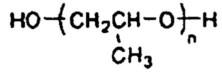 10 (Mw=1000) | 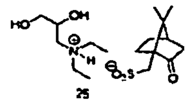 25 | 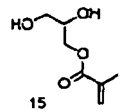 15 | 62, 000 |
| P-23 | 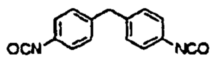 40 | 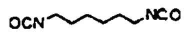 10 | 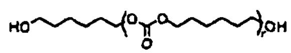 10 | 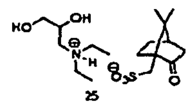 25 | 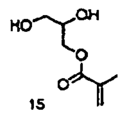 15 | 53, 000 |

| Polymer No. | Binder structure (mol %) | Molecular weight |
|---|---|---|
| P - 24 | 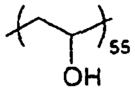 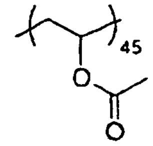 | 80, 000 |
| P - 25 | 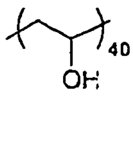 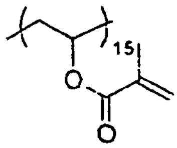 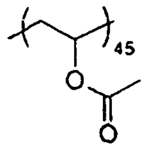 | 100, 000 |

(ii) Ethylenically unsaturated compound

In the present invention, the ethylenically unsaturated compound comprising at least one type selected from the group consisting of an ester bond, an amide bond, a tertiary amino group, a urethane bond, a urea bond, a thiourethane bond, and a thiourea bond used in the photosensitive layer (hereinafter, also called an 'addition-polymerizable compound') is selected from compounds having at least one, and preferably at least two, ethylenically unsaturated bonds. Such a group of compounds is widely known in the present industrial field, and they may be used in the present invention without particular limitations. They have a chemical form such as, for example, a monomer, a prepolymer such as a dimer or a trimer, an oligomer, a mixture thereof, or a copolymer thereof.

Examples of the monomer and a copolymer thereof include esters of an unsaturated carboxylic acid (e.g. of acrylic acid, methacrylic acid, itaconic acid, crotonic acid, isocrotonic acid and maleic acid) and a polyhydric alcohol compound or an amide of an unsaturated carboxylic acid. Furthermore, an addition reaction product of an unsaturated carboxylic acid ester or amide having a nucleophilic substituent such as a hydroxy group, an amino group, or a mercapto group with a monofunctional or polyfunctional isocyanate or epoxy, a dehydration-condensation reaction product between an unsaturated carboxylic acid ester or amide having the above nucleophilic substituent and a monofunctional or polyfunctional carboxylic acid, etc. may also be used suitably. Furthermore, an addition reaction product of an unsaturated carboxylic acid ester or amide having an electrophilic substituent such as an isocyanate group or an epoxy group with a monofunctional or polyfunctional alcohol, amine, or thiol, and a substitution reaction product of an unsaturated carboxylic acid ester or amide having a leaving substituent such as a halogen group or a tosyloxy group with a monofunctional or polyfunctional alcohol, amine, or thiol are also suitable. Furthermore, as other examples, a group of compounds in which the above-mentioned unsaturated carboxylic ester is replaced by an unsaturated phosphonic ester may also be used.

In the present invention, an ethylenically unsaturated compound containing an ester bond or an amide bond in the molecule is used, and it preferably contains an acryloyloxy group and/or a methacryloyloxy group.

Specific examples of the monomer that is an ester of an aliphatic polyhydric alcohol compound and an unsaturated carboxylic acid include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, an ethylene oxide (EO)-modified isocyanurate triacrylate, and a polyester acrylate oligomer.

Examples of methacrylic acid esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[*p*-(3-methacryloxy-2-hydroxypropoxy)phenyl]dimethylmethane, and bis[*p*-(methacryloxyethoxy)phenyl]dimethylmethane.

Examples of itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate. Examples of crotonic acid esters include ethylene glycol dicrotonate, tetramethylene glycol dicrotonate, pentaerythritol dicrotonate, and sorbitol tetracrotonate. As isocrotonic acid esters there can be cited ethylene glycol diisocrotonate, pentaerythritol diisocrotonate, and sorbitol tetraisocrotonate. As maleic acid esters there can be cited ethylene glycol dimaleate, triethylene glycol dimaleate, pentaerythritol dimaleate, and sorbitol tetramaleate.

As examples of other esters, aliphatic alcohol-based esters described in JP-B-46-27926, JP-B-51-47334, and JP-A-57-196231, those having an aromatic skeleton described in JP-A-59-5240, JP-A-59-5241, and JP-A-2-226149, those having an amino group described in JP-A-1-165613, etc. may also be used suitably. Moreover, the above-mentioned ester monomers may be used as a mixture.

Furthermore, specific examples of monomers that are amides of an aliphatic polyvalent amine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide, and xylylenebismethacrylamide. Preferred examples of other amide-based monomers include cyclohexylene structure-containing ones described in JP-B-54-21726.

In the present invention, an ethylenically unsaturated compound containing in the molecule at least one type of functional group selected from the group of functional groups consisting of a tertiary amino group, an amide bond, a urethane bond, a urea bond, a thiourethane bond, and a thiourea bond is used. When an ethylenically unsaturated compound contains such a functional group in the molecule, due to the effect of improving aggregation by hydrogen bonding it becomes possible to form a high strength cured film, thus improving printing durability, and by processing using the developer comprising an enzyme of the present invention it becomes possible to reduce development residue in the developer.

Among them, an ethylenically unsaturated compound containing at least one type of functional group selected from the group of functional groups consisting of a urethane bond, a urea bond, a thiourethane bond, and a thiourea bond is preferably used. From the viewpoint of sensitivity, printing durability, developability, and development residue, an ethylenically unsaturated compound containing a urethane bond is more preferably used.

An ethylenically unsaturated compound containing a urethane bond is prepared by an addition reaction of an isocyanate and a hydroxy group. Specific examples thereof include a compound described in JP-B-48-41708 containing two or more polymerizable vinyl groups per molecule in which a hydroxy group-containing vinyl monomer represented by Formula (ii) below is added to a polyisocyanate compound having two or more isocyanate groups per molecule.

$$CH_2 = C(R^4)COOCH_2CH(R^5)OH \qquad (ii)$$

(Here, $R^4$ and $R^5$ denote H or $CH_3$.)

Examples of an isocyanate compound that is reacted with a compound represented by Formula (ii) above include hexamethylene diisocyanate, 2,2,4-trimethylhexamethylene diisocyanate, and 2,4-tolylene diisocyanate, and in particular 2,2,4-trimethylhexamethylene diisocyanate is preferably used from the viewpoint of improvement in sensitivity of a reaction product obtained from reaction therewith.

Furthermore, urethane (meth)acrylates described in JP-A-51-37193, JP-B-2-32293, and JP-B-2-16765, and urethane compounds having an ethylene oxide-based skeleton described in JP-B-58-49860, JP-B-56-17654, JP-B-62-39417, and JP-B-62-39418 are also suitable. Furthermore, a photopolymerizable composition having extremely good photosensitive speed can be obtained by the use of addition-polymerizable compounds having an amino structure or a sulfide structure in the molecule described in JP-A-63-277653, JP-A-63-260909, and JP-A-1-105238.

Other examples include polyfunctional acrylates and methacrylates, for example, polyester acrylates and epoxy acrylates obtained by reacting an epoxy resin with (meth)acrylic acid that are described in JP-A-48-64183, JP-B-49-43191, and JP-B-52-30490. Further examples include specific unsaturated compounds described in JP-B-46-43946, JP-B-1-40337, and JP-B-1-40336 and vinylphosphonic acid-based compounds described in JP-A-2-25493. In some cases, a perfluoroalkyl group-containing structure described in JP-A-61-22048 is suitably used. Moreover, photocurable monomers or oligomers described in Nippon Secchaku Kyokaishi (Journal of Japan Adhesion Society), Vol. 20, No. 7, pp. 300-308 (1984) can also be used. Specific examples thereof include NK OLIGO U-4HA, U-4H, U-6HA, U-6ELH, U-108A, U-1084A, U-200AX, U-122A, U-340A, U-324A, and UA-100 (Shin-Nakamura Chemical Co., Ltd.), UA-306H, AI-600, UA-101T, UA-101I, UA-306T, and UA-306I (Kyoeisha Chemical Co., Ltd.), Art Resin UN-9200A, UN-3320HA, UN-3320HB, UN-3320HC, SH-380G, SH-500, and SH-9832 (Negami Chemical Industrial Co., Ltd.), and PLEX6661-O (Degussa, Germany).

With regard to these addition-polymerizable compounds, the structure thereof and details of an application method such as use thereof on their own or in combination and the amount thereof added may be freely set according to the eventual performance design of a lithographic printing plate precursor. For example, selection is carried out from the following viewpoints. From the viewpoint of photosensitive speed, a structure having a large unsaturated group content per molecule is preferable, and in many cases di- or higher-functionality is preferable. Furthermore, it is effective to adjust both photosensitivity and strength by using in combination different functionality/different polymerizable groups (e.g. an acrylic acid ester, a methacrylic acid ester, a styrene-based compound, a vinyl ether-based compound). A compound having a large molecular weight or a compound having high hydrophobicity might not be preferable in terms of development speed and precipitation in a developer although photosensitive speed and film strength are excellent. Furthermore, selection and application methods of the addition-polymerizable compound are important factors for compatibility and dispersibility with other components (e.g. binder polymer, initiator, colorant, etc.) of the photosensitive layer and, for example, the compatibility can be improved by the use of a low purity compound or the use of two or more types in combination. Moreover, in order to improve adhesion to a support, a protective layer (overcoat layer), which is described layer, etc., a specific structure can be selected. With regard to the proportion of the addition-polymerizable compound added in the photosensitive layer, the larger it is, the more advantageous it is in terms of sensitivity, but when it is too large, undesirable phase separation, production process problems due to tackiness of a photosensitive layer (e.g. manufacturing defects due to transfer or adhesion of photosensitive layer component), or the problem of precipitation from a developer occurring are possible.

From the above viewpoints, the addition-polymerizable compound is used preferably in the range of 5 to 90 wt% relative to nonvolatile components (solids content) in the recording layer, more preferably 20 to 75 wt%, yet more preferably 25 to 75 wt%, and particularly preferably 30 to 60 wt%. It may be used on its own or in a combination of two or more types. Other than the above, with regard to the method for use of the addition-polymerizable compound, from the viewpoint of the degree of polymerization inhibition by oxygen, resolution, fogging properties, change in refractive index, surface tackiness, etc., an appropriate structure, mixing ratio, and amount added may be selected freely, and in some cases a method of constituting and coating a layer such as undercoating or overcoating may be carried out. (iii) Radical polymerization initiator

In the present invention, the photosensitive layer in the lithographic printing plate precursor comprises a radical polymerization initiator (hereinafter, also called a 'polymerization initiator' or an 'initiator compound').

An initiator compound is a compound that undergoes chemical change under the action of electron transfer, energy transfer, heat generation, etc. due to an electronically excited state of a sensitizing dye, and generates at least one type selected from a radical, an acid, and a base. Hereinafter, a radical, an acid, or a base generated in this way is simply called an active species. When there is no initiator compound, sufficient sensitivity cannot be obtained in practice, and when only an initiator compound is used on its own, sufficient sensitivity might not be obtained in practice. As one mode in which a sensitizing dye and an initiator compound are used in combination, it is also possible to use them as a single compound by an appropriate chemical method (linking the sensitizing dye and the initiator compound by a chemical bond, etc.).

It is thought that many of these initiator compounds usually generate an active species via initial chemical processes represented by (1) to (3) below. That is, (1) reductive decomposition of an initiator compound based on a reaction involving electron transfer from a sensitizing dye in an electronically excited state to the initiator compound, (2) oxidative decomposition of an initiator compound based on electron transfer from the initiator compound to a sensitizing dye in an electronically excited state, and (3) decomposition of an initiator compound in an electronically excited state based on energy transfer from a sensitizing dye in an electronically excited state to the initiator compound. Although there is often some ambiguity with respect to which individual initiator compound belongs to which type among (1) to (3), the sensitizing dye in the present invention exhibits a very high sensitizing effect in combination with any type of these initiator compounds.

As the initiator compound, a compound known to a person skilled in the art may be used without limitations; specific examples thereof include a trihalomethyl compound, a carbonyl compound, an organic peroxide, an azo compound, an azido compound, a metallocene compound, a hexaarylbiimidazole compound, an organoboron compound, a disulfone compound, an oxime ester compound, an onium salt compound, and an iron arene complex. Among them, it is preferably at least one type selected from the group consisting of a hexaarylbiimidazole-based compound, an onium salt, a trihalomethyl compound, and a metallocene compound, and it is particularly preferably a hexaarylbiimidazole-based compound.

With regard to the polymerization initiators above, two or more types may be used in combination as appropriate.

As the hexaarylbiimidazole compound, there can be cited lophine dimers described in JP-B-45-37377 and JP-B-44-86516, and examples thereof include 2,2'-bis(*o*-chlorophenyl)-4,4',5,5'-tetraphenylbiimidazole, 2,2'-bis(*o*-bromophenyl)-4,4',5,5'-tetraphenylbiimidazole, 2,2'-bis(*o,p*-dichlorophenyl)-4,4',5,5'-tetraphenylbiimidazole, 2,2'-bis(*o*-chlorophenyl)-4,4',5,5'-tetra(m-methoxyphenyl)biimidazole, 2,2'-bis(*o,o*'-dichlorophenyl)-4,4',5,5'-tetraphenylbiimidazole, 2,2'-bis(o-nitrophenyl)-4,4',5,5'-tetraphenylbiimidazole, 2,2'-bis(*o*-methylphenyl)-4,4',5,5'-tetraphenylbiimidazole, and 2,2'-bis(*o*-trifluorophenyl)-4,4',5,5'-tetraphenylbiimidazole.

The hexaarylbiimidazole-based compound is particularly preferably used in a combination with a sensitizing dye having a maximum absorption at 300 to 450 nm.

The onium salt (in the present invention it functions not as an acid generator but as an ionic polymerization initiator) suitably used in the present invention is a sulfonium salt, an iodonium salt, or a diazonium salt. A diaryliodonium salt or a triarylsulfonium salt is particularly preferably used. The onium salt is preferably an onium salt represented by Formulae (RI-I) to (RI-III) below.

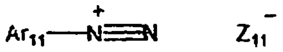

(RI-I)

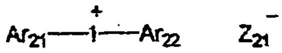

(RI-II)

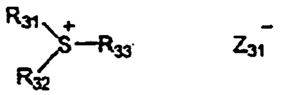

(RI-III)

In formula (RI-I), $Ar_{11}$ denotes an aryl group that has no greater than 20 carbon atoms and that may have 1 to 6 substituents. Preferable examples of the substituent include an alkyl group having 1 to 12 carbon atoms, an alkenyl group having 1 to 12 carbon atoms, an alkynyl group having 1 to 12 carbon atoms, an aryl group having 1 to 12 carbon atoms, an alkoxy group having 1 to 12 carbon atoms, an aryloxy group having 1 to 12 carbon atoms, a halogen atom, an alkylamino group having 1 to 12 carbon atoms, a dialkylamino group having 1 to 12 carbon atoms, an alkylamide group or arylamide group having 1 to 12 carbon atoms, a carbonyl group, a carboxy group, a cyano group, a sulfonyl group, a thioalkyl group having 1 to 12 carbon atoms, and a thioaryl group having 1 to 12 carbon atoms.

In Formula (RI-I), $Z_{11}^-$ denotes a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, or a sulfate ion. Among them, a perchlorate ion, a hexafluorophosphate ion, a tetrafluoroborate ion, a sulfonate ion, and a sulfinate ion are preferable from the viewpoint of stability.

In formula (RI-II), $Ar_{21}$ and $Ar_{22}$ independently denote an aryl group that has no greater than 20 carbon atoms and that may have 1 to 6 substituents. Preferable examples of the substituent include an alkyl group having 1 to 12 carbon atoms, an alkenyl group having 1 to 12 carbon atoms, an alkynyl group having 1 to 12 carbon atoms, an aryl group having 1 to 12 carbon atoms, an alkoxy group having 1 to 12 carbon atoms, an aryloxy group having 1 to 12 carbon atoms, a halogen atom, an alkylamino group having 1 to 12 carbon atoms, a dialkylamino group having 1 to 12 carbon atoms, an alkylamide group or arylamide group having 1 to 12 carbon atoms, a carbonyl group, a carboxy group, a cyano group, a sulfonyl group, a thioalkyl group having 1 to 12 carbon atoms, or a thioaryl group having 1 to 12 carbon atoms.

In Formula (RI-II), $Z_{21}^-$ denotes a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion. Among them, a perchlorate ion, a hexafluorophosphate ion, a tetrafluoroborate ion, a sulfonate ion, a sulfinate ion, and a carboxylate ion are preferable from the viewpoint of stability and reactivity.

In Formula (RI-III), $R_{31}$, $R_{32}$, and $R_{33}$ independently denote an aryl group that has no greater than 20 carbon atoms and that may have 1 to 6 substituents, an alkyl group having no greater than 20 carbon atoms, an alkenyl group having no greater than 20 carbon atoms, or an alkynyl group having no greater than 20 carbon atoms. Among them, the aryl group is preferable from the viewpoint of reactivity and stability.

Examples of the substituent include an alkyl group having 1 to 12 carbon atoms, an alkenyl group having 1 to 12 carbon atoms, an alkynyl group having 1 to 12 carbon atoms, an aryl group having 1 to 12 carbon atoms, an alkoxy group having 1 to 12 carbon atoms, an aryloxy group having 1 to 12 carbon atoms, a halogen atom, an alkylamino group having 1 to 12 carbon atoms, a dialkylamino group having 1 to 12 carbon atoms, an alkylamide group or arylamide group having 1 to 12 carbon atoms, a carbonyl group, a carboxy group, a cyano group, a sulfonyl group, a thioalkyl group having 1 to 12 carbon atoms, and a thioaryl group having 1 to 12 carbon atoms.

In Formula (RI-III), $Z_{31}^-$ denotes a monovalent anion. Specific examples of the monovalent anion include a halogen ion, a perchlorate ion, a hexafluorophosphate ion, a tetrafluoroborate ion, a sulfonate ion, a sutfinate ion, a thiosulfonate ion, and a sulfate ion. Among them, a perchlorate ion, a hexafluorophosphate ion, a tetrafluoroborate ion, a sulfonate ion, a sulfinate ion, and a carboxylate ion are preferable from the viewpoint of stability and reactivity. Carboxylate ions described in JP-A-2002-148790 and JP-A-2001-343742 are more preferable, and carboxylate ions described in JP-A-2002-148790 are yet more preferable.

The onium salt is particularly preferably used in combination with an IR absorber having a maximum absorption at 750 to 1,400 nm.

As other polymerization initiators, polymerization initiators described in JP-A-2007-171406, paragraph Nos. [0071] to [0129] of JP-A-2007-206216, JP-A-2007-206217, JP-A-2007-225701, JP-A-2007-225702, JP-A-2007-316582, and JP-A-2007-328243 may preferably be used.

With regard to the polymerization initiator of the photosensitive layer, one type thereof may suitably used on its own or two or more types thereof may be used in combination.
The amount of polymerization initiator used in the photosensitive layer is preferably 0.01 to 20 wt% relative to the total weight of the solids content of the photosensitive layer, more preferably 0.1 to 15 wt%, and yet more preferably 1.0 to 10 wt%.

Sensitizing dye

The photosensitive layer preferably comprises a sensitizing dye. The sensitizing dye may be used without particular restrictions as long as it is one that absorbs light during imagewise exposure and attains an excited state, provides energy to a polymerization initiator via electron transfer, energy transfer, or heat generation, and improves the polymerization initiating function.
Preferred examples of the sensitizing dye include a sensitizing dye having a maximum absorption at 300 to 450 nm, a sensitizing dye having a maximum absorption at 500 to 600 nm, and a sensitizing dye having a maximum absorption at 750 to 1,400 nm (infrared absorbing agent); and adding such sensitizing dyes enables highly sensitive lithographic printing plate precursors that are compatible with a violet laser at 405 nm, a green laser at 532 nm, and an IR laser at 830 nm, which are usually used in the present field, to be provided.
A sensitizing dye having a maximum absorption in a wavelength region of 350 to 450 nm is first explained.
Examples of such a sensitizing dye include a merocyanine dye, a benzopyran, a coumarin, an aromatic ketone, and an anthracene.
Among sensitizing dyes having an absorption maximum in the wavelength region of 360 to 450 nm, from the viewpoint of high sensitivity a dye represented by Formula (IX) below is preferable.

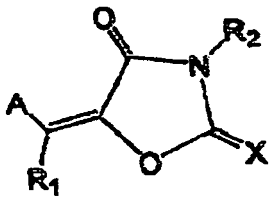

(IX)

(In Formula (IX), A denotes an optionally substituted aromatic ring group or heterocyclic group, X denotes an oxygen atom, a sulfur atom, or N-($R_3$), $R_1$, $R_2$, and $R_3$ independently denote a monovalent non-metallic atomic group, and A and $R_1$, and $R_2$ and $R_3$ may be bonded to each other to form an aliphatic or aromatic ring.)
Formula (IX) is explained in further detail.
$R_1$, $R_2$, and $R_3$ in Formula (IX) are independently a monovalent non-metallic atomic group, and preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxyl group, or a halogen atom.
A in Formula (IX) is now explained.
A denotes an optionally substituted aromatic ring group or heterocyclic group, and specific examples of the optionally substituted aromatic ring or heterocycle include the same groups as those denoted by $R_1$, $R_2$, and $R_3$ in Formula (IX) (an aryl group, an aromatic heterocyclic residue, etc.).
Preferred specific examples of such a sensitizing dye include compounds described in paragraphs 0047 to 0053 of JP-A-2007-58170.
Furthermore, a sensitizing dye represented by Formulae (V) to (VII) below may also be used.

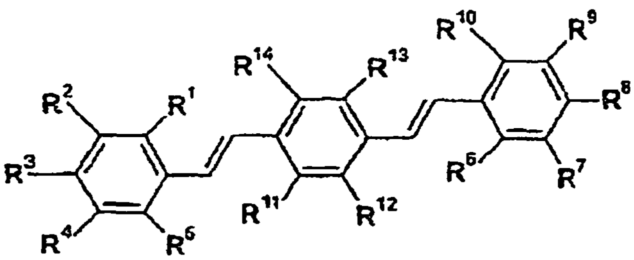

(V)

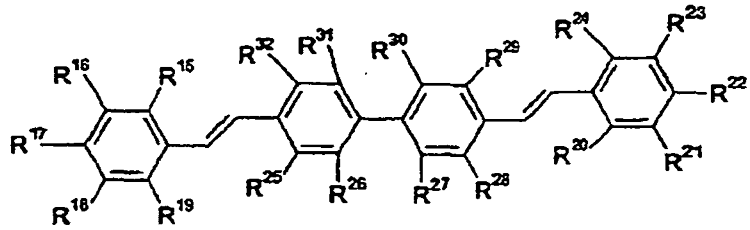

(VI)

In Formula (V), $R^1$ to $R^{14}$ independently denote a hydrogen atom, an alkyl group, an alkoxy group, a cyano group, or a halogen atom. At least one of $R^1$ to $R^{10}$ denotes an alkoxy group having 2 or more carbons.

In Formula (VI), $R^{15}$ to $R^{32}$ independently denote a hydrogen atom, an alkyl group, an alkoxy group, a cyano group, or a halogen atom. At least one of $R^{15}$ to $R^{24}$ denotes an alkoxy group having 2 or more carbons.

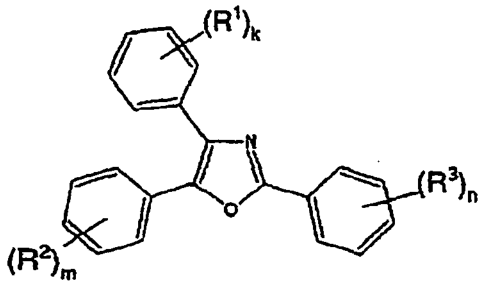

(VII)

In Formula (VII), $R^1$, $R^2$, and $R^3$ independently denote a halogen atom, an alkyl group, an aryl group, an aralkyl group, an $-NR^4R^5$ group, or an $-OR^6$ group, $R^4$, $R^5$, and $R^6$ independently denote a hydrogen atom, an alkyl group, an aryl group, or an aralkyl group, and k, m, and n independently denote an integer of 0 to 5.

Furthermore, sensitizing dyes described in JP-A-2007-171406, JP-A-2007-206216, JP-A-2007-206217, JP-A-2007-225701, JP-A-2007-225702, JP-A-2007-316582, and JP-A-2007-328243 may also be used.

The amount of sensitizing dye added is preferably 0.05 to 30 parts by weight relative to 100 parts by weight of the total solids content of the photosensitive layer, more preferably 0.1 to 20 parts by weight, and yet more preferably 0.2 to 10 parts by weight.

The sensitizing dye having a maximum absorption at 750 to 1,400 nm (IR absorber) that is suitably used in the present invention is explained in detail below.

The sensitizing dye used here attains an electronically excited state with high sensitivity by irradiation with (exposure to) an IR laser, and it is surmised that electron transfer, energy transfer, generation of heat (photothermal conversion), etc. related to the electronically excited state acts on a polymerization initiator present in the photosensitive layer so as to cause a chemical change of the polymerization initiator, thus generating an active species such as a radial, an acid, or a base. Whichever is the case, adding a sensitizing dye having a maximum absorption at 750 to 1,400 nm (IR absorber) is particularly suitable for production of a plate that is directly drawn using an IR laser having a wavelength of 750 nm to 1,400 nm, and compared with a conventional lithographic printing plate precursor, high image formation performance can be exhibited.

The IR absorber is preferably a dye or a pigment having an absorption maximum at a wavelength of 750 nm to 1,400 nm, and more preferably a dye.

As the dye, commercial dyes and known dyes described in the literature such as, for example, 'Senryo Binran' (Dye Handbook) (Ed. The Society of Synthetic Organic Chemistry, Japan, 1970) may be used. Specific examples thereof include an azo dye, a metal complex salt azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium salt, and a metal thiolate complex.

Among these dyes, a cyanine dye, a squarylium dye, a pyrylium salt, a nickel thiolate complex, and an indolenine cyanine dye are preferable, a cyanine dye and an indolenine cyanine dye are more preferable, and a cyanine dye represented by Formula (a) below is particularly preferable.

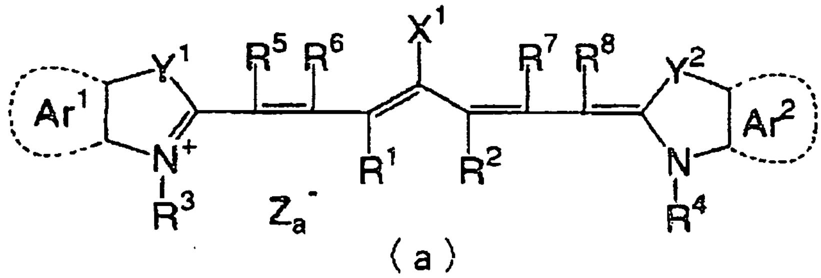

(a)

In Formula (a), $X^1$ denotes a hydrogen atom, a halogen atom, $-NPh_2$, $X^2-L^1$, or the group shown below. Here, $X^2$ denotes an oxygen atom, a nitrogen atom, or a sulfur atom, $L^1$ denotes a hydrocarbon group having 1 to 12 carbon atoms, a hetero atom-containing aromatic ring, or a hetero atom-containing hydrocarbon group having 1 to 12 carbon atoms. The hetero atom referred to here means N, S, O, a halogen atom, or Se, and Ph denotes a phenyl group.

$X_a^-$ is defined in the same manner as for $Z_a^-$, which is described later, and $R^a$ denotes a hydrogen atom or a substituent selected from the group consisting of an alkyl group, an aryl group, a substituted or unsubstituted amino group, and a halogen atom.

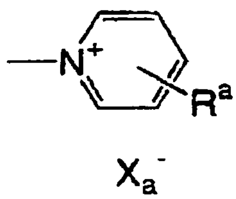

$R^1$ and $R^2$ independently denote a hydrocarbon group having 1 to 12 carbon atoms. From the viewpoint of storage stability of a photosensitive layer coating liquid, $R^1$ and $R^2$ are preferably hydrocarbon groups having two or more carbon atoms, and it is particularly preferable for $R^1$ and $R^2$ to be bonded to each other to form a 5-membered ring or a 6-membered ring.

$Ar^1$ and $Ar^2$ may be identical to or different from each other, and denote an optionally substituted aromatic hydrocarbon group. Preferred examples of the aromatic hydrocarbon group include a benzene ring and a naphthalene ring. Preferred examples of the substituent include a hydrocarbon group having no greater than 12 carbon atoms, a halogen atom, and an alkoxy group having no greater than 12 carbon atoms.

$Y^1$ and $Y^2$ may be identical to or different from each other, and denote a sulfur atom or a dialkylmethylene group having no greater than 12 carbon atoms.

$R^3$ and $R^4$ may be identical to or different from each other, and denote an optionally substituted hydrocarbon group having no greater than 20 carbon atoms. Preferred examples of the substituent include an alkoxy group having no greater than 12 carbon atoms, a carboxy group, and a sulfo group.

$R^5$, $R^6$, $R^7$, and $R^8$ may be identical to or different from each other, and denote a hydrogen atom or a hydrocarbon group having no greater than 12 carbon atoms. From the availability of starting materials, a hydrogen atom is preferable.

Furthermore, $Za^-$ denotes a counteranion. When a cyanine dye represented by Formula (a) has an anionic substituent in its structure and neutralization of charge is unnecessary, $Za^-$ is not required. From the viewpoint of storage stability of the photosensitive layer coating liquid, $Za^-$ is preferably a halogen ion, a perchlorate ion, a tetrafluoroborate ion, a hexafluorophosphate ion, or a sulfonate ion, and particularly preferably a perchlorate ion, a hexafluorophosphate ion, or an arylsulfonate ion. As a counterion, one not containing a halogen ion is particularly preferable.

Specific examples of cyanine dyes represented by Formula (a) include those described in paragraph Nos. [0017] to [0019] of JP-A-2001-133969.

Furthermore, particularly preferred other examples include specific indolenine cyanine dyes described in JP-A-2002-278057.

As a pigment, commercial pigments and pigments described in 'Karaa Indekkusu' (C.I.) Binran (Handbook), 'Saishin Ganryo Binran' (Latest Pigments Handbook) (Ed. Nippon Ganryo Gijutsu Kyokai, 1977), 'Saishin Ganryo Ouyo Gijutsu' (Latest Pigment Application Techniques' (CMC Publishing, 1986), and 'Insatsu Inki Gijutsu' (Printing Ink Techniques) (CMC Publishing, 1984) may be used.

Examples of the type of pigment include a black pigment, a yellow pigment, an orange pigment, a brown pigment, a red pigment, a purple pigment, a blue pigment, a green pigment, a fluorescent pigment, a metal powder pigment and, in addition, polymer-binding dyes. Specifically, an insoluble azo pigment, an azo lake pigment, a condensed

azo pigment, a chelate azo pigment, a phthalocyanine type pigment, an anthraquinone type pigment, perylene and perinone type pigments, a thioindigo type pigment, a quinacridone type pigment, a dioxazine type pigment, an isoindolinone type pigment, a quinophthalone type pigment, a dye lake pigment, an azine pigment, a nitroso pigment, a nitro pigment, a natural pigment, a fluorescent pigment, an inorganic pigment, carbon black, etc. may be used. Among these pigments, carbon black is preferable.

These pigments may be used with or without a surface treatment being carried out. As a method for the surface treatment, a method in which the surface is coated with a resin or wax, a method in which a surfactant is deposited, a method in which a reactive material (e.g. a silane coupling agent, an epoxy compound, a polyisocyanate, etc.) is bonded to the pigment surface, etc. can be considered. The above-mentioned surface treatment methods are described in 'Kinzoku Sekken no Seishitsu to Ouyo' (Properties and Applications of Metal Soaps) (SAIWAISHOBO), 'Insatsu Inki Gijutsu' (Printing Ink Techniques) (CMC Publishing, 1984), and 'Saishin Ganryo Ouyo Gijutsu' (Latest Pigment Application Techniques) (CMC Publishing, 1986).

The particle size of the pigment is preferably in the range of 0.01 μm to 10 μm, more preferably in the range of 0.05 μm to 1 μm, and particularly preferably in the range of 0.1 μm to 1 μm. When in this preferred particle size range, the dispersion stability of the pigment in the photosensitive layer is excellent and a uniform photosensitive layer can be obtained.

As a method for dispersing the pigment, a known dispersion technique used for ink production, toner production, etc. may be used. Examples of a dispersion machine include an ultrasonic disperser, a sand mill, an attritor, a pearl mill, a super mill, a ball mill, an impeller, a disperser, a KD mill, a colloidal mill, a dynatron, a three roll mill, and a pressure kneader. Details are described in 'Saishin Ganryo Ouyo Gijutsu' (Latest Pigment Application Techniques) (CMC Publishing, 1986).

These IR absorbers may be added to the same layer as other components or may be added to another layer provided separately.

From the viewpoint of uniformity in the photosensitive layer and durability of the photosensitive layer, the amount of these IR absorbers added is preferably 0.01 to 50 wt% relative to the total content of solids forming the photosensitive layer, and more preferably 0.1 to 10 wt%; in the case of a dye it is more preferably 0.5 to 10 wt%, and in the case of a pigment it is more preferably 0.1 to 10 wt%.

Microcapsules

In the present invention, as a method by which the above-mentioned constituents of the photosensitive layer and other constituents described hereinafter are contained in the photosensitive layer, part of the constituents may be encapsulated in microcapsules and added to the photosensitive layer as described in, for example, JP-A-2001-277740 and JP-A-2001-277742. In such a case, each constituent may be present inside or outside the microcapsule in any appropriate ratio.

As a method of microencapsulating the constituents of the photosensitive layer, known methods can be used.

Methods for the production of microcapsules include, for example, a method utilizing coacervation described in U.S. Pat. Nos. 2,800,457 and 2,800,458, a method using interfacial polymerization described in U.S. Pat. No. 3,287,154, JP-B-38-19574, and JP-B-42-446, a method using polymer deposition described in U.S. Pat. Nos. 3,418,250 and 3,660,304, a method using an isocyanate polyol wall material described in U.S. Pat. No. 3,796,669, a method using an isocyanate wall material described in U.S. Pat. No. 3,914,511, a method using a urea-formaldehyde type or urea-formaldehyde-resorcinol type wall-forming material described in U.S. Pat. Nos. 4,001,140, 4,087,376, and 4,089,802, a method using a wall material, for example, a melamine-formaldehyde resin or hydroxycellulose described in U.S. Pat. No. 4,025,445, an in-situ method by monomer polymerization described in JP-B-36-9163 and JP-B-51-9079, a spray drying method described in GB Patent No. 930,422 and U.S. Pat. No. 3,111,407, and an electrolytic dispersion cooling method described in GB Patents Nos. 952,807 and 967,074, but the present invention should not be construed as being limited thereto.

A preferred microcapsule wall used in the present invention has three-dimensional crosslinking and has the property of being swollen by solvent. From this point of view, preferred wall materials of the microcapsule include polyurea, polyurethane, polyester, polycarbonate, polyamide, and mixtures thereof, and polyurea and polyurethane are particularly preferred. Furthermore, a compound having a crosslinkable functional group such as an ethylenically unsaturated bond, capable of being introduced into above-mentioned water-insoluble polymer, may be introduced into the microcapsule wall.

The average particle size of the microcapsules is preferably 0.01 to 3.0 μm, more preferably 0.05 to 2.0 μm, and particularly preferably 0.10 to 1.0 μm. When in the above-mentioned range, good resolution and stability over time can be achieved.

Colorant

The photosensitive layer preferably employs a dye having a large absorption in the visible light region for a colorant in an image. As above-mentioned, a colorant may have a function as a sensitizing dye.
Specific examples of the dye include Oil Yellow #101, Oil Yellow #103, Oil Pink #312, Oil Green BG, Oil Blue BOS, Oil Blue #603, Oil Black BY, Oil Black BS, Oil Black T-505 (all from Orient Chemical Industry Co., Ltd.). Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247.
As the colorant, a pigment may suitably be used.
As the pigment, a pigment such as a phthalocyanine-based pigment, an azo-based pigment, carbon black, or titanium oxide may suitably be used, and a phthalocyanine-based pigment is most preferably used.
It is preferable to add these colorants because the image area and the non-image area after image formation can be easily differentiated. The amount of colorant added is preferably 0.01 to 10 wt% relative to the total solids content of image recording materials of the photosensitive layer.

Other photosensitive layer components

The photosensitive layer may further contain various additives as necessary. As the additive, a surfactant for promoting developability and improving coated surface conditions, a hydrophilic polymer for improving developability and improving dispersion stability of microcapsules, a colorant and a printing out agent for making visible an image area and a non-image area, a polymerization inhibitor for inhibiting unwanted thermal polymerization of a radically polymerizable compound during production or storage of a photosensitive layer, a higher fatty derivative for preventing polymerization inhibition by oxygen, inorganic particles for improving cured film strength of an image area, a hydrophilic low molecular weight compound for improving developability, a co-sensitizer or a chain transfer agent for improving sensitivity, a plasticizer for improving plasticity, etc. may be added. These compounds may employ known substances such as compounds described in, for example, JP-A-2007-171406, JP-A-2007-206216, paragraph Nos. [0161] to [0215] of JP-A-2007-206217, JP-A-2007-225701, JP-A-2007-225702, JP-A-2007-316582, and JP-A-2007-328243.
As a compound functioning as a chain transfer agent, a group of compounds having SH, PH, SiH, or GeH in the molecules may be used. These compounds can donate hydrogen to a low activity radical species to generate a radical or are oxidized and then deprotonated to generate a radical.
The photosensitive layer may preferably employ as a chain transfer agent a thiol compound (e.g. a 2-mercaptobenzimidazole, a 2-mercaptobenzothiazole, a 2-mercaptobenzoxazole, a 3-mercaptotriazole, a 5-mercaptotetrazole, etc.) in particular.
Specific examples of the thiol compound are described in paragraph Nos. [0212] to [0216] of JP-A-2008-276155.
Among them, a thiol compound represented by Formula (S) below is particularly suitably used. In accordance with the use of a thiol compound represented by Formula (S) as a chain transfer agent, degradation of sensitivity due to evaporation from the photosensitive layer or diffusion to another layer can be avoided, the storage stability is excellent, and a lithographic printing plate precursor having high sensitivity and high printing durability can be obtained.

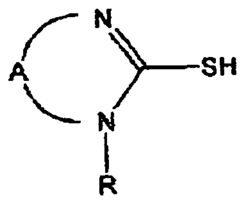

(S)

In Formula (S), R denotes hydrogen atom, an optionally substituted alkyl group, or an optionally substituted aryl group, A denotes an atomic group forming together with the N=C-N moiety a carbon atom-containing 5- or 6-membered heterocycle, and A may further have a substituent.
In the present invention, it is preferable for the lithographic printing plate precursor not to comprise gelatin in the constitution, and it is particularly preferable for it not to comprise gelatin in the photosensitive layer. It is preferable for gelatin not to be contained since when gelatin is contained in the photosensitive layer ink laydown might be degraded.

Formation of Photosensitive Layer

The photosensitive layer is formed by dispersing or dissolving each of the necessary components described above in a solvent to prepare a coating liquid and applying the liquid.

As the solvent used here, there can be cited for example ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, *N,N*-dimethylacetamide, *N,N*-dimethylformamide, tetramethylurea, *N*-methylpyrrolidone, dimethylsulfoxide, sulfolane, γ-butyrolactone, toluene, and water, but the present invention should not be construed as being limited thereto.
These solvents may be used singly or as a mixture.
The solids content concentration of the coating liquid is preferably 1 to 50 wt%.
The photosensitive layer may also be formed by preparing a plurality of coating liquids by dispersing or dissolving the same or different components described above in the same or different solvents and repeatedly coating and drying a plurality of times.
The amount (solids content) of the photosensitive layer that the support is coated with after coating and drying may be varied depending on the use, but generally it is preferably 0.3 to 3.0 g/$m^2$. In the above-mentioned range good sensitivity and good film properties of the photosensitive layer can be obtained.
Various methods can be used for the coating. Examples of the method include bar coater coating, spin coating, spray coating, curtain coating, dip coating, air knife coating, blade coating, and roll coating.

Protective Layer

In the lithographic printing plate precursor that can be used in the present invention, a protective layer (oxygen-blocking layer) is preferably provided on the photosensitive layer in order to prevent diffusion and penetration of oxygen, which inhibits a polymerization reaction at the time of exposure.
The protective layer preferably has an oxygen permeability (A) at 25°C under one atmosphere of $1.0 \leq (A) \leq 20$ (mL/$m^2$·day). When the oxygen permeability (A) is at least 1.0 (mL/$m^2$·day), an undesirable polymerization reaction can be suppressed during production and during storage before image exposure, and the occurrence of the problems of undesirable fogging or widening of image lines during image exposure can be suppressed. When the oxygen permeability (A) is no greater than 20 (mL/$m^2$·day), the sensitivity is excellent. The oxygen permeability (A) is more preferably in the range of $1.5 \leq (A) \leq 12$ (mL/$m^2$·day), and yet more preferably in the range of $2.0 \leq (A) \leq 10.0$ (mL/$m^2$·day).
Apart from the above-mentioned oxygen permeability, as properties required of the protective layer it is desirable that the protective layer does not substantially hinder the transmission of light used for exposure, has excellent adhesion to the photosensitive layer, and can be easily removed during a development step after exposure. Protective layers have already been devised and described in detail in U.S. Pat. No. 3,458,311 and JP-B-55-49729.
As the material that can be used for the protective layer, for example, a water-soluble polymer compound with relatively good crystallinity is preferably used. Specifically, a water-soluble polymer such as polyvinyl alcohol (PVA), a vinyl alcohol/vinyl phthalate copolymer, a vinyl acetate/vinyl alcohol/vinyl phthalate copolymer, a vinyl acetate/crotonic acid copolymer, polyvinylpyrrolidone, an acidic cellulose, gelatin, gum Arabic, polyacrylic acid, or polyacrylamide can be cited. The water-soluble polymer compound may be used singly or as a mixture. Of these compounds, it is preferable to use polyvinyl alcohol as a main component since the best results can be obtained in fundamental properties such as oxygen-blocking properties and development removability.
The polyvinyl alcohol for use in the protective layer may be partially substituted with ester, ether or acetal as long as it contains unsubstituted vinyl alcohol units for achieving the necessary oxygen-blocking properties and water solubility. In the same way, part of the polyvinyl alcohol may have another copolymer component. The polyvinyl alcohol can be obtained by hydrolyzing a vinyl acetate.
As specific examples of the polyvinyl alcohol, those with 71 to 100 mol % hydrolysis and 300 to 2,400 polymerization repeating units can be cited.
Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (Kuraray Co., Ltd.). They can be used singly or as a mixture.
In a preferred embodiment, the polyvinyl alcohol content in the protective layer is 20 to 95 wt%, and more preferably 30 to 90 wt%.
Furthermore, a known modified polyvinyl alcohol may also be preferably used. For example, polyvinyl alcohols of various degrees of polymerization having at random various types of hydrophilic modified sites such as an anion-modified site modified with an anion such as a carboxy group or a sulfo group, a cation-modified site modified with a cation such as an amino group or an ammonium group, a silanol-modified site, and a thiol-modified site, and polyvinyl alcohols of various degrees of polymerization having at the terminal of the polymer chain various types of modified sites such as the above-mentioned anion-modified site, the above-mentioned cation-modified site, a silanol-modified site, and a thiol-modified site and, furthermore, an alkoxy-modified site, a sulfide-modified site, an ester-modified site of vinyl alcohol with various types of organic acids, an ester-modified site of the above-mentioned anion-modified site with an

alcohol, and an epoxy-modified site can be cited.

Among them, the acid-modified polyvinyl alcohol having a carboxy group or a sulfo group is preferably used.

As a component used as a mixture with polyvinyl alcohol, polyvinylpyrrolidone or a modified product thereof is preferable from the viewpoint of oxygen-blocking properties and development removability. The content thereof in the protective layer is preferably 3.5 to 80 wt%, more preferably 10 to 60 wt%, and yet more preferably 15 to 30 wt%.

The components of the protective layer (PVA selection and use of additives), the amount coated, etc. are determined taking into consideration fogging properties, adhesion, and scratch resistance in addition to oxygen-blocking properties and development removability. In general, the higher the degree of hydrolysis of the PVA used (the higher the unsubstituted vinyl alcohol unit content in the protective layer) and the thicker the film thickness, the higher are the oxygen-blocking properties, which is advantageous from the viewpoint of sensitivity.

The molecular weight of the (co)polymer of the above-mentioned polyvinyl alcohol (PVA), etc. is preferably 2,000 to 10,000,000 and more preferably 20,000 to 3,000,000.

As other components of the protective layer, glycerol, dipropylene glycol, etc. can be added in an amount corresponding to several wt% of the (co)polymer to impart flexibility. Furthermore, an anionic surfactant such as a sodium alkylsulfate or sodium alkylsulfonate; an amphoteric surfactant such as an alkylaminocarboxylic acid salt or an alkylaminodicarboxylic acid salt; or a nonionic surfactant such as a polyoxyethylene alkyl phenyl ether can be added in an amount corresponding to several wt% of the (co)polymer.

Furthermore, adhesion to an image area and scratch resistance are also extremely important for handling of a plate. That is, when a hydrophilic layer comprising a water-soluble polymer is layered on an oleophilic photosensitive layer, layer peeling due to insufficient adhesion is liable to occur, and the peeled portion causes defects such as incomplete film curing due to polymerization inhibition by oxygen. Various proposals have been made for improving the adhesion between these two layers. For example, it is described in U.S. Pat. Application Nos. 292,501 and 44,563 that sufficient adhesion can be obtained by mixing from 20 to 60 wt% of an acrylic-based emulsion or a water-insoluble vinylpyrrolidone/vinyl acetate copolymer with a hydrophilic polymer mainly comprising polyvinyl alcohol and layering the resulting mixture on the photosensitive layer. Any of these known techniques may be applied to the protective layer according to the present invention. Coating methods for such a protective layer are described in detail, for example, in U.S. Pat. No. 3,458,311 and JP-B-55-49729.

Furthermore, it is also preferable for an inorganic layered compound to be contained in the protective layer of the lithographic printing plate precursor for the purpose of improving the oxygen-blocking properties and the photosensitive layer surface protection properties.

The inorganic layered compound used here is a particle having a thin tabular shape and includes, for example, mica, for example, natural mica represented by the following formula:

$$A(B,C)_{2\text{-}5}D_4O_{10}(OH,F,O)_2$$

(in the formula A denotes any one of K, Na, and Ca, B and C denote any one of Fe (II), Fe(III), Mn, Al, Mg, and V, and D denotes Si or Al) or synthetic mica; talc represented by the following formula: $3MgO{\cdot}4SiO{\cdot}H_2O$; taeniolite; montmorillonite; saponite; hectorite; and zirconium phosphate.

Of the inorganic layered compounds, fluorine-based swellable synthetic mica, which is a synthetic inorganic layered compound, is particularly useful in the present invention.

The aspect ratio of the inorganic layered compound is preferably at least 20, more preferably at least 100, and yet more preferably at least 200. The aspect ratio is the ratio of thickness to major axis of a particle and can be determined, for example, from a projection drawing of a particle by microphotography. The larger the aspect ratio, the greater the effect obtained.

As for the particle size of the inorganic layered compound, the average major axis is preferably 0.3 to 20 μm, more preferably 0.5 to 10 μm, and yet more preferably 1 to 5 μm. The average thickness of the particle is preferably no greater than 0.1 μm, more preferably no greater than 0.05 μm, and yet more preferably no greater than 0.01 μm. For example, in the swellable synthetic mica that is a representative compound of the inorganic layered compound, the thickness is preferably on the order of from 1 to 50 nm and the plane size is preferably on the order of from 1 to 20 μm.

When such an inorganic layered compound particle having a large aspect ratio is contained in the protective layer, the coated film strength increases and, furthermore, since penetration of oxygen or moisture can be inhibited effectively deterioration of the protective layer due to deformation, etc. can be prevented, and even when the lithographic printing plate precursor is stored for a long period of time under high humidity conditions there is no degradation in the image-forming properties thereof due to change in humidity and the storage stability is excellent.

The content of the inorganic layered compound in the protective layer is preferably 5/1 to 1/00 as a ratio by weight relative to the amount of binder used in the protective layer. When a plurality of inorganic layered compounds are used in combination, it is also preferable that the total amount of the inorganic layered compounds is in the above-mentioned weight ratio range.

A method for dispersing the inorganic layered compound used in the protective layer may employ a method described in JP-A-2007-171406, JP-A-2007-206216, JP-A-2007-206217, JP-A-2007-225701, JP-A-2007-225702, JP-A-2007-316582, JP-A-2007-328243, etc.

The coat weight of the protective layer is preferably in the range of 0.05 to 10 g/$m^2$ as a coat weight after drying. When the protective layer contains the inorganic layered compound, it is more preferably in the range of 0.1 to 0.5 g/$m^2$, and when the protective layer does not contain the inorganic layered compound, it is more preferably in the range of 0.5 to 5 g/$m^2$.

Undercoat layer

In the present invention, in the lithographic printing plate precursor, it is preferable to provide, above a support, an undercoat layer of a compound containing a polymerizable group. When an undercoat layer is used, the photosensitive layer is provided above the undercoat layer. The undercoat layer has the effects of strengthening adhesion between the support and the photosensitive layer in exposed areas and facilitating separation of the photosensitive layer from the support in unexposed areas, so that the developability can be improved.

Specific preferred examples of the undercoat layer include a silane coupling agent having an addition-polymerizable ethylenic double bond reactive group described in JP-A-10-282679, and a phosphorus compound having an ethylenic double bond reactive group described in JP-A-2-304441. A particularly preferred compound is a compound having both a polymerizable group such as a methacrylic group or an allyl group and a support-adsorptive group (acid group) such as a sulfonic acid group, a phosphonic acid group, a phosphoric acid group, or a phosphoric acid ester group. A compound having a hydrophilicity-imparting group such as an ethylene oxide group, in addition to the polymerizable group and the support-adsorptive group may also be cited as a preferable compound.

The coat weight (solids content) of the undercoat layer is preferably 0.1 to 100 mg/$m^2$, and more preferably 1 to 30 mg/$m^2$.

Backcoat layer

After applying a surface treatment to the support or forming the undercoat layer above the support, a backcoat layer may as necessary be provided on the back surface of the support.

As the backcoat layer, there can preferably be cited, for example, a coating layer comprising an organic polymer compound described in JP-A-5-45885, and a coating layer comprising a metal oxide obtained by hydrolysis and polycondensation of an organic metal compound or an inorganic metal compound described in JP-A-6-35174. Among them, use of an alkoxy compound of silicon such as $Si(OCH_3)_4$, $Si(OC_2H_5)_4$, $Si(OC_3H_7)_4$, or $Si(OC_4H_9)_4$ is preferable since starting materials are inexpensive and readily available.

Process for producing lithographic printing plate

The process for producing a lithographic printing plate of the present invention using the lithographic printing plate precursor of the present invention is now explained in detail.

The process for producing a lithographic printing plate of the present invention comprises an exposure step of exposing (hereinafter, also called 'imagewise exposing') the lithographic printing plate precursor and a development step of removing the photosensitive layer of a non-exposed portion in the presence of the developer of the present invention containing an enzyme selected from the EC3 group and a surfactant.

Furthermore, it may comprise as necessary a step of exposing and/or heating the entire surface of the lithographic printing plate precursor between the exposure step and the development step and/or subsequent to the development step.

Exposure step

Exposure of the lithographic printing plate precursor is carried out by a method in which exposure is carried out through a transparent original image having a line image, a halftone dot image, etc., a method in which laser beam scanning is carried out based on digital data, etc. Among them, in the exposure step, it is preferable to carry out imagewise exposure by means of a laser.

The wavelength of an exposure light source is not particularly limited and may be appropriately selected according to a polymerization initiator or a sensitizing dye, but is preferably 300 nm to 450 nm (more preferably, 350 nm to 450 nm) or 750 nm to 1,400 nm (more preferably, 760 nm to 1,200 nm).

When the exposure light source has a wavelength of 300 nm to 450 nm, a lithographic printing plate precursor comprising in the photosensitive layer a sensitizing dye having a maximum absorption in this region is used, and when

it has a wavelength of 750 nm to 1,400 nm, a lithographic printing plate precursor comprising an infrared absorbing agent, which is a sensitizing dye having an absorption in this region, is used.

As available laser light sources for emitting light at 300 nm to 450 nm (preferably, 350 nm to 450 nm), those below may be used.

Examples of gas lasers include an Ar ion laser (364 nm, 351 nm, 10 mW to 1W), a Kr ion laser (356 nm, 351 nm, 10 mW to 1W), and a He-Cd laser (441 nm, 325 nm, 1 mW to 100 mW), examples of solid-state lasers include a combination of Nd:YAG ($YVO_4$) and SHG crystal ×2 (355 nm, 5 mW to 1W) and a combination of Cr:LiSAF and SHG crystal (430 nm, 10 mW), examples of semiconductor laser systems include a $KNbO_3$ ring resonator (430 nm, 30 mW), a combination of a waveguide wavelength converter and AlGaAs and InGaAs semiconductors (380 nm to 450 nm, 5 mW to 100 mW), a combination of a waveguide wavelength converter and AlGaInP and AlGaAs semiconductors (300 nm to 350 nm, 5 mW to 100 mW), and AlGaInN (350 nm to 450 nm, 5 mW to 30 mW) and, in addition, examples of pulse lasers include an $N_2$ laser (337 nm, 0.1 to 10 mJ pulse) and XeF (351 nm, 10 to 250 mJ pulse). Among them, a semiconductor laser is suitable, and an AlGaInN semiconductor laser (commercial 400 to 410 nm, 5 to 30 mW InGaN-based semiconductor laser) is particularly suitable in terms of wavelength characteristics and cost.

With regard to lithographic printing plate precursor exposure equipment of a scanning exposure method, as a exposure mechanism any of an internal drum system, an external drum system, and a flatbed system may be used, and as a light source among the above-mentioned light sources a continuous-wave type may preferably be used.

Furthermore, as another exposure light source that can be used in the present invention, super high pressure, high pressure, medium pressure, and low pressure mercury lamps, a chemical lamp, a carbon arc lamp, a xenon lamp, a metal halide lamp, various visible and UV laser lamps, a fluorescent lamp, a tungsten lamp, sunlight, etc. can be cited.

As available laser light sources for emitting light at 750 nm to 1,400 nm (preferably 760 nm to 1,200 nm) there can be suitably cited, without being particularly limited to, a solid-state laser and a semiconductor laser that radiate IR rays at a wavelength of 750 nm to 1,400 nm (preferably 760 nm to 1,200 nm). An exposure mechanism may be any of a drum inner face method, a drum outer face method, a flat bed method, etc. The output of an IR laser is preferably at least 100 mW. Furthermore, in order to reduce exposure time, a multibeam laser device is preferably used. The exposure time per pixel is preferably within 20 μsec. Furthermore, the amount of irradiation energy is preferably 10 to 300 $mJ/cm^2$. As a light source, an AlGaInN semiconductor laser (commercial 5 to 30 mW InGaN-based semiconductor laser) is suitable in terms of wavelength characteristics and cost.

Development step

The development step is now explained in detail.

In a development step using a conventional lithographic printing plate precursor, strongly alkaline development is carried out, whereas in accordance with the lithographic printing plate precursor in the present invention, weakly alkaline development is also possible.

That is, in the present invention, examples of the development step include (1) a method in which development is carried out with an alkaline developer (pH higher than 11) and (2) a method in which development is carried out with a developer having a pH of 2 to 11.

Furthermore, in the present invention, the development step is preferably a step in which removal of the photosensitive layer of a non-exposed portion and a gumming treatment are carried out using a single solution. Moreover, when the lithographic printing plate precursor of the present invention has a protective layer, the development step is preferably a step of carrying out, using a single solution, removal of the protective layer, removal of the photosensitive layer of a non-exposed portion, and a gumming treatment. The 'gumming treatment' in the present invention means a treatment of a plate surface in order to make it hydrophilic by means of an aqueous solution containing a water-soluble polymer compound and/or a surfactant.

Furthermore, it is also possible to add a water-soluble polymer compound to the developer in the development step.

In the development step (1) employing a conventional alkaline developer, it is necessary to remove a protective layer in a water washing pre-step, subsequently carry out alkaline development, remove the alkali in a water washing post-step, carry out a gumming treatment in a gumming step, and carry out drying in a drying step. On the other hand, in method (2) in which development is carried out using a developer having a pH of 2 to 11, adding a surfactant and/or a water-soluble polymer compound to a developer enables development and a gumming liquid treatment to be carried out at the same time. It is therefore unnecessary to carry out a water washing post-step, and after carrying out development and gumming liquid treatment using a single solution, a drying step may be carried out. Furthermore, a water washing pre-step is not particularly necessary, and protective layer removal, development, and gumming liquid treatment may be carried out at the same time. It is preferable to carry out development and a gumming treatment, then remove surplus developer using a squeegee roller, and then carry out drying. Development method (2) has the advantage of being free from measures against development residue resulting from the protective layer and photosensitive layer encountered

during printing in the case of on-machine development.

In the present invention, as described above, a method in which development is carried out using a developer having a pH of 2 to 11 is suitably used.

That is, in a method for processing the lithographic printing plate precursor of the present invention, immediately after the protective layer and the non-exposed portion of the photosensitive layer are together removed using the developer having a pH of 2 to 11, it can be set on a printing machine, and printing may be carried out. Development of a lithographic printing plate precursor in the present invention is carried out in accordance with a standard method at 0°C to 60°C, and preferably at on the order of 15°C to 40°C, such as, for example, a method in which an imagewise exposed lithographic printing plate precursor is immersed in a developer and rubbed by a brush or a method in which an exposed photosensitive lithographic printing plate precursor is sprayed with a developer and rubbed by a brush.

Processing in the present invention may be carried out suitably by an automatic development processor equipped with supply means for the developer and a rubbing member. An automatic processor using a rotating brush roller as the rubbing member is particularly preferable. The automatic development processor preferably further includes, after the processing means, means such as a squeegee roller for removing surplus developer and drying means such as a hot air dryer.

As the automatic development processor, the structure shown in FIG. 1 can be cited as an example. This automatic development processor comprises a development section 6 for developing a lithographic printing plate precursor 4 and a drying section 10 for drying the developed lithographic printing plate precursor 4. Provided within a development tank 20 of the development section 6 in sequence from the upstream in the transport direction are a transport roller 22, a brush roller 24, and a squeegee roller 26, and provided therebetween at appropriate positions are backup rollers 28. The lithographic printing plate precursor 4 is immersed in developer while being transported by the transport roller 22, and processed by removing a non-image area of the lithographic printing plate precursor 4 by rotating the brush roller 24. The processed lithographic printing plate precursor 4 is transported to the drying section 10 by a transport roller (transport-out roller).

The drying section 10 is provided, in sequence from the upstream in the transport direction, with a guide roller 36 and a pair of skewer rollers 38. The drying section 10 is also provided with drying means such as hot air supply means or heat generating means, which are not illustrated. The drying section 10 is provided with an outlet (not illustrated), and the lithographic printing plate precursor 4 that has been dried by the drying means is discharged through the outlet. Furthermore, a shutter (not illustrated) is provided in a passage between the drying section 10 and the development section 6, and when the lithographic printing plate precursor 4 is not passing through the passage, the passage is closed by the shutter.

## Developer

The developer used in the present invention comprises an enzyme selected from the EC3 group and a surfactant in the developer.

Furthermore, the developer used in the present invention is an aqueous solution comprising water as a main component (containing water at 60 wt% or greater), and a surfactant (anionic, nonionic, cationic, amphoteric ion, etc. surfactant). The developer used in the present invention preferably comprises both a surfactant and a water-soluble polymer compound.

Furthermore, it is also preferable for the development step to be a method in which development-processing is carried out while supplying an enzyme to a developer. Supplying an enzyme to a developer may be carried out by adding an enzyme to a replenishing composition and carrying out replenishment. Alternatively, a development replenisher comprising an enzyme, which is described later, may be used as the replenishing composition. In either case, means by which an enzyme is supplied to a developer effectively may be used.

In the present invention, the developer may comprise an enzyme when starting development, or the developer may not comprise an enzyme when starting development with only the replenisher comprising an enzyme so that the developer may comprise an enzyme after the replenisher is supplied, there being no particular restrictions thereon.

## Enzyme

The enzyme selected from the EC3 group used in the present invention is not particularly limited in terms of its type as long as it exhibits a function of suppressing the occurrence of development residue during development-processing of a lithographic printing plate precursor comprising a photopolymerizable photosensitive layer. For the purpose of decomposing and solubilizing a monomer (ethylenically unsaturated compound) a hydrolase belonging, as an enzyme number (EC No.) in accordance with the enzyme commission of International Union of Biochemistry and Molecular Biology (IUBMB), to the EC3 Group is used. Since ethylenically unsaturated compounds often comprise carbon, hydrogen, nitrogen, oxygen, sulfur, phosphorus, halogen etc. atoms, examples of the enzyme include an enzyme

that hydrolyzes at least one selected from the group consisting of an ester bond, an amide bond, a tertiary amino group, a urethane bond, a urea bond, a thiourethane bond, and a thiourea bond.

Among them, those belonging to the EC3.1 group (ester hydrolases) and the EC3.4 group (peptide bond hydrolases) are particularly preferable, and EC3.1.1.3 (triacylglycerol lipase), EC3.4.11.1 (leucine aminopeptidase (leucylaminopeptidase)), EC3.4.21.62 (subtilisin (subtilisin)), EC3.4.21.63 (oryzin (oryzin)), EC3.4.22.2 (papain (papain)), EC3.4.22.32 (stem bromelain), EC3.4.23.18 (aspergillo pepsin I), EC3.4.24.25 (vibriolysin), EC3.4.24.27 (thermolysin (thermolysin)), and EC3.4.24.28 (bacillolysin (bacillolysin)) are preferable. Moreover, EC3.1.1.3, EC3.4.21.14, EC3.4.21.62, and EC3.4.21.63 are preferable.

Moreover, as described above, in the present invention, in terms of developability and the environment, the pH of the developer is preferably 2 to 11, more preferably 5 to 11, yet more preferably 6.5 to 11, particularly preferably 7.5 to 11.0, and most preferably 8.0 to 10.5.

From the viewpoint of the above, an alkaline enzyme is preferably used as the enzyme. The alkaline enzyme referred to here is an enzyme that has an optimum pH in an alkaline region; an enzyme that has an optimum pH of 7.0 to 11.0 is preferable, an enzyme having an optimum temperature of 20°C to 60°C is preferable, and an enzyme having an optimum temperature of 30°C to 55°C is more preferable.

Specifically, an enzyme that can hydrolyze mainly an ester group of a monomer under alkaline conditions, such as an alkaline protease or an alkaline lipase, is preferable. As the alkaline protease there are Bacillus subtilis, Aspergillus oryzae, Bacillus stearothermophilus, papaya latex, papaya, Ananas comosus M, Pig pancreas, Bacillus licheniformis, Aspergillus melleus, Aspergillus sp., Bacillus lentus, Bacillus sp., and Bacillus clausii, and as the alkaline lipase there are Candida cylindracea, Humicola lanuginosa, Pseudomonas, Mucor sp., Chromobacterium viscosum, Rhizopus japonicus, Aspergillus niger, Mucor javanicus, Penicillium camemberti, Rhizopus oryzae, Candida rugosa, Penicillium roqueforti, Rhizopus delemar, Pseudomonas sp., Aspergillus sp., Rhizomucor miehei, Bacillus sp., and Alcaligenes sp., which are of microbial origin.

More specific modes include Lipase PL, Lipase QLM, Lipase SL, Lipase MY, and Lipase OF (all from Meito Sangyo Co., Ltd.), Newlase F3G, Lipase A 'Amano' 6, Lipase AY 'Amano' 30G, Lipase G 'Amano' 50, Lipase R 'Amano', Lipase AS 'Amano', Umamizyme G, Papain W-40, Protease A 'Amano' G, Protease N 'Amano' G, Protease NL 'Amano', Protease P 'Amano' 3G, Protease S 'Amano' G, Bromelain F, Proleather FG-F, Peptidase R, Thermoase PC10F, Protin SD-AC10F, Protin SD-AY10, Protin SD-PC10F, Protin SD-NY10, Pancreatic Digestive Enzyme TA, Prozyme, Prozyme 6, Semi-alkaline Proteinase, Lipase AYS 'Amano', Lipase PS 'Amano' SD, Lipase AK 'Amano', Lipase PS 'Amano' IM, Protease N 'Amano', Protease S 'Amano', Acylase 'Amano', and D-Aminoacylase 'Amano' (all from Amano Enzyme Inc.), Alcalase, Esperase, Savinase, Everlase, Kannase, Lipolase, Lipex, NS44020, NS44120, NS44060, NS44114, NS44126, and NS44160 (all from Novozymes Japan Ltd.), Alkaline Protease (Takeda Chemical Industries Ltd.), Aroase XA-10 (Yakult Pharmaceutical Industry Co., Ltd.), Alkaline Protease GL, Protex 6L, Purafect, Purafect OX, Properase, Protex OXG, and Protex 40L (all from Genencor Kyowa), Sumizyme MP (Shin Nihon Chemical Co., Ltd.), Bioprase OP, Bioprase AL-15KG, Bioprase 30G, Bioprase APL-30, Bioprase XL-416F, Bioprase SP-20FG, Bioprase SP-4FG, and Protease CL-15 (all from Nagase ChemteX Corporation), Orientase (HBI Enzymes, Inc.), and Enzylon SA (Rakuto-Kasei Industry Co., Ltd.).

As a method for introducing these enzymes, they may be charged directly to a developer or may be charged while processing a lithographic printing plate. Development-processing may also be carried out while supplying an enzyme to a developer.

The amount of enzyme added is preferably 0.01 wt% to 20 wt% relative to the total weight of the developer, more preferably 0.1 wt% to 10 wt%, and most preferably 1 wt% to 5 wt%.

The pH of the developer in the development step is not particularly limited, but it is preferably a developer having pH buffering capacity. It is particularly preferable to use an aqueous solution having pH buffering capacity. By exhibiting a buffer action, even if the developer is used for a long period of time, variation in pH can be suppressed, and degradation of developability, formation of development residue, etc. due to variation in pH can be suppressed.

<u>pH buffer agent</u>

The pH buffer agent that can be used is not particularly limited as long as it is a buffer agent exhibiting a buffering action.

Specific examples of the buffer (buffer agent) include, but are not limited to, those below.

Maleic acid/trishydroxymethylaminomethane (Tris)/sodium hydroxide buffer, disodium hydrogen phosphate/sodium dihydrogen phosphate buffer, potassium dihydrogen phosphate/sodium hydroxide buffer, 2,4,6-trimethylpyridine/hydrochloric acid buffer, triethanolamine hydrochloride/sodium hydroxide buffer, sodium 5,5-diethylbarbiturate/hydrochloric acid buffer, *N*-ethylmorpholine/hydrochloric acid buffer, sodium pyrophosphate/hydrochloric acid buffer, Tris/hydrochloric acid buffer, *N,N*-bis(2-hydroxyethyl)glycine (Bicine)/sodium hydroxide buffer, 2-amino-2-methylpropane-1,3-diol/hydrochloric acid buffer, diethanolamine/hydrochloric acid buffer, potassium *p*-phenolsulfonate/sodium

hydroxide buffer, boric acid/sodium hydroxide buffer, sodium borate/hydrochloric acid buffer, ammonia/ammonium chloride buffer, glycine/sodium hydroxide buffer, sodium carbonate/sodium bicarbonate buffer, sodium borate/sodium hydroxide buffer, sodium bicarbonate/sodium hydroxide buffer, disodium hydrogen phosphate/sodium hydroxide buffer, sodium hydroxide/potassium chloride buffer, citric acid/disodium hydrogen phosphate buffer, piperazine dihydrochloride/glycylglycine/sodium hydroxide buffer, citric acid monohydrate/potassium dihydrogen phosphate/boric acid/diethylbarbituric acid/sodium hydroxide buffer, and boric acid/citric acid/sodium phosphate dodecahydrate buffer.

Among them, from the viewpoint of developability, sodium 5,5-diethylbarbiturate/hydrochloric acid buffer, Tris/hydrochloric acid buffer, 2-amino-2-methylpropane-1,3-diol/hydrochloric acid buffer, diethanolamine/hydrochloric acid buffer, potassium *p*-phenolsulfonate/sodium hydroxide buffer, boric acid/sodium hydroxide buffer, sodium borate/hydrochloric acid buffer, ammonia/ammonium chloride buffer, glycine/sodium hydroxide buffer, sodium carbonate/sodium bicarbonate buffer, sodium borate/sodium hydroxide buffer, sodium bicarbonate/sodium hydroxide buffer, disodium hydrogen phosphate/sodium hydroxide buffer, sodium hydroxide/potassium chloride buffer, piperazine dihydrochloride/glycylglycine/sodium hydroxide buffer, citric acid monohydrate/potassium dihydrogen phosphate/boric acid/diethylbarbituric acid/sodium hydroxide buffer, and boric acid/citric acid/sodium phosphate dodecahydrate buffer are preferable, and potassium *p*-phenolsulfonate/sodium hydroxide buffer, boric acid/sodium hydroxide buffer, ammonia/ammonium chloride buffer, glycine/sodium hydroxide buffer, sodium carbonate/sodium bicarbonate buffer, sodium borate/sodium hydroxide buffer, sodium bicarbonate/sodium hydroxide buffer, disodium hydrogen phosphate/sodium hydroxide buffer, sodium hydroxide/potassium chloride buffer, piperazine dihydrochloride/glycylglycine/sodium hydroxide buffer, citric acid monohydrate/potassium dihydrogen phosphate/boric acid/diethylbarbituric acid/sodium hydroxide buffer, and boric acid/citric acid/sodium phosphate dodecahydrate buffer are more preferable.

In the present invention an alkaline buffer agent is preferably used, and more preferably a weak alkaline agent. Specific examples thereof include (a) carbonate ion and hydrogen carbonate ion, (b) borate ion, (c) a water-soluble amine compound and an ion of the amine compound, and the combined use thereof. That is, for example, (a) a combination of carbonate ion-hydrogen carbonate ion, (b) borate ion, or (c) a combination of water-soluble amine compound-ion of the amine compound can exhibit a pH buffering action in the developer, can suppress change in pH when the developer is used for a long period of time, and can suppress degradation of developability, the occurrence of development residue, etc. due to change in pH. A combination of carbonate ion and hydrogen carbonate ion is particularly preferable.

In order to make (a) carbonate ion and hydrogen carbonate ion present in the developer, a carbonate salt and a hydrogen carbonate salt may be added to the developer, or carbonate ion and hydrogen carbonate ion may be formed by adjusting the pH after a carbonate salt or a hydrogen carbonate salt is added.

The carbonate salt and the hydrogen carbonate salt are not particularly limited, but an alkali metal salt is preferable. As the alkali metal, lithium, sodium, and potassium can be cited, and sodium is particularly preferable. They may be used singly or in combination of two or more types.

In order to make (b) borate ion present in the developer, after boric acid and/or a boric acid salt is added to the developer, the pH is adjusted using an alkali or an alkali and an acid, thus forming an appropriate amount of borate ion.

The boric acid or the boric acid salt used here is not particularly limited, and known boric acid and boric acid salt may be used.

Examples of the boric acid include orthoboric acid, metaboric acid, and tetraboric acid, and among them orthoboric acid and tetraboric acid are preferable. The boric acid may be used singly or in combination of two or more types.

Furthermore, examples of the boric acid salt include an alkali metal salt and an alkaline earth metal salt; an orthoboric acid salt, a diboric acid salt, a metaboric acid salt, a tetraboric acid salt, a pentaboric acid salt, and an octaboric acid salt can be cited, and among them an orthoboric acid salt and a tetraboric acid salt, in particular an alkali metal tetraboric acid salt, are preferable. Preferred examples of the tetraboric acid salt include sodium tetraborate, potassium tetraborate, and lithium tetraborate, and among them sodium tetraborate is preferable. The boric acid salt may be used singly or in combination of two or more types.

As the boric acid and/or boric acid salt that can be used in the present invention, orthoboric acid, tetraboric acid, and/or sodium tetraborate are particularly preferable. The developer may use boric acid and a boric acid salt in combination.

The ion of the water-soluble amine compound (c) can be generated in an aqueous solution of the water-soluble amine compound, an alkali or an acid may further be added to the aqueous solution of the water-soluble amine compound, or it can be made present in an aqueous solution by adding a compound that is a salt of the amine compound itself.

The water-soluble amine compound is not particularly limited, but is preferably a water-soluble amine compound having a group that promotes water-solubility. Examples of the group that promotes water-solubility include a carboxylic acid group, a sulfonic acid group, a sulfinic acid group, a phosphonic acid group, and a hydroxy group. The water-soluble amine compound may contain a plurality of these groups in combination.

When the water-solubility of an amine compound is promoted by a carboxylic acid group, a sulfonic acid group, a sulfinic acid group, or a phosphonic acid group, the amine compound corresponds to an amino acid. An amino acid is in equilibrium in an aqueous solution, and when the acid group is for example a carboxylic acid group, the equilibrium

can be expressed as shown below. The amino acid referred to in the present invention means state B below, and the ion of an amino acid referred to means state C below. As a counterion in state C, sodium ion or potassium ion is preferable.

(Equilibrium of amino acid (when acid group is carboxylic acid))

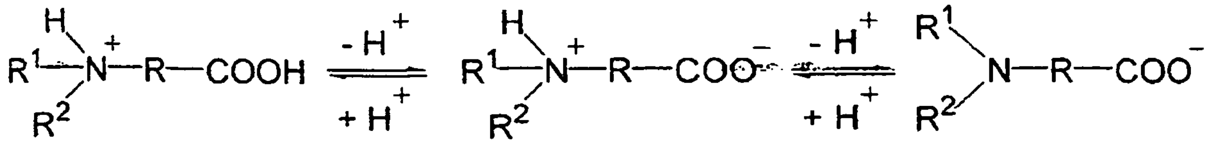

A B C

(For example, $R^1$ and $R^2$ independently denote a hydrogen atom, an alkyl group, an aryl group, etc., and R denotes a linking group.)

Specific examples of the water-soluble amine compound having a carboxylic acid group, a sulfonic acid group, or a sulfinic acid group include amino acids such as glycine, iminodiacetic acid, lysine, threonine, serine, aspartic acid, parahydroxyphenylglycine, dihydroxyethylglycine, alanine, anthranilic acid, and tryptophan; sulfamic acid, fatty acid aminesulfonic acids such as cyclohexylsulfamic acid and taurine; and fatty acid aminesulfinic acids such as aminoethanesulfinic acid. Among them, glycine and iminodiacetic acid are preferable.

Specific examples of the water-soluble amine compound having a phosphonic acid group (including a phosphinic acid group) include 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid, and ethylenediaminopentamethylenephosphonic acid. 2-aminoethylphosphonic acid is particularly preferable.

The water-soluble amine compound having a hydroxy group as the group promoting water-solubility means an alkylamine having a hydroxy group on the alkyl group (state B' below), and an ion thereof means an ammonium ion of the amino group (state A' below).

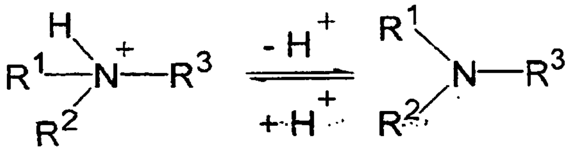

A' B'

(For example, $R^1$, $R^2$, and $R^3$ independently denote a hydrogen atom, an alkyl group, an aryl group, etc. At least one of $R^1$, $R^2$, and $R^3$ is an alkyl group having a hydroxy group.)

Specific examples of the water-soluble amine compound having a hydroxy group include monoethanolamine, diethanolamine, trimethanolamine, triethanolamine, tripropanolamine, and triisopropanolamine. Among them, triethanolamine and diethanolamine are preferable. As the ammonium ion counterion, chloride ion is preferable.

Examples of an alkali that can be used for adjustment of pH include sodium hydroxide, potassium hydroxide, lithium hydroxide, sodium carbonate, potassium carbonate, ammonium carbonate, sodium hydrogen carbonate, potassium hydrogen carbonate, ammonium hydrogen carbonate, an organic alkali agent, and a combination thereof. Furthermore, as an acid an inorganic acid such as, for example, hydrochloric acid, sulfuric acid, or nitric acid may be used. Adding such an alkali or acid enables the pH to be finely adjusted.

The pH of the developer containing (a) carbonate ion and hydrogen carbonate ion used in the present invention is preferably in the range of 8.5 to 10.8. When the pH is at least 8.5 the developability of a non-image area can be improved, whereas when it is 10.8 or lower the influence of carbon dioxide in the air can be reduced and degradation of processing capacity due to the influence of carbon dioxide can be suppressed. The pH is more preferably in the range of 8.8 to 10.2, and particularly preferably in the range of 9.0 to 10.0.

When as the pH buffer agent the combination (a) carbonate ion and hydrogen carbonate ion is used, the total amount of carbonate ion and hydrogen carbonate ion is preferably 0.05 to 5 mol/L relative to the total amount of developer, more preferably 0.1 to 2 mol/L, and particularly preferably 0.2 to 1 mol/L. When the total amount is at least 0.05 mol/L the developability and processing capacity do not deteriorate, and when it is 5 mol/L or less there is hardly any formation

of a precipitate or crystals, there is hardly any gelling when carrying out neutralization during waste solution treatment for the developer, and waste solution treatment can be carried out without problems.

Furthermore, for the purpose of finely adjusting the alkali concentration or assisting dissolution of a non-image area of the photosensitive layer, an alkali agent, for example, an organic alkali agent may be added supplementarily.

Examples of the organic alkali agent include monomethylamine, dimethylamine, trimethylamine, monoethylamine, diethylamine, triethylamine, monoisopropylamine, diisopropylamine, triisopropylamine, *n*-butylamine, monoethanolamine, diethanolamine, triethanolamine, monoisopropanolamine, diisopropanolamine, ethyleneimine, ethylenediamine, pyridine, and tetramethylammonium hydroxide. These alkali agents may be used singly or in a combination of two or more types.

When (b) borate ion is used as the pH buffer agent, the total amount of borate ion is preferably 0.05 to 5 mol/L relative to the total weight of the developer, more preferably 0.1 to 2 mol/L, and particularly preferably 0.2 to 1 mol/L. When the total amount of boric acid salt is at least 0.05 mol/L, the developability and processing capacity do not deteriorate, and when it is no greater than 5 mol/L there is hardly any formation of a precipitate or crystals, there is hardly any gelling when carrying out neutralization during waste solution processing for the developer, and waste solution processing can be carried out without problems.

When as a pH buffer agent (c) a water-soluble amine compound and an ion of the amine compound are used, the total amount of water-soluble amine compound and ion of the amine compound is preferably 0.01 to 1 mol/L relative to the total weight of the developer, more preferably 0.03 to 0.7 mol/L, and particularly preferably 0.05 to 0.5 mol/L. When the pH buffer agent is in the above-mentioned range, the developability and processing capacity do not degrade, and waste solution processing is easy.

<u>Surfactant</u>

The developer of the present invention and the developer which can be used in the process of the present invention comprises a surfactant.

The surfactant that can be used in the present invention may comprise any of anionic, nonionic, cationic, and amphoteric surfactants.

The anionic surfactant is not particularly limited, and examples thereof include a fatty acid salt, an abietic acid salt, a hydroxyalkanesulfonic acid salt, an alkanesulfonic acid salt, a dialkylsulfosuccinic acid salt, a straight-chain alkylbenzenesulfonic acid salt, a branched alkylbenzenesulfonic acid salt, an alkylnaphthalenesulfonic acid salt, an alkyldiphenylether (di)sulfonic acid salt, an alkylphenoxypolyoxyethylene propylsulfonic acid salt, a polyoxyethylene alkylsulfophenyl ether salt, sodium *N*-methyl-*N*-oleyltaurine, a disodium *N*-alkylsulfosuccinic acid monoamide, a petroleum sulfonic acid salt, sulfated castor oil, sulfated tallow oil, a sulfate ester of a fatty acid alkyl ester, an alkylsulfate ester, a polyoxyethylene alkyl ether sulfate ester, a fatty acid monoglyceride sulfate ester, a polyoxyethylene alkyl phenyl ether sulfate ester, a polyoxyethylene styrylphenyl ether sulfate ester, an alkyl phosphate ester, a polyoxyethylene alkyl ether phosphate ester, a polyoxyethylene alkyl phenyl ether phosphate ester, a partially saponified styrene-maleic anhydride copolymer, a partially saponified olefin-maleic anhydride copolymer, a naphthalenesulfonic acid salt formalin condensate, an aromatic sulfonic acid salt, and an aromatic substituted polyoxyethylenesulfonic acid salt. Among them, a dialkylsulfosuccinic acid salt, an alkylsulfate ester, an alkylbenzenesulfonic acid salt, an alkylnaphthalenesulfonic acid salt, and an alkyldiphenylether (di)sulfonic acid salt are particularly preferably used.

The cationic surfactant is not particularly limited, and a conventionally known cationic surfactant may be used. Examples thereof include an alkylamine salt, a quaternary ammonium salt, a polyoxyethylene alkylamine salt, and a polyethylene polyamine derivative.

The nonionic surfactant is not particularly limited, and examples thereof include a polyethylene glycol type higher alcohol ethylene oxide adduct, an alkylphenol ethylene oxide adduct, an alkyl naphthol ethylene oxide adduct, a phenol ethylene oxide adduct, a naphothol ethylene oxide adduct, an aromatic compound polyethylene glycol adduct, a fatty acid ethylene oxide adduct, a polyhydric alcohol fatty acid ester ethylene oxide adduct, a higher alkylamine ethylene oxide adduct, a fatty acid amide ethylene oxide adduct, an ethylene oxide adduct of an oil or fat, a polypropylene glycol ethylene oxide adduct, a dimethylsiloxane-ethylene oxide block copolymer, a dimethylsiloxane-(propylene oxide-ethylene oxide) block copolymer, a polyhydric alcohol type glycerol fatty acid ester, a pentaerythritol fatty acid ester, sorbitol and sorbitan fatty acid esters, a sucrose fatty acid ester, a polyhydric alcohol alkyl ether, and an alkanolamine fatty acid amide.

Among the above, in the present invention, an ethylene oxide adduct of a polyethylene glycol type higher alcohol, a polyethylene glycol adduct of an aromatic compound, an ethylene oxide adduct of a sorbitol and/or sorbitan fatty acid ester, an ethylene oxide adduct of a polypropylene glycol, a dimethylsiloxane-ethylene oxide block copolymer, a dimethylsiloxane-(propylene oxide-ethylene oxide) block copolymer, and a polyhydric alcohol fatty acid ester are preferable. Furthermore, one comprising an aromatic ring and an ethylene oxide chain is preferable, and an ethylene oxide adduct of an alkyl-substituted or unsubstituted phenol and an ethylene oxide adduct of an alkyl-substituted or

unsubstituted naphthol are more preferable.

Furthermore, from the viewpoint of stable solubility in water and turbidity, for the nonionic surfactant the HLB (Hydrophile-Lipophile Balance) value is preferably at least 6, and more preferably at least 8. It is also possible to similarly use acetylene glycol type and acetylene alcohol type oxyethylene adducts, fluorine type, silicone type etc. surfactants.

Amphoteric surfactants, as is well known in the surfactant field, are compounds comprising an anionic moiety and a cationic moiety in one molecule. An amphoteric surfactant used in the developer is not particularly limited; an amphoteric ion surfactant can be cited, and examples include an amine oxide type such as an alkyldimethylamine oxide, a betaine type such as an alkylbetaine, and an amino acid type such as an alkylamino fatty acid sodium salt. Specific examples thereof are described in paragraph Nos. [0255] to [0278] of JP-A-2008-203359, paragraph Nos. [0028] to [0052] of JP-A-2008-276166, etc. More preferred modes include a 2-alkyl-*N*-carboxymethyl-*N*-hydroxyethylimidazolinium betaine, an alkyldiaminoethylglycine hydrochloride, lauryldimethylaminoacetic acid betaine, N-lauramidopropyldimethyl betaine, and *N*-lauramidopropyldimethylamine oxide. As the amphoteric surfactant used in the developer, an optionally substituted alkyldimethylamine oxide, an optionally substituted alkylcarboxybetaine, an optionally substituted alkylsulfobetaine, etc. are preferably used.

In the present invention, as the amphoteric surfactant that can be used in the developer, a compound represented by Formula <1> below and a compound represented by Formula <2> below are preferable.

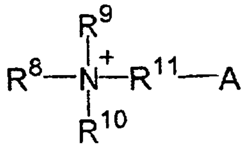

<1>

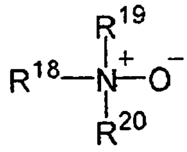

<2>

In Formula <1>, $R^8$ denotes an alkyl group, $R^9$ and $R^{10}$ independently denote a hydrogen atom or an alkyl group, $R^{11}$ denotes an alkylene group, and A denotes a carboxylic acid ion or a sulfonic acid ion.

In Formula <2>, $R^{18}$, $R^{19}$, and $R^{20}$ independently denote a hydrogen atom or an alkyl group, but not all of $R^{18}$, $R^{19}$, and $R^{20}$ are hydrogen atoms.

In Formula <1> above, the alkyl group denoted by $R^8$, $R^9$, or $R^{10}$ and the alkylene group denoted by $R^{11}$ may be a straight chain or a branched chain, may have a linking group in the chain, and may further have a substituent. As the linking group, one containing a hetero atom, such as an ester bond, an amide bond, or an ether bond is preferable. Furthermore, as the substituent a hydroxyl group, an ethylene oxide group, a phenyl group, an amide group, a halogen atom, etc. are preferable.

In the compound represented by Formula <1>, the sum total of the carbons of $R^8$ to $R^{11}$ is preferably 8 to 25, and more preferably 11 to 21. When in this range, a hydrophobic portion is appropriate, and the solubility in an aqueous developer is excellent.

Furthermore, by adding an organic solvent such as an alcohol as a dissolution adjuvant, the solubility of a surfactant in an aqueous developer can be improved.

In Formula <2> above, the alkyl group denoted by $R^{18}$, $R^{19}$, or $R^{20}$ may be a straight chain or a branched chain, may have a linking group in the chain, and may further have a substituent. As the linking group, one containing a hetero atom, such as an ester bond, an amide bond, or an ether bond is preferable. Furthermore, as the substituent a hydroxyl group, an ethylene oxide group, a phenyl group, an amide group, a halogen atom, etc. are preferable.

In the compound represented by Formula <2>, the sum total of the carbons of $R^{18}$ to $R^{20}$ is preferably 8 to 22, and more preferably 10 to 20. When in this range, a hydrophobic portion is appropriate, and the solubility in an aqueous developer is excellent.

The total number of carbons of the amphoteric surfactant might depend on the properties of a material used in the photosensitive layer, in particular a binder. In the case of a highly hydrophilic binder, one in which the total number of carbons is relatively small tends to be preferable, and when the binder used has a low degree of hydrophilicity one in which the total number of carbons is large tends to be preferable.

Preferred specific examples of the amphoteric surfactant that can be used in the developer are listed below, but the present invention is not limited thereto.

W-1

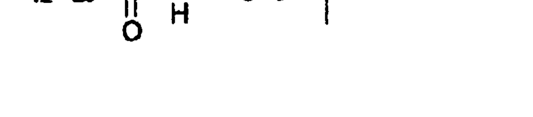

W-2 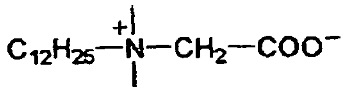

W-3 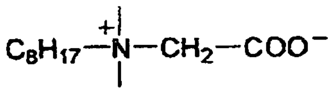

W-4 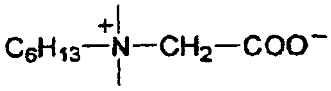

W-5 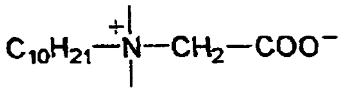

W-6 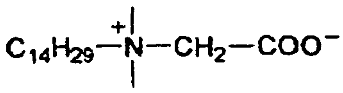

W-7 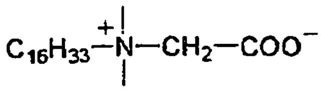

W-8 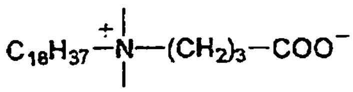

W-9 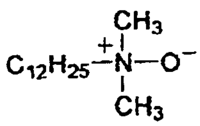 W-10 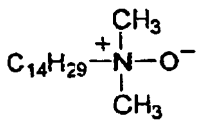

W-11 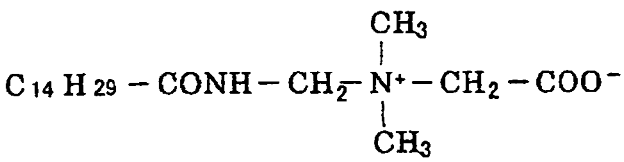

W-12 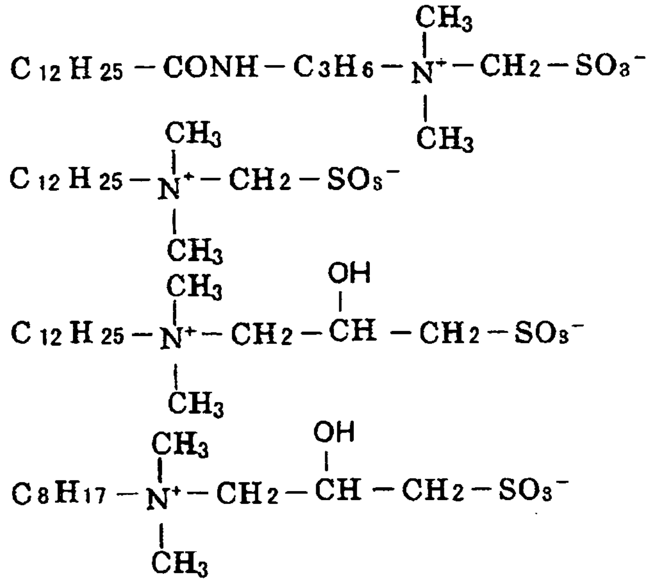

W-13

W-14

W-15

W-16 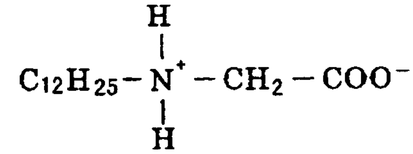

W-17 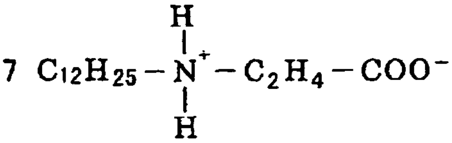

With regard to the surfactant, one type on its own or two or more types in combination may be used.

The content of the surfactant in the developer is preferably 0.01 to 20 wt%, more preferably 0.01 to 10 wt%, and yet more preferably 0.01 to 5 wt%.

The developer used in the present invention may contain, in addition to the above-mentioned components, a wetting agent, a preservative, a chelating agent, an antifoaming agent, an organic solvent, an inorganic acid, an inorganic salt, a water-soluble resin, etc.

As the wetting agent, ethylene glycol, propylene glycol, triethylene glycol, butylene glycol, hexylene glycol, diethylene glycol, dipropylene glycol, glycerol, trimethylolpropane, diglycerol, etc. are suitably used. The wetting agent may be used singly or in a combination of two or more types.

The content of the wetting agent is preferably 0.1 to 5 wt% relative to the total weight of the developer.

As the preservative, for example, phenol or a derivative thereof, formalin, an imidazole derivative, sodium dehydroacetate, a 4-isothiazolin-3-one derivative, benzisothiazolin-3-one, 2-methyl-4-isothiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative, or a nitrobromoalcohol such as 2-bromo-2-nitropropane-1,3-diol, 1,1-dibromo-1-nitro-2-ethanol, or 1,1-dibromo-1-nitro-2-propanol is preferably used. It is preferable to use in combination at least two types of preservatives so as to exhibit efficacy toward various types of molds and bacteria.

The amount of preservative added is an amount that exhibits stable efficacy toward bacteria, molds, yeasts, etc., and depends on the type of bacterium, mold, or yeast, but is preferably in the range of 0.01 to 4 wt% relative to the developer.

As the chelating agent, for example, ethylenediaminetetraacetic acid, the potassium salt thereof, or the sodium salt thereof; diethylenetriaminepentaacetic acid, the potassium salt thereof, or the sodium salt thereof; triethylenetetraminehexaacetic acid, the potassium salt thereof, or the sodium salt thereof; hydroxyethylethylenediaminetriacetic acid, the potassium salt thereof, or the sodium salt thereof; nitrilotriacetic acid or the sodium salt thereof; an organic phosphonic acid, for example, 1-hydroxyethane-1,1-diphosphonic acid, the potassium salt thereof, or the sodium salt thereof; or aminotri(methylenephosphonic acid), the potassium salt thereof, or the sodium salt thereof, or a phosphonoalkanetricarboxylic acid can be cited. An organic amine salt is also effective instead of the sodium salt or potassium salt of the chelating agents.

As the chelating agent, one that is present stably in the developer composition and does not inhibit printing properties is selected.

The amount of chelating agent added is suitably 0.001 to 1.0 wt% relative to the developer.

As the antifoaming agent, a normal silicone-based self emulsifying type, emulsifying type, nonionic, etc. compound having an HLB of no greater than 5 may be used. Among them, a silicone antifoaming agent is preferable.

Furthermore, any of an emulsifying dispersion type and a solubilizing type antifoaming agent may be used.

The content of the antifoaming agent is suitably in the range of 0.001 to 1.0 wt% relative to the developer.

Examples of the organic solvent include an aliphatic hydrocarbon (e.g. hexane, heptane, Isopar E, H, G (Exxon Chemical Co., Ltd.), gasoline, or kerosene), an aromatic hydrocarbon (e.g. toluene or xylene), a halogenated hydrocarbon (e.g. methylene dichloride, ethylene dichloride, triclene, or manochlorobenzene), and a polar solvent.

Examples of the polar solvent include an alcohol (e.g. methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methylphenylcarbinol, n-amyl alcohol, or methylamyl alcohol), a ketone (e.g. acetone, methyl ethyl ketone, ethyl butyl ketone, methyl isobutyl ketone, or cyclohexanone), an ester (e.g. ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, or butyl levulinate), and others (e.g. triethyl phosphate, tricresyl phosphate, *N*-phenylethanolamine, or *N*-phenyldiethanolamine).

Furthermore, when the organic solvent is insoluble in water, it may be employed by being solubilized in water using a surfactant, etc. In the case where the developer contains an organic solvent, the concentration of the organic solvent is preferably less than 40 wt% from the viewpoint of safety and inflammability.

As the inorganic acid and an inorganic salt, for example, phosphoric acid, metaphosphoric acid, monoammonium phosphate, diammonium phosphate, monosodium phosphate, disodium phosphate, monopotassium phosphate, dipotassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, and nickel sulfate can be cited.

The content of the inorganic salt is preferably 0.01 to 0.5 wt% relative to the total weight of the developer.

The developer that can be used in the present invention may contain a water-soluble polymer (also called a 'water-soluble resin').

The water-soluble resin that can be contained in the developer includes, for example, soybean polysaccharide, modifed starch, gum Arabic, dextrin, a cellulose derivative (for example, carboxymethylcellulose, carboxyethylcellulose or methylcellulose) or a modified product thereof, pullulan, polyvinyl alcohol or a derivative thereof, polyvinylpyrrolidone, polyacrylamide, an acrylamide copolymer, a vinyl methyl ether/maleic anhydride copolymer, a vinyl acetate/maleic anhydride copolymer, and a styrene/maleic anhydride copolymer.

Furthermore, the acid value of the water-soluble resin is preferably 0 to 3.0 meq/g.

As the soybean polysaccharide, those conventionally known may be used. For example, as a commercial product, Soyafibe (Fuji Oil Co., Ltd.) is available, and various product grades can be used. The soybean polysaccharide preferably used has a viscosity in the range of 10 to 100 mPa/sec in a 10 wt% aqueous solution thereof.

As the modified starch, there is, for example, one represented by Formula (III) below. As the starch represented by Formula (III), any starch from corn, potato, tapioca, rice, wheat, etc. may be used. Modification of these starches may be carried out by, for example, a method in which they are decomposed with, for example, an acid or an enzyme to the extent that the number of glucose residues per molecule is from 5 to 30 and then oxypropylene is added thereto in an alkali.

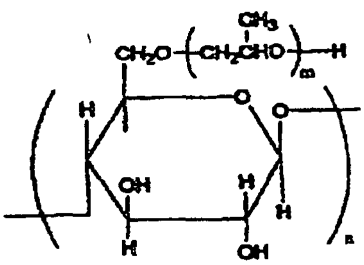

(III)

In Formula (III), the degree of etherification (degree of substitution) is in the range of 0.05 to 1.2 per glucose

unit, n denotes an integer of 3 to 30, and m denotes an integer of 1 to 3.

Examples of modified starch and derivatives thereof include roasted starch such as British gum, enzymatically-modified dextrin such as enzyme dextrin and Shardinger dextrin, oxidized starch such as solubilized starch, pregelatinized starch such as modified pregelatinized starch and unmodified pregelatinized starch, esterified starch such as starch phosphate, fatty starch, starch sulfate, starch nitrate, starch xanthate and starch carbamate, etherified starch such as carboxyalkyl starch, hydroxyalkyl starch, sulfoalkyl starch, cyanoethyl starch, allyl starch, benzyl starch, carbamylethyl starch and dialkylamino starch, crosslinked starch such as methylol-crosslinked starch, hydroxyalkyl-crosslinked starch, phosphoric acid-crosslinked starch, and dicarboxylic acid-crosslinked starch, and starch graft polymers such as starch polyacrylamide copolymer, starch polyacrylic acid copolymer, starch polyvinyl acetate copolymer, starch polyacrylonitrile copolymer, cationic starch polyacrylic acid ester copolymer, cationic starch vinyl polymer copolymer, starch polystyrene maleic acid copolymer, starch polyethylene oxide copolymer, and starch polypropylene copolymer.

Among the water-soluble resins, soybean polysaccharide, modified starch, gum Arabic, dextrin, carboxymethylcellulose, polyvinyl alcohol, etc. are preferable. The water-soluble resin may be used in a combination of two or more types. The content of the water-soluble resin in the developer is preferably 0.1 to 20 wt%, and more preferably 0.5 to 10 wt%.

Replenisher for lithographic printing plate precursor development

Furthermore, in the development step, when development-processing is carried out while supplying enzyme to the developer, the amount of enzyme in the development replenisher comprising the enzyme selected from the EC3 group is preferably 1 to 100 wt% relative to the total amount of replenisher, more preferably 10 to 90 wt%, and most preferably 20 to 80 wt%.

The pH of the replenisher is not particularly limited, but since the activity of the enzyme selected from the EC3 group is maintained and the replenisher is supplied to a developer, the pH is preferably 6 to 12, more preferably 6.5 to 11, and in terms of developability and the environment is most preferably 7 to 10.5. Furthermore, from the viewpoint of it being supplied to the developer and the activity of the enzyme selected from the EC3 group being maintained, the replenisher preferably has pH buffer capacity. Due to a buffering action being exhibited, changes in pH can be suppressed even when the replenisher is stored for a long period of time. As a pH buffer agent, those described for the developer may be used. The amount thereof added is the same as described above.

In the present invention, the above-mentioned replenisher may comprise as necessary a wetting agent, a preservative, a chelating agent, an antifoaming agent, an organic solvent, an inorganic acid, an inorganic salt, a water-soluble resin, etc. The type and amount added of the surfactant, wetting agent, preservative, chelating agent, antifoaming agent, organic solvent, inorganic acid, inorganic salt, water-soluble resin, etc. that can be used are the same as the type and amount added of such additives introduced to the developer.

With regard to the process for making a lithographic printing plate of the present invention, development-processing is also preferably carried out while supplying an enzyme selected from the EC3 group to the developer.

The form of the enzyme supplied and the supply method are not particularly limited. The form supplied may be a solid form or a liquid form. From the viewpoint of enzyme activity, stability, etc., it is preferable to supply it to the developer as an aqueous solution.

With regard to the supply method, a generally known method for replenishing a replenishing composition, such as for example an area replenishment method, a time replenishment method, an evaporated moisture replenishment method, or an electrical conductivity replenishment method, may be used. The area replenishment method is a method in which a replenishing composition is supplied each time a predetermined amount has been processed, and specifically is a method in which means for measuring the amount (area) processed is provided, a replenishing machine is operated each time a predetermined amount has been processed (e.g. 5 $m^2$ of lithographic printing plate precursor being processed per L of developer), and a predetermined amount of replenishing composition is supplied. The time replenishment method is a method in which a replenishing composition is supplied at predetermined time intervals, and specifically is a method in which a replenishing machine is operated at predetermined intervals (e.g. 2 hours, 10 days, when starting up), and a replenishing composition is supplied. The evaporated moisture replenishment method is a method in which means for detecting an amount of moisture evaporated in a processing bath is provided, or the amount of moisture evaporated in the processing bath is measured and predicted in advance, a replenishing machine is operated each time a predetermined amount of water has been evaporated, and a replenishing composition is supplied. The electrical conductivity replenishment method is a method in which the electrical conductivity of a processing bath is measured; when this electrical conductivity attains a preset electrical conductivity or lower a replenishing machine is operated, and a replenishing composition is supplied. In the present invention, use of an enzyme selected from the EC3 group or a composition comprising an enzyme selected from the EC3 group as the above-mentioned replenishing composition enables the enzyme selected from the EC3 group to be supplied to the developer. Furthermore, a method in which the activity of the enzyme selected from the EC3 group in the developer is measured, and enzyme selected from the EC3 group is

supplied according to the degree of activity may also be used.

With regard to supply of a replenishing composition, it is preferable to use a machine (replenishing machine) that automatically carries out supply as described above, but supply may be carried out directly by an operator.

One of the methods preferably used in the present invention is the evaporated moisture replenishment method. In order to carry out the evaporated moisture replenishment method, for example, the automatic development processor shown in FIG. 2 may be used. The automatic development processor shown in FIG. 2 has basically the same structure as that of the automatic development processor shown in FIG. 1 in terms of a development section and a drying section, and further comprises a machine for carrying out evaporated moisture replenishment.

That is, in FIG. 2, a development tank 20 is provided with an overflow opening 51 at a position substantially the same as the liquid surface level of the development tank 20, the overflow opening 51 allowing developer to flow in. The automatic development processor comprises a first circulation pipeline C1 communicating with the overflow opening 51, a developer tank 50 connected to the first circulation pipeline C1 and being capable of storing developer, a second circulation pipeline C2 for circulating the developer contained in the developer tank 50 toward the development tank 20 side, and a supply pump 55 for circulating the developer along the second circulation pipeline C2. Furthermore, the second circulation pipeline C2 may be additionally provided partway along with a filter section for collecting aggregates contained in the circulating developer. In this arrangement, the supply pump 55 may be constituted so that it is controlled by a controller equipped with a time measuring section and control ROM and RAM storing developer replenishment conditions, etc., control being based on a plate detection sensor and the time measuring section, which are not illustrated.

Furthermore, developer may be permanently circulated between the developer tank 50 and the development tank 20. It may be permanently circulated at an amount of for example 100 mL/min to 1,000 mUmin.

In order to replenish the development tank 20 with the loss due to water contained therein evaporating, a water replenishment tank 71 is provided. Water stored in the water tank 71 is supplied to the development tank 20 via a replenishment pipeline C3 and a water replenishment pump 72. Water replenishment may be carried out when starting the automatic development processor or may be carried out automatically at a predetermined time.

The developer tank 50 is provided with an upper limit liquid level meter 52 and a lower limit liquid level meter 53. The upper limit liquid level meter 52 detects an upper limit position of the liquid surface so that the developer contained in the developer tank 50 does not overflow. The lower limit liquid level meter 53 detects a lower limit position of the liquid surface of the developer so that the developer contained in the developer tank 50 does not become insufficient or dried out due to evaporation, etc., and when the liquid surface is not detected replenishment with fresh water from the water tank 71 can be carried out.

When the automatic development processor shown in FIG. 2 is used, supplying an enzyme aqueous solution to the water tank 71 enables an enzyme of the EC3 group to be successfully supplied to the developer.

The development temperature is preferably no greater than 60°C, and more preferably on the order of 15°C to 40°C. In development-processing using an automatic processor, since the developer might be exhausted depending on the amount processed, the processing performance may be recovered by use of a replenisher or fresh developer.

After the development step is carried out, the developer may be dried by natural drying, but it is preferable to provide a drying step employing hot air, etc.

In the process for producing a lithographic printing plate of the present invention, the entire surface of the lithographic printing plate precursor may be heated between exposure and development as necessary. By heating in this way, an image-forming reaction in the photosensitive layer is accelerated and advantages in terms of, for example, improvement in sensitivity and printing durability and stabilization of sensitivity are achieved.

Heating conditions may be appropriately set within a range that exhibits these effects.

As heating means, a commonly used convection oven, IR irradiator, IR laser, microwave device, Wisconsin oven, etc. can be cited. It may be carried out by holding the plate at a surface temperature of 70°C to 150°C for 1 sec to 5 min, preferably at 80°C to 140°C for 5 sec to 1 min, and more preferably at 90°C to 130°C for 10 to 30 sec. It is preferable for the conditions to be in these ranges since the above-mentioned effects can be obtained efficiently and adverse effects such as deformation of the printing plate due to heat can be prevented.

Heating means used in the heating treatment is preferably connected to a plate setter used in the exposure step and a developing machine used in the development step, thus carrying out automatic continuous processing. Specific examples thereof include a plate making line in which a plate setter and a developing machine are connected via transport means such as a conveyor. The heating means may be placed between the plate setter and the developing machine, or the heating means and the developing machine may be integrated.

When a lithographic printing plate precursor used is susceptible to ambient light in the operating environment, the above-mentioned plate making line is preferably shielded from light by a filter or a cover.

The printing plate after development may be subjected to overall exposure using actinic radiation such as UV rays so as to promote curing of an image area. Examples of a light source used for overall exposure include a carbon arc lamp, a mercury lamp, a gallium lamp, a metal halide lamp, a xenon lamp, a tungsten lamp, and various types of laser light. In order to obtain sufficient printing durability, the exposure is preferably at least 10 mJ/$cm^2$, and more

preferably at least 100 mJ/cm$^2$.

Heating may be carried out at the same time as overall exposure, and it is observed that printing durability is further improved by heating. As a heating device, a commonly used convection oven, IR irradiator, IR laser, microwave device, Wisconsin oven, etc. can be cited.

In this process, the plate surface temperature is preferably 30°C to 150°C, more preferably 35°C to 130°C, and yet more preferably 40°C to 120°C. Specifically, a method described in JP-A-2000-89478 may be utilized.

Furthermore, for the purpose of improving image strength and printing durability, subjecting the image after development to overall post-heating or overall exposure is effective. The post-development heating is preferably carried out using very severe conditions at a heating temperature in the range of 100°C to 500°C, and more preferably 200°C to 500°C. When in the above-mentioned range, a sufficient image strengthening effect is obtained, and it is possible to prevent the occurrence of problems such as degradation of a support or thermal decomposition of an image area.

The lithographic printing plate thus obtained is set in an offset printer, and used for printing of a large number of sheets.

EXAMPLES

The present invention is explained below in detail by way of Examples, but the present invention should not be construed as being limited thereto.

Binder polymers B-1 to B-6, ethylenically unsaturated compounds M-1 to M-5, M-7, and M-8, polymerization initiators I-1 to I-3, sensitizing dyes D-1 to D-5, chain transfer agents S-1 to S-3, additive T-1, fluorine-based surfactant (F-1), and ethyl violet (EV-1) used in the Examples are shown below.

B-1 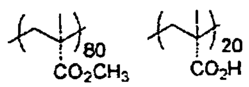 Mw = 50,000

B-2 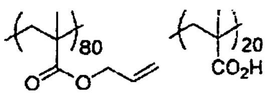 Mw = 65,000

B-3 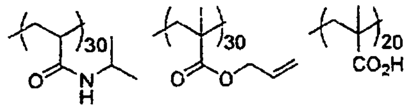 Mw = 60,000

B-4 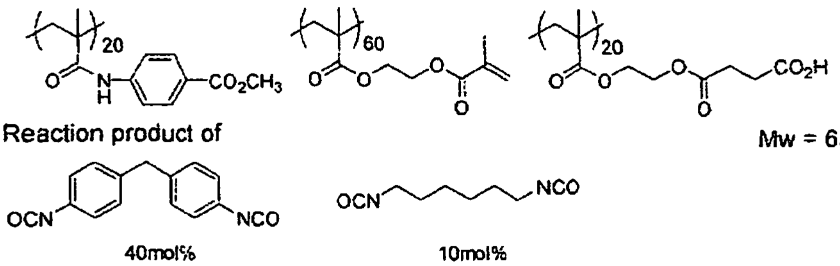

Reaction product of

40mol%

10mol%

Mw = 65,000

B-5 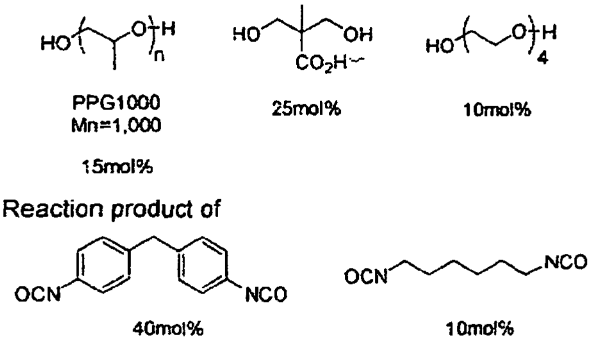

Mw = 60,000

PPG1000 Mn=1,000 15mol%

25mol%

10mol%

Reaction product of

40mol%

10mol%

Mw = 69,000

B-6

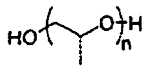

PPG1000
Mn=1000

15mol%

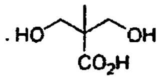

25mol%

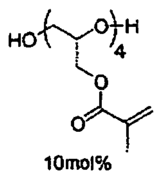

10mol%

Mixture of

M-1

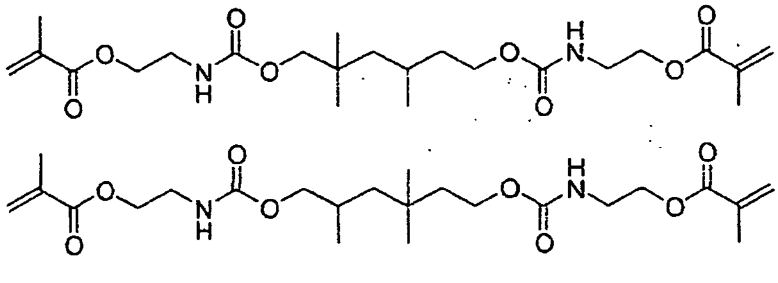

M-2

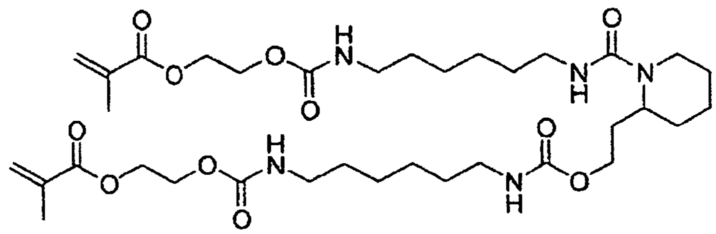

M-3

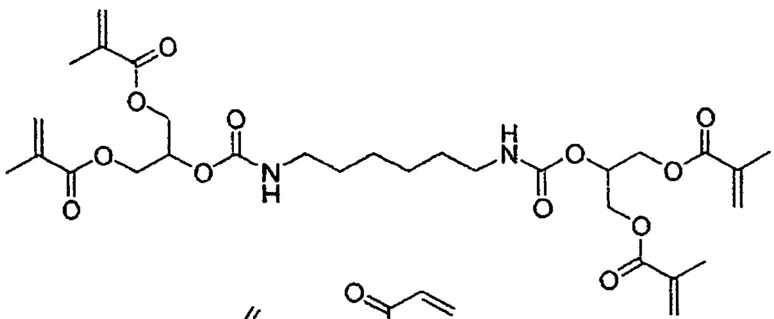

M-4

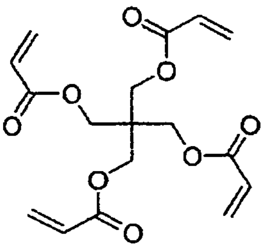

M-5

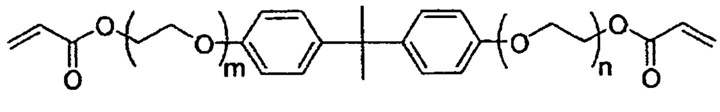

M-7 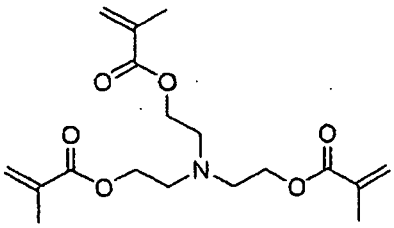

M-8 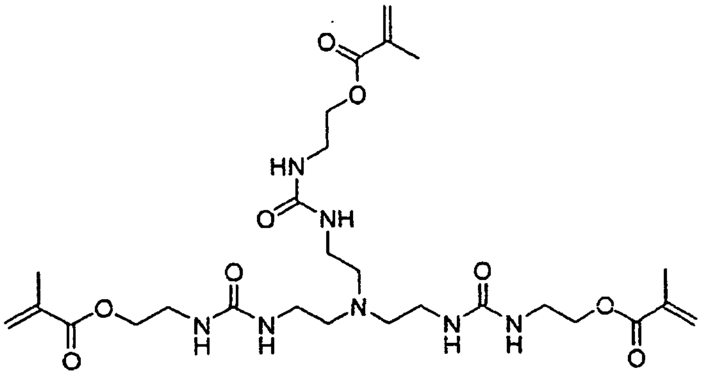

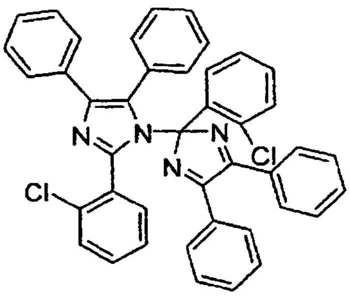

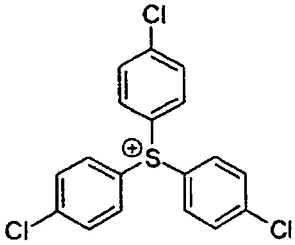

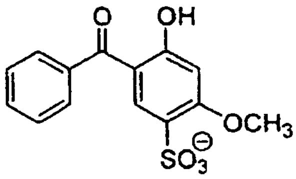

I-1

I-2

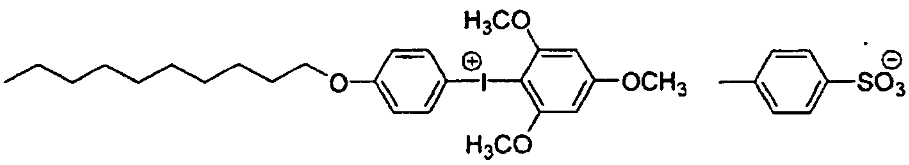

I-3

D-1 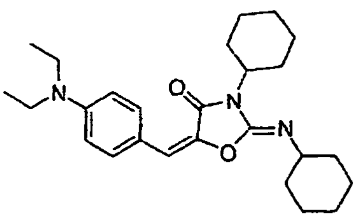

D-4 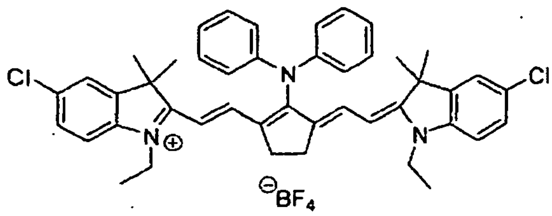

D-2

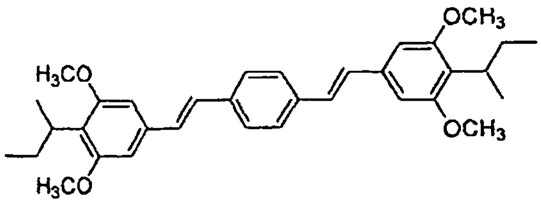

D-5

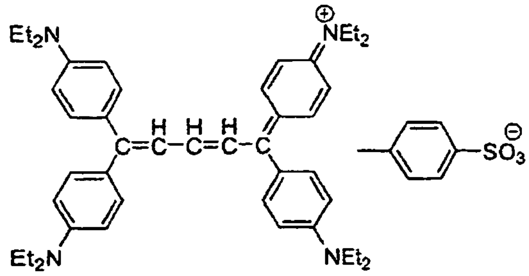

D-3

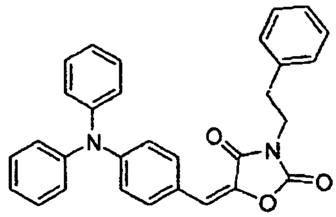

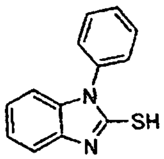

S-1

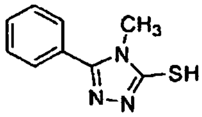

S-2

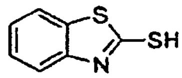

S-3

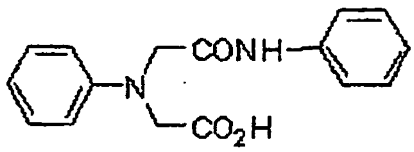

T-1

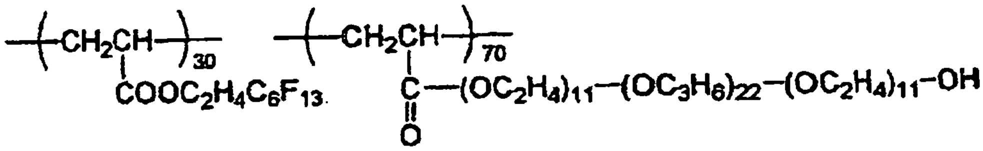

Fluorine-based surfactant (F-1)

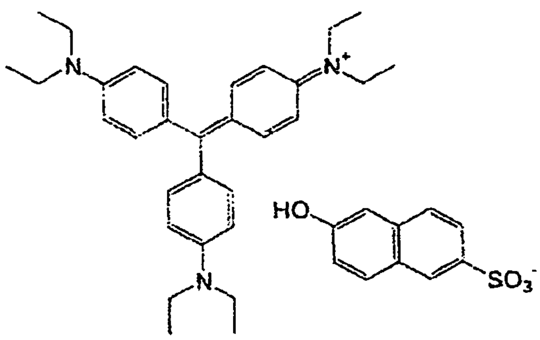

(EV-1)

Examples 1-1 to 1-34 and Comparative Examples 1-1 to 1-6

Preparation of support

A 0.03 mm thick aluminum plate (JIS A1050) was subjected to the surface treatment below.

(a) Mechanical roughening treatment

The surface of the aluminum plate was subjected to a mechanical roughening treatment by means of a rotating roll-shaped nylon brush while supplying a suspension of an abrasive (pumice) having a specific gravity of 1.12 in water as an abrasive slurry to the surface of the aluminum plate. The abrasive had an average particle size of 30 μm and a maximum particle size of 100 μm. The material of the nylon brush was nylon 6,10, the bristle length was 45 mm, and the diameter of the bristles was 0.3 mm. The nylon brush was formed by making holes in a stainless steel tube having a diameter of 300 mm and densely implanting the bristles. Three rotating brushes were used. The distance of two support rollers (ϕ 200 mm) below the brush was 300 mm. The brush rollers were pressed against the aluminum plate so that the load on a drive motor for rotating the brushes increased by 7 kW from the load before pressing the brush rollers. The direction of rotation of the brushes was the same as the direction in which the aluminum plate moved. The rotational speed of the brushes was 200 rpm.

(b) Alkali etching treatment

The aluminum plate was subjected to an etching treatment by spraying an aqueous solution (sodium hydroxide concentration 26 wt%, aluminum ion concentration 6.5 wt%) at 70°C so as to dissolve 10 g/m$^2$ of the aluminum plate. Subsequently, washing with water was carried out by means of a spray.

(c) Desmutting treatment

A desmutting treatment was carried out by means of a spray using an aqueous solution having a nitric acid concentration of 1 wt% and a temperature of 30°C (containing 0.5 wt% of aluminum ion), and following this washing with water was carried out by means of a spray. The aqueous solution of nitric acid used in the desmutting treatment employed liquid waste from a step involving carrying out the electrochemical roughening treatment using alternating current in an aqueous solution of nitric acid, which is described below.

(d) Electrochemical surface roughening treatment

A consecutive electrochemical surface roughening treatment was carried out using an AC voltage of 60 Hz. An electrolytic liquid used here was a 10.5 g/L aqueous solution of nitric acid (containing 5 g/L of aluminum ion and 0.007 wt% of ammonium ion) at a liquid temperature of 50°C. The electrochemical surface roughening treatment was carried out using a trapezoidal rectangular wave alternating current having a duty ratio of 1:1 and a time TP from zero to peak current value of 0.8 msec, with a carbon electrode as the counter electrode. Ferrite was used as an auxiliary anode. The electrolytic vessel used was of a radial cell type. The current density was 30 A/dm$^2$ as a peak current value, and the quantity of electricity as a total quantity of electricity when the aluminum plate was the anode was 220 C/dm$^2$. 5% of the current flowing from the power source was diverted to the auxiliary anode. Subsequently, washing with water was carried out by means of a spray.

(e) Alkali etching treatment

The aluminum plate was subjected to an etching treatment at 32°C by means of a spray with an aqueous solution having a sodium hydroxide concentration of 26 wt% and an aluminum ion concentration of 6.5 wt% so as to dissolve 0.50 g/m$^2$ of the aluminum plate, remove a smut component containing aluminum hydroxide as a main component formed in the previous stage when carrying out the electrochemical roughening treatment using alternating current, and dissolve an edge portion of a pit formed to thus make the edge portion smooth. Subsequently, washing with water was carried out by means of a spray.

(f) Desmutting treatment

A desmutting treatment was carried out by means of a spray using an aqueous solution having a sulfuric acid concentration of 15 wt% and a temperature of 30°C (containing 4.5 wt% of aluminum ion), and following this washing with water was carried out by means of a spray. The aqueous solution of nitric acid used in the desmutting treatment employed liquid waste from the step involving carrying out the electrochemical roughening treatment using alternating current in an aqueous solution of nitric acid.

(g) Electrochemical surface roughening treatment

A consecutive electrochemical surface roughening treatment was carried out using an AC voltage of 60 Hz. An electrolytic liquid used here was a 5.0 g/L aqueous solution of hydrochloric acid (containing 5 g/L of aluminum ion) at a liquid temperature of 35°C. The electrochemical surface roughening treatment was carried out using a trapezoidal rectangular wave alternating current having a duty ratio of 1:1 and a time TP from zero to peak current value of 0.8 msec, with a carbon electrode as the counter electrode. Ferrite was used as an auxiliary anode. The electrolytic vessel used was of a radial cell type. The current density was 25 A/$dm^2$ as a peak current value, and the quantity of electricity as a total quantity of electricity when the aluminum plate was the anode was 50 C/$dm^2$. Following this, washing with water was carried out by means of a spray.

(h) Anodizing treatment

An anodizing treatment was carried out using a two-stage power supply electrolytic method anodizing system (first and second electrolysis section lengths 6 m each, first and second power supply section lengths 3 m each, first and second power supply electrode section lengths 2.4 m each). As electrolytic liquids supplied to the first and second electrolysis sections, both had a sulfuric acid concentration of 50 g/L (containing 0.5 wt% aluminum ion) and a temperature of 20°C. Subsequently, washing with water was carried out by means of a spray. The final amount of oxidized film was 2.7 g/$m^2$.

An aluminum plate that had been subjected to all of steps (a) to (h) above was defined as support 1. When the center line average roughness (as Ra in accordance with JIS B0601) of support 1 was measured using a stylus having a diameter of 2 μm, it was found to be 0.52 μm.

Furthermore, support 1 was immersed in an aqueous solution containing 4 g/L of polyvinylphosphonic acid at 40°C for 10 sec, washed with tap water at 20°C for 2 sec, and dried, thus preparing support 2.

<u>Formation of photosensitive layer and protective layer</u>

Aluminum supports 2 having the undercoat layer applied thereto were bar-coated with photosensitive layer coating solutions 1 to 7 having the compositions below and dried in an oven at 80°C for 60 sec, thus forming photosensitive layers with a dry coat weight of 1.1 g/$m^2$, and protective layer coating liquid 1 having the composition below was applied thereonto by means of a bar coater so as to give a dry coat weight of 1.25 g/$m^2$ and dried at 125°C for 70 sec, thus forming a protective layer and thereby giving lithographic printing plate precursors 1 to 7.

<u>Photosensitive layer coating solution 1</u>

Binder polymer (B-1): 0.52 parts by weight
Ethylenically unsaturated compound (M-1): 0.50 parts by weight
Radical polymerization initiator (I-1): 0.10 parts by weight
Sensitizing dye (D-1): 0.08 parts by weight
Chain transfer agent (S-1): 0.07 parts by weight
Dispersion (P-1) of ε-phthalocyanine pigment: 0.40 parts by weight

(pigment: 15 parts by weight, allyl methacrilate/methacrylic acid (80/20) copolymer (Mw = 60,000): 10 parts by weight as dispersant, cyclohexanone/methoxypropyl acetate/1-methoxy-2-propanol = 15 parts by weight/20 parts by weight/40 parts by weight as solvent)
Thermopolymerization inhibitor (K-1): 0.01 parts by weight
(*N*-nitrosophenylhydroxylamine aluminum salt)
Fluorine-based surfactant (F-1): 0.001 parts by weight
(Megafac F780-F, Dainippon Ink and Chemicals, Incorporated, methyl isobutyl ketone 30 wt% solution)
Polyoxyethylene-polyoxypropylene condensation product: 0.04 parts by weight
(Pluronic L44, ADEKA)
1-Methoxy-2-propanol: 6.5 parts by weight
Methyl ethyl ketone: 8.0 parts by weight

Photosensitive layer coating solution 2

Binder polymer (B-1): 0.52 parts by weight
Ethylenically unsaturated compound (M-4): 0.50 parts by weight
Radical polymerization initiator (I-1): 0.10 parts by weight
Sensitizing dye (D-1): 0.08 parts by weight
Chain transfer agent (S-1): 0.07 parts by weight
Dispersion (P-1) of ε-phthalocyanine pigment: 0.40 parts by weight
Thermopolymerization inhibitor (K-1): 0.01 parts by weight
Fluorine-based surfactant (F-1): 0.001 parts by weight
Polyoxyethylene-polyoxypropylene condensation product: 0.04 parts by weight (Pluronic L44, ADEKA)
1-Methoxy-2-propanol: 6.5 parts by weight
Methyl ethyl ketone: 8.0 parts by weight

Photosensitive layer coating solution 3

Binder polymer (B-3): 0.50 parts by weight
Ethylenically unsaturated compound (M-3): 0.60 parts by weight
Radical polymerization initiator (I-1): 0.10 parts by weight
Sensitizing dye (D-3): 0.08 parts by weight
Chain transfer agent (S-2): 0.07 parts by weight
Dispersion (P-1) of ε-phthalocyanine pigment: 0.40 parts by weight
Thermopolymerization inhibitor (K-1): 0.01 parts by weight
Fluorine-based surfactant (F-1): 0.001 parts by weight
1-Methoxy-2-propanol: 6.5 parts by weight
Methyl ethyl ketone: 8.0 parts by weight

Photosensitive layer coating solution 4

Binder polymer (B-6): 0.52 parts by weight
Ethylenically unsaturated compound (M-1): 0.58 parts by weight
Radical polymerization initiator (I-1): 0.10 parts by weight
Sensitizing dye (D-1): 0.08 parts by weight
Chain transfer agent (S-1): 0.07 parts by weight
Dispersion (P-1) of ε-phthalocyanine pigment: 0.40 parts by weight
Thermopolymerization inhibitor (K-1): 0.01 parts by weight
Fluorine-based surfactant (F-1): 0.001 parts by weight
1-Methoxy-2-propanol: 6.5 parts by weight
Methyl ethyl ketone: 8.0 parts by weight

Photosensitive layer coating solution 5

Binder polymer (B-1): 0.40 parts by weight
Ethylenically unsaturated compound (M-2): 0.75 parts by weight
Radical polymerization initiator (I-1): 0.12 parts by weight
Sensitizing dye (D-2): 0.08 parts by weight
Chain transfer agent (S-3): 0.07 parts by weight
Dispersion (P-1) of ε-phthalocyanine pigment: 0.40 parts by weight
Thermopolymerization inhibitor (K-1): 0.01 parts by weight
Fluorine-based surfactant (F-1): 0.001 parts by weight

1-Methoxy-2-propanol: 6.5 parts by weight
Methyl ethyl ketone: 8.0 parts by weight

Photosensitive layer coating solution 6

Made in the same way as photosensitive layer coating solution 1 except that an ethylenically unsaturated compound (M-7) was used instead of the ethylenically unsaturated compound (M-1).

Photosensitive layer coating solution 7

Made in the same way as photosensitive layer coating solution 1 except that an ethylenically unsaturated compound (M-8) was used instead of the ethylenically unsaturated compound (M-1).

Protective layer coating solution 1

Mica dispersion below: 0.6 parts by weight
Sulfonic acid-modified polyvinyl alcohol: 0.8 parts by weight
(GOHSERAN CKS-50, The Nippon Synthetic Chemical Industry Co., Ltd. (degree of saponification: 99 mol %, average degree of polymerization: 300, degree of modification: about 0.4 mol %))
Poly(vinylpyrrolidone/vinyl acetate (1/1)) (molecular weight: 70,000): 0.001 parts by weight
Surfactant (Emalex 710, Nihon-Emulsion Co., Ltd.): 0.002 parts by weight
Water: 13 parts by weight

Mica Dispersion

32 parts by weight of synthetic mica ('SOMASIF ME-100': CO-OP Chemical Co., Ltd.; aspect ratio: 1,000 or greater) was added to 368 parts by weight of water and dispersed using a homogenizer until the average particle size (laser scattering method) became 0.5 μm, thus giving a mica dispersion.

Exposure, development, and printing

Each of the lithographic printing plate precursors above was imagewise exposed using a Vx9600 Violet Semiconductor Laser Plate Setter manufactured by FFEI (equipped with an InGaN semiconductor laser, emission wavelength: 405 nm ± 10 nm/output: 30 mW). An image was drawn using an FM screen (TAFFETA 20, FUJIFILM Corporation) with a plate surface exposure of 0.05mJ/cm$^2$ at a resolution of 2,438 dpi.

Subsequently, after pre-heating was carried out at 100°C for 30 sec, development-processing was carried out in an automatic development processor having the type of structure shown in FIG. 1 using each of the developers having the compositions below.

This automatic development processor was equipped with a development section 6 carrying out development of a lithographic printing plate precursor 4 and also carrying out a gumming treatment, and a drying section 10 carrying out drying of the developed lithographic printing plate precursor 4. Provided within a development tank 20 of the development section 6 in sequence from the upstream in the transport direction were a transport roller 22, a brush roller 24, and a squeegee roller 26, and provided therebetween at appropriate positions were backup rollers 28. The lithographic printing plate precursor 4 was immersed in a developer while being transported by the transport roller 22, and processed by removing a non-image area of the lithographic printing plate precursor 4 by rotating the brush roller 24. The processed lithographic printing plate precursor 4 was next transported to the drying section 10 by a transport roller (transport-out roller).

The drying section 10 was provided, in sequence from the upstream in the transport direction, with a guide roller 36 and a pair of skewer rollers 38. The drying section 10 was also provided with drying means such as hot air supply means or heat generating means, which are not illustrated. The drying section 10 was provided with an outlet (not illustrated), and the lithographic printing plate precursor 4 that had been dried by the drying means was discharged through the outlet. Furthermore, a shutter (not illustrated) was provided in a passage between the drying section 10 and the development section 6, and when the lithographic printing plate precursor 4 was not passing through the passage, the passage was closed by the shutter.

The automatic development processor had one brush roller 24 having an outer diameter of 50 mm and having implanted therein fibers of polybutylene terephthalate (bristle diameter: 200 μm, bristle length: 17 mm), and the brush

roller was rotated at 200 rpm in the same direction as the transport direction (peripheral speed at brush tip: 0.52 m/sec). The developer temperature was 30°C. Transport of the lithographic printing plate precursor was carried out at a transport speed of 100 cm/min. After development-processing, drying was carried out in the drying section. The drying temperature was 80°C.

The compositions of the developers used are shown below.

Developer 1-1; pH = 9.80

0.1 M sodium carbonate decahydrate aqueous solution: 60.00 parts by weight
0.1 M sodium bicarbonate aqueous solution: 40.00 parts by weight
Newcol B13: 3.00 parts by weight (polyoxyethylene aryl ether, Nippon Nyukazai Co., Ltd.)
Enzyme (compound described in table): 5.00 parts by weight

Developer 1-2: pH = 9.80

0.1 M sodium carbonate decahydrate aqueous solution: 60.00 parts by weight
0.1 M sodium bicarbonate aqueous solution: 40.00 parts by weight
Newcol B13: 3.00 parts by weight
Enzyme (compound described in table): 5.00 parts by weight
Gum Arabic (Mw = 250,000): 2.50 parts by weight
Hydroxyalkylated starch (Penon JE66, Nippon Starch Chemical Co.): 7.00 parts by weight
Developer 1-3: pH = 9.80
0.1 M sodium carbonate decahydrate aqueous solution: 60.00 parts by weight
0.1 M sodium bicarbonate aqueous solution: 40.00 parts by weight
Eleminol MON2: 3.00 parts by weight (alkyl diphenyl ether disulfonate, Sanyo Chemical Industries, Ltd.)
Enzyme (compound described in table): 5.00 parts by weight
Gum Arabic (Mw = 250,000): 2.50 parts by weight
Hydroxyalkylated starch (Penon JE66, Nippon Starch Chemical Co.): 7.00 parts by weight

Developer 1-4: pH = 9.80

0.1 M sodium carbonate decahydrate aqueous solution: 60.00 parts by weight.
0.1 M sodium bicarbonate aqueous solution: 40.00 parts by weight
Pionin C157K: 3.00 parts by weight (*N*-lauryldimethyl betaine, Takemoto Oil & Fat Co., Ltd.)
Enzyme (compound described in table): 5.00 parts by weight

Developer 1-5: pH = 9.80

0.2 M boric acid aqueous solution: 25.00 parts by weight
0.2 M potassium chloride aqueous solution: 25.00 parts by weight
0.1 M sodium hydroxide aqueous solution: 40.60 parts by weight
Water: 9.40 parts by weight
Enzyme (compound described in table): 3.00 parts by weight
Newcol B13: 5.00 parts by weight
Gum Arabic (Mw = 250,000): 2.50 parts by weight
Hydroxyalkylated starch (Penon JE66, Nippon Starch Chemical Co.): 7.00 parts by weight

Developer 1-6: pH = 9.80

0.05 M sodium bicarbonate aqueous solution: 50.00 parts by weight
0.1 M sodium hydroxide aqueous solution: 7.60 parts by weight
Water: 42.4 parts by weight
Newcol B13: 3.00 parts by weight
Enzyme (compound described in table): 5.00 parts by weight
Gum Arabic (Mw = 250,000): 2.50 parts by weight
Hydroxyalkylated starch (Penon JE66, Nippon Starch Chemical Co.): 7.00 parts by weight

Developer 1-7; pH = 9.80

0.20 M diethanolamine aqueous solution: 25 parts by weight
0.20 M hydrochloric acid aqueous solution: 2.87 parts by weight
Water: 72.13 parts by weight
Newcol B13: 3.00 parts by weight
Enzyme (compound described in table): 5.00 parts by weight
Gum Arabic (Mw = 250,000): 2.50 parts by weight
Hydroxyalkylated starch (Penon JE66, Nippon Starch Chemical Co.): 7.00 parts by weight

Developer 1-8; pH = 7.0

0.1 M triethanolamine hydrochloride aqueous solution: 50.0 parts by weight
0.1 M sodium hydroxide aqueous solution: 5.1 parts by weight
Water: 44.9 parts by weight
Newcol B13: 3.00 parts by weight
Enzyme (compound described in table): 5.00 parts by weight
Gum Arabic (Mw = 250,000): 2.50 parts by weight
Hydroxyalkylated starch (Penon JE66, Nippon Starch Chemical Co.): 7.00 parts by weight

Developer 1-9; pH = 11.9

0.05 M disodium hydrogen phosphate aqueous solution: 50.0 parts by weight
0.1 M sodium hydroxide aqueous solution: 23.0 parts by weight
Water: 27.0 parts by weight
Newcol B13: 3.00 parts by weight
Enzyme (compound described in table): 5.00 parts by weight
Gum Arabic (Mw = 250,000): 2.50 parts by weight
Hydroxyalkylated starch (Penon JE66, Nippon Starch Chemical Co.): 7.00 parts by weight

Comparative developer 1-1; pH = 9.80

0.1 M sodium carbonate decahydrate aqueous solution: 60.00 parts by weight
0.1 M sodium bicarbonate aqueous solution: 40.00 parts by weight
Newcol B13: 3.00 parts by weight
Gum Arabic (Mw = 250,000): 5.00 parts by weight
Hydroxyalkylated starch (Penon JE66, Nippon Starch Chemical Co.): 7.00 parts by weight
Comparative developer 1-2: pH = 12.0
Potassium hydroxide: 0.20 parts by weight
Water: 93.00 parts by weight
Newcol B13: 3.00 parts by weight
Gum Arabic (Mw = 250,000): 2.50 parts by weight

Hydroxyalkylated starch (Penon JE66, Nippon Starch Chemical Co.): 7.00 parts by weight

The lithographic printing plates thus obtained were mounted on a SOR-M printing machine (Heidelberg), and printing was carried out at a printing speed of 6,000 sheets per hour using dampening water (EU-3 (etching liquid, FUJIFILM Corporation))/water/isopropyl alcohol = 1/89/10 (ratio by volume)) and TRANS-G(N) black ink (Dai-Nippon Ink & Chemicals, Inc.).

Evaluation

Developability, printing durability, staining resistance, and development residue were evaluated as follows using the lithographic printing plates obtained.

Developability

Development was carried out at various transport speeds as described above, and the cyan density of a non-image area was measured using a Macbeth densitometer. The transport speed at which the cyan density of a non-image area became the same as the cyan density of the aluminum substrate was determined and defined as the developability. Evaluation of developability was expressed as a relative developability, which is defined below, with Comparative Example 1-1 as a reference (1.0). The larger the value for the relative developability, the higher the developability and the better the performance.

**Relative developability = (transport speed of target sensitive material)/(transport speed of reference sensitive material)**

Printing durability

Since as the number of prints increases the photosensitive layer is gradually abraded and the ink receiving properties are degraded, the ink density on the printing paper decreases. For printing plates that had been exposed with the same exposure, the printing durability was evaluated using the number of sheets printed before the ink density (reflection density) decreased by 0.1 from that when printing started. Evaluation of printing durability was expressed as a relative printing durability, which is defined below, with Comparative Example 1-1 as a reference (1.0). The larger the value of the relative printing durability, the higher the printing durability.

**Relative printing durability = (printing durability of target sensitive material)/(printing durability of reference sensitive material)**

Staining resistance

500 sheets were printed as described above; one without any ink staining at all in a non-image area was described as 'Excellent', one being inferior to 'Excellent' but having no problems in practice was described as 'Good', one having staining in even one part and having problems in practice was described as 'Fair', and one having staining was described as 'Poor'.

Ethylenically unsaturated compound Development residue model experiment

A Teflon (registered trademark) sheet was coated with a photosensitive layer and a protective layer, 0.4 g was scraped therefrom and dispersed in 10 mL of a developer (amount of photosensitive layer and protective layer dissolved when processing 20 $m^2$ lithographic printing plate precursor per L), and the hydrolytic behavior of monomer in the developer when stored at 30°C for 20 days was estimated by measuring a hydrolyzed product (sodium methacrylate) of an ethylenically unsaturated compound appearing in the developer by means of HPLC. 20 days thereafter, one for which the hydrolysis reaction progressed at least 80% was defined as 'Good' (no ethylenically unsaturated compound residue), one for which the hydrolysis reaction progressed less than 80% was defined as 'Fair' (some ethylenically unsaturated compound residue), and one for which no hydrolysis reaction progressed was defined as 'Poor' (much ethylenically unsaturated compound residue)

Table 1

| | Lithographic printing plate precursor | Developer | | | Developability | Printing durability | Staining resistance | Ethylenically unsaturated compound development residue (20th day) |
|---|---|---|---|---|---|---|---|---|
| | | Developer composition | Enzyme added | pH | | | | |
| Ex. 1-1 | 1 | Developer 1-1 | Enzyme 7 | 9.8 | 1.2 | 1.0 | Good | Good |
| Ex. 1-2 | 1 | Developer 1-2 | Enzyme 1 | 9.8 | 1.1 | 1.0 | Excellent | Good |
| Ex. 1-3 | 1 | Developer 1-2 | Enzyme 2 | 9.8 | 1.2 | 1.0 | Excellent | Good |
| Ex. 1-4 | 1 | Developer 1-2 | Enzyme 3 | 9.8 | 1.1 | 1.0 | Excellent | Good |
| Ex. 1-5 | 1 | Developer 1-2 | Enzyme 4 | 9.8 | 1.0 | 1.0 | Excellent | Good |
| Ex. 1-6 | 1 | Developer 1-2 | Enzyme 5 | 9.8 | 1.1 | 1.0 | Excellent | Fair |
| Ex. 1-7 | 1 | Developer 1-2 | Enzyme 6 | 9.8 | 1.1 | 1.0 | Excellent | Fair |
| Ex. 1-8 | 1 | Developer 1-2 | Enzyme 7 | 9.8 | 1.2 | 1.1 | Excellent | Good |
| Ex. 1-9 | 1 | Developer 1-2 | Enzyme 8 | 9.8 | 1.1 | 1.1 | Excellent | Fair |
| Ex. 1-10 | 1 | Developer 1-2 | Enzyme 10 | 9.8 | 1.1 | 1.1 | Excellent | Good |
| Ex. 1-11 | 1 | Developer 1-2 | Enzyme 11 | 9.8 | 1.1 | 1.0 | Excellent | Good |
| Ex. 1-12 | 1 | Developer 1-2 | Enzyme 12 | 9.8 | 1.2 | 1.0 | Excellent | Good |
| Ex. 1-13 | 1 | Developer 1-2 | Enzyme 13 | 9.8 | 1.1 | 1.0 | Excellent | Good |
| Ex. 1-14 | 1 | Developer 1-2 | Enzyme 14 | 9.8 | 1.1 | 1.0 | Excellent | Good |
| Ex. 1-15 | 1 | Developer 1-2 | Enzyme 15 | 9.8 | 1.1 | 1.1 | Excellent | Good |
| Ex. 1-16 | 1 | Developer 1-2 | Enzyme 16 | 9.8 | 1.1 | 1.1 | Excellent | Good |
| Ex. 1-17 | 1 | Developer 1-2 | Enzyme 17 | 9.8 | 1.1 | 1.0 | Excellent | Good |
| Ex. 1-18 | 1 | Developer 1-3 | Enzyme 7 | 9.8 | 0.9 | 1.2 | Excellent | Good |
| Ex. 1-19 | 1 | Developer 1-4 | Enzyme 7 | 9.8 | 1.3 | 0.9 | Good | Good |
| Ex. 1-20 | 1 | Developer 1-5 | Enzyme 7 | 9.8 | 1.0 | 1.0 | Excellent | Good |
| Ex. 1-21 | 1 | Developer 1-6 | Enzyme 7 | 9.8 | 1.2 | 1.1 | Excellent | Good |
| Ex. 1-22 | 1 | Developer 1-7 | Enzyme 7 | 9.8 | 1.1 | 1.1 | Excellent | Good |
| Ex. 1-23 | 2 | Developer 1-2 | Enzyme 7 | 9.8 | 1.0 | 0.8 | Excellent | Good |
| Ex. 1-24 | 3 | Developer 1-2 | Enzyme 7 | 9.8 | 1.1 | 1.3 | Excellent | Good |

(continued)

| | Lithographic printing plate precursor | Developer | | | Developability | Printing durability | Staining resistance | Ethylenically unsaturated compound development residue (20th day) |
|---|---|---|---|---|---|---|---|---|
| | | Developer composition | Enzyme added | pH | | | | |
| Ex. 1-25 | 4 | Developer 1-2 | Enzyme 7 | 9.8 | 1.0 | 1.5 | Excellent | Good |
| Ex. 1-26 | 4 | Developer 1-2 | Enzyme 10 | 9.8 | 0.9 | 1.5 | Excellent | Good |
| Ex. 1-27 | 5 | Developer 1-2 | Enzyme 11 | 9.8 | 0.9 | 1.4 | Excellent | Good |
| Ex. 1-28 | 5 | Developer 1-2 | Enzyme 7 | 9.8 | 0.9 | 1.0 | Excellent | Good |
| Ex. 1-29 | 5 | Developer 1-2 | Enzyme 10 | 9.8 | 0.9 | 1.0 | Excellent | Good |
| Ex. 1-30 | 5 | Developer 1-2 | Enzyme 11 | 9.8 | 0.9 | 1.0 | Excellent | Good |
| Ex. 1-31 | 6 | Developer 1-7 | Enzyme 7 | 9.8 | 1.0 | 1.1 | Excellent | Good |
| Ex. 1-32 | 7 | Developer 1-7 | Enzyme 7 | 9.8 | 1.0 | 1.1 | Excellent | Good |
| Ex. 1-33 | 1 | Developer 1-8 | Enzyme 5 | 7.0 | 0.2 | 1.0 | Fair | Fair |
| Ex. 1-34 | 1 | Developer 1-9 | Enzyme 5 | 11.9 | 1.1 | 1.0 | Excellent | Fair |
| Comp. Ex. 1-1 | 1 | Comparative developer 1-1 | None | 9.8 | 1.0 | 1.0 | Excellent | Poor |
| Comp. Ex. 1-2 | 1 | Comparative developer 1-2 | None | 12.0 | 1.0 | 1.0 | Excellent | Fair |
| Comp. Ex. 1-3 | 2 | Comparative developer 1-1 | None | 9.8 | 1.2 | 1.3 | Excellent | Poor |
| Comp. Ex. 1-4 | 3 | Comparative developer 1-1 | None | 9.8 | 1.0 | 0.8 | Excellent | Poor |
| Comp. Ex. 1-5 | 4 | Comparative developer 1-1 | None | 9.8 | 1.0 | 1.5 | Excellent | Poor |
| Comp. Ex. 1-6 | 5 | Comparative developer 1-1 | None | 9.8 | 0.9 | 1.0 | Excellent | Poor |

Table 2

| | Enzyme No: | Enzyme name | EC No. | Optimum pH | Optimum temp. (°C) | Manufacturer |
|---|---|---|---|---|---|---|
| Lipase | Enzyme 1 | Lipolase | 3.1.1.3 | 8.0 | 30 | Novozymes Japan |
| | Enzyme 2 | Lipex | 3.1.1.3 | 8.0 | 30 | Novozymes Japan |
| | Enzyme 3 | Lipase AK 'Amano' | 3.1.1.3 | 8.0 | 55 | Amano Enzyme Inc. |
| | Enzyme 4 | Lipase AY 'Amano' 30G | 3.1.1.3 | 7.0 | 45 | Amano Enzyme Inc. |
| | Enzyme 5 | NS44060 | 3.1.1.3 | 7.0-11.0 | 15-60 | Novozymes Japan |
| | Enzyme 6 | NS44114 | 3.1.1.3 | 5.0-10.0 | 30-60 | Novozymes Japan |
| | Enzyme 7 | NS44126 | 3.1.1.3 | 8.0-10.0 | 30 | Novozymes Japan |
| | Enzyme 8 | NS44160 | 3.1.1.3 | 6.0-10.0 | 30-70 | Novozymes Japan |
| | Enzyme 9 | Lipase G 'Amano' 50 | 3.1.1.3 | 5.0-10.0 | 45 | Amano Enzyme Inc. |
| Protease | Enzyme 10 | Alcalase | 3.4.21.62 | 8.0 | 30 | Novozymes Japan |
| | Enzyme 11 | Esperase | 3.4.21.62 | 8.0 | 50 | Novozymes Japan |
| | Enzyme 12 | Savinase | 3.4.21.62 | 8.0 | 30 | Novozymes Japan |
| | Enzyme 13 | Everlase | 3.4.21.62 | 8.0 | 30 | Novozymes Japan |
| | Enzyme 14 | Kannase | 3.4.21.62 | 8.0 | 30 | Novozymes Japan |
| | Enzyme 15 | Protease P 'Amano' 3G | 3.4.21.63 | 10.0 | 45 | Amano Enzyme Inc. |
| | Enzyme 16 | Proleather FG-F | 3.4.21.62 | 10.0-11.0 | 60 | Amano Enzyme Inc. |
| | Enzyme 17 | Prolin SD-AY10 | 3.4.21.62 | 10.0-11.0 | 70 | Amano Enzyme Inc. |
| | Enzyme 18 | Pronase E | 3.4.21.80 | 6.0-7.0 | 30 | Merck |

As shown in Table 1, since the development-processing was carried out using the developer comprising an enzyme of the present invention, although the developer had low pH, development residue due to an ethylenically unsaturated compound that was generated could be suppressed by a hydrolysis reaction of the ethylenically unsaturated compound progressing in the developer while maintaining developability and printing durability. Furthermore, compared with development using strong alkali, development residue of the developer could be improved. Moreover, it has been found that, with regard to the monomer used, from the viewpoint of printing durability a monomer comprising a urethane skeleton is preferable.

Examples 1-35 to 1-60 and Comparative Examples 1-7 to 1-10

Preparation of support

Support 2 was prepared by the same method as in Example 1-1.

Formation of photosensitive layer

Photosensitive layer coating solutions 8 to 10 below were prepared and applied onto the supports 2 formed as above by means of a wire bar. Drying was carried out using a hot air dryer at 100°C for 60 sec. The dry coat weight was 1.4 g/m$^2$. Subsequently, the same protective layer coating solution 1 as for the lithographic printing plate precursor 1 was applied using a bar at a dry coat weight of 1.25 g/m$^2$, and then dried at 125°C for 70 sec. to thus form a protective layer, thereby giving lithographic printing plate precursors 8 to 10.

Photosensitive layer coating solution 8

Binder polymer (B-4): 0.25 parts by weight
Binder polymer (B-3): 0.20 parts by weight
Binder polymer (B-6): 0.15 parts by weight
Ethylenically unsaturated compound (M-5): 0.50 parts by weight
Radical polymerization initiator (I-2): 0.07 parts by weight
Radical polymerization initiator (I-3): 0.09 parts by weight
Sensitizing dye (D-4): 0.03 parts by weight
Additive (T-1): 0.08 parts by weight
Mercapto compound (S-1): 0.02 parts by weight
Ethyl violet (EV-1): 0.02 parts by weight
Thermopolymerization inhibitor (K-1): 0.01 parts by weight
Fluorine-based surfactant (F-1): 0.008 parts by weight
1-Methoxy-2-propanol: 6.5 parts by weight
Methanol: 2.5 parts by weight
Methyl ethyl ketone: 8.0 parts by weight

Photosensitive layer coating solution 9

Binder polymer (B-2): 0.55 parts by weight
Ethylenically unsaturated compound (M-4): 0.50 parts by weight
Radical polymerization initiator (I-2): 0.12 parts by weight
Sensitizing dye (D-5): 0.03 parts by weight
Additive (T-1): 0.08 parts by weight
Mercapto compound (S-1): 0.02 parts by weight
Ethyl vioiet (EV-1): 0.02 parts by weight
Thermopolymerization inhibitor (K-1): 0.01 parts by weight
Fluorine-based surfactant (F-1): 0.008 parts by weight
1-Methoxy-2-propanol: 6.5 parts by weight
Methanol: 2.5 parts by weight
Methyl ethyl ketone: 8.0 parts by weight

Photosensitive layer coating solution 10

Binder polymer (B-5): 0.55 parts by weight
Ethylenically unsaturated compound (M-1): 0.50 parts by weight
Radical polymerization initiator (I-3): 0.12 parts by weight
Sensitizing dye (D-5): 0.05 parts by weight
Additive (T-1): 0.08 parts by weight
Mercapto compound (S-1): 0.02 parts by weight
Ethyl violet (EV-1): 0.02 parts by weight
Thermopolymerization inhibitor (K-1): 0.01 parts by weight
Fluorine-based surfactant (F-1): 0.008 parts by weight
1-Methoxy-2-propanol: 6.5 parts by weight
Methanol: 2.5 parts by weight
Methyl ethyl ketone: 8.0 parts by weight

Formation of protective layer

A protective layer was formed by the same method as in Example 1-1.

Exposure, development and printing

The lithographic printing plate precursors thus obtained were subjected to exposure, development-processing, and drying steps in sequence.

Imagewise exposure was carried out using as an exposure light source (setter) an IR semiconductor laser (Creo Trendsetter 3244VX: equipped with a water-cooled 40 W IR semiconductor laser) under conditions of an output of 9 W, a drum outer face rotational speed of 210 rpm, a resolution of 2,400 dpi (50% halftone dot image), and a plate surface energy of 110 mJ/$cm^2$. Subsequently, after pre-heating was carried out at 100°C for 30 sec within 30 sec after exposure, development-processing was carried out in an automatic development processor having the structure shown in FIG. 1 using each developer described above in the same manner as in Example 1-1.

The lithographic printing plates thus obtained were mounted on a SOR-M printing machine (Heidelberg), and printing was carried out at a printing speed of 6,000 sheets per hour using dampening water (EU-3 (etching liquid, FUJIFILM Corporation))/water/isopropyl alcohol = 1/89/10 (ratio by volume)) and TRANS-G(N) black ink (Dai-Nippon Ink & Chemicals, Inc.).

Evaluation

Developability, printing durability, staining resistance, and development residue were evaluated in the same manner as in Example 1-1 using the lithographic printing plates obtained.

Table 3

| | Lithographic printing plate precursor | Developer | | | Developability | Printing durability | Staining resistance | Ethylenically unsaturated compound development residue (20th day) |
|---|---|---|---|---|---|---|---|---|
| | | Developer composition | Enzyme added | pH | | | | |
| Ex. 1-35 | 8 | Developer 1-1 | Enzyme 7 | 9.8 | 1.1 | 1.0 | Good | Good |
| Ex. 1-36 | 8 | Developer 1-2 | Enzyme 1 | 9.8 | 1.0 | 1.1 | Excellent | Good |
| Ex. 1-37 | 8 | Developer 1-2 | Enzyme 2 | 9.8 | 1.1 | 1.0 | Excellent | Good |
| Ex. 1-38 | 8 | Developer 1-2 | Enzyme 3 | 9.8 | 1.0 | 1.0 | Excellent | Good |
| Ex. 1-39 | 8 | Developer 1-2 | Enzyme 4 | 9.8 | 0.9 | 1.0 | Excellent | Good |
| Ex. 1-40 | 8 | Developer 1-2 | Enzyme 5 | 9.8 | 1.0 | 1.0 | Excellent | Fair |
| Ex. 1-41 | 8 | Developer 1-2 | Enzyme 6 | 9.8 | 1.0 | 1.0 | Excellent | Fair |
| Ex. 1-42 | 8 | Developer 1-2 | Enzyme 7 | 9.8 | 1.1 | 1.1 | Excellent | Good |
| Ex. 1-43 | 8 | Developer 1-2 | Enzyme 8 | 9.8 | 1.0 | 1.1 | Excellent | Fair |
| Ex. 1-44 | 8 | Developer 1-2 | Enzyme 10 | 9.8 | 1.0 | 1.1 | Excellent | Good |
| Ex. 1-45 | 8 | Developer 1-2 | Enzyme 11 | 9.8 | 1.0 | 1.0 | Excellent | Good |
| Ex. 1-46 | 8 | Developer 1-2 | Enzyme 12 | 9.8 | 1.0 | 1.0 | Excellent | Good |
| Ex. 1-47 | 8 | Developer 1-2 | Enzyme 13 | 9.8 | 1.0 | 1.0 | Excellent | Good |
| Ex. 1-48 | 8 | Developer 1-2 | Enzyme 14 | 9.8 | 1.0 | 1.0 | Excellent | Good |
| Ex. 1-49 | 8 | Developer 1-2 | Enzyme 15 | 9.8 | 1.0 | 1.1 | Excellent | Good |
| Ex. 1-50 | 8 | Developer 1-2 | Enzyme 16 | 9.8 | 1.0 | 1.1 | Excellent | Good |
| Ex. 1-51 | 8 | Developer 1-2 | Enzyme 17 | 9.8 | 1.0 | 1.0 | Excellent | Good |
| Ex. 1-52 | 8 | Developer 1-3 | Enzyme 7 | 9.8 | 0.9 | 1.2 | Excellent | Good |
| Ex. 1-53 | 8 | Developer 1-4 | Enzyme 7 | 9.8 | 1.2 | 0.9 | Good | Good |
| Ex. 1-54 | 8 | Developer 1-5 | Enzyme 7 | 9.8 | 0.9 | 1.0 | Excellent | Good |
| Ex. 1-55 | 8 | Developer 1-6 | Enzyme 7 | 9.8 | 1.1 | 1.1 | Excellent | Good |
| Ex. 1-56 | 8 | Developer 1-7 | Enzyme 7 | 9.8 | 1.0 | 1.1 | Excellent | Good |
| Ex. 1-57 | 9 | Developer 1-2 | Enzyme 7 | 9.8 | 1.1 | 0.8 | Excellent | Good |
| Ex. 1-58 | 10 | Developer 1-2 | Enzyme 7 | 9.8 | 0.9 | 1.3 | Excellent | Good |

(continued)

| | Lithographic printing plate precursor | Developer | | | Developability | Printing durability | Staining resistance | Ethylenically unsaturated compound development residue (20th day) |
|---|---|---|---|---|---|---|---|---|
| | | Developer composition | Enzyme added | pH | | | | |
| Ex. 1-59 | 10 | Developer 1-2 | Enzyme 10 | 9.8 | 0.8 | 1.3 | Excellent | Good |
| Ex. 1-60 | 10 | Developer 1-2 | Enzyme 11 | 9.8 | 0.8 | 1.3 | Excellent | Good |
| Comp. Ex. 1-7 | 8 | Comparative developer 1-1 | None | 9.8 | 1.0 | 1.0 | Excellent | Poor |
| Comp. Ex. 1-8 | 8 | Comparative developer 1-2 | None | 9.8 | 1.0 | 1.0 | Excellent | Fair |
| Comp. Ex. 1-9 | 9 | Comparative developer 1-1 | None | 9.8 | 1.1 | 0.8 | Excellent | Poor |
| Comp. Ex. 1-10 | 10 | Comparative developer 1-1 | None | 9.8 | 0.9 | 1.1 | Excellent | Poor |

As shown in Table 3, since the development-processing was carried out using the developer comprising an enzyme of the present invention, although the developer had low pH, development residue that was generated due to an ethylenically unsaturated compound could be suppressed by a hydrolysis reaction of the ethylenically unsaturated compound progressing in the developer while maintaining developability and printing durability. Furthermore, compared with development using strong alkali; development residue of the developer could be improved.

Example 1-61 and Comparative Example 1-11

Preparation of support 3

A 0.24 mm thick aluminum plate (material 1050, temper H16) was immersed for 1 min in a 5% aqueous solution of sodium hydroxide kept at 65°C so as to carry out degreasing, and then washed with water. This degreased aluminum plate was neutralized by immersion for 1 min in a 10% aqueous solution of hydrochloric acid kept at 25°C, and then washed with water. Subsequently, this aluminum plate was subjected to electrolytic surface roughening for 60 sec in a 0.3 wt% aqueous solution of hydrochloric acid at 25°C using AC with a current density of 100 A/$dm^2$, and then subjected to a desmutting treatment for 10 sec in a 5% aqueous solution of sodium hydroxide kept at 60°C. The aluminum plate that had been subjected to the surface roughening and the desmutting treatment was subjected to an anodizing treatment for 1 min in a 15% aqueous solution of sulfuric acid under conditions of 25°C, a current density of 10 A/$dm^2$, and a voltage of 15 V, and further subjected to a hydrophilization treatment using a 1% aqueous solution of polyvinylphosphonic acid at 75°C, thus giving a support 3. The surface roughness thereof was measured and found to be 0.44 μm (as Ra in accordance with JIS B0601).

Formation of photosensitive layer

Support 3 above was bar-coated with photosensitive layer coating solution 12 having the composition below and dried in an oven at 90°C for 60 sec, thus giving a photosensitive layer with a dry coat weight of 1.3 g/$m^2$.

Photosensitive layer coating solution 12

Binder polymer (1) below (weight-average molecular weight: 50,000): 0.04 parts by weight
Binder polymer (2) below (weight-average molecular weight: 80,000): 0.30 parts by weight
Polymerizable compound (1) below: 0.17 parts by weight
(PLEX6661-O, Degussa Japan)
Polymerizable compound (2) below: 0.51 parts by weight
Sensitizing dye (1) below: 0.03 parts by weight
Sensitizing dye (2) below: 0.015 parts by weight
Sensitizing dye (3) below: 0.015 parts by weight
Polymerization initiator (1) below: 0.13 parts by weight
Chain transfer agent: mercaptobenzothiazole: 0.01 parts by weight
Dispersion of ε-phthalocyanine pigment: 0.40 parts by weight

(pigment: 15 parts by weight, dispersant (allyl methacrylate/methacrylic acid copolymer (weight-average molecular weight: 60,000, copolymerization molar ratio: 83/17)): 10 parts by weight, cyclohexanone: 15 parts by weight)
Thermopolymerization inhibitor: 0.01 parts by weight
(*N*-nitrosophenylhydroxylamine aluminum salt)
Fluorine-based surfactant (1) below: 0.001 parts by weight
(weight-average molecular weight: 10,000)
1-Methoxy-2-propanol: 3.5 parts by weight
Methyl ethyl ketone: 8.0 parts by weight

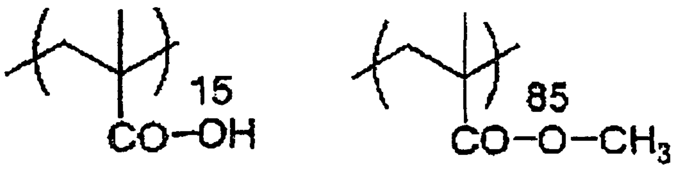

Binder Polymer (1)
(Acid value = 85 mg KOH/g)

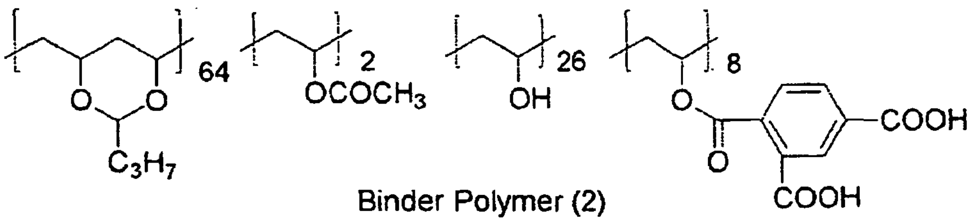

Binder Polymer (2)
(Acid value = 66 mg KOH/g)

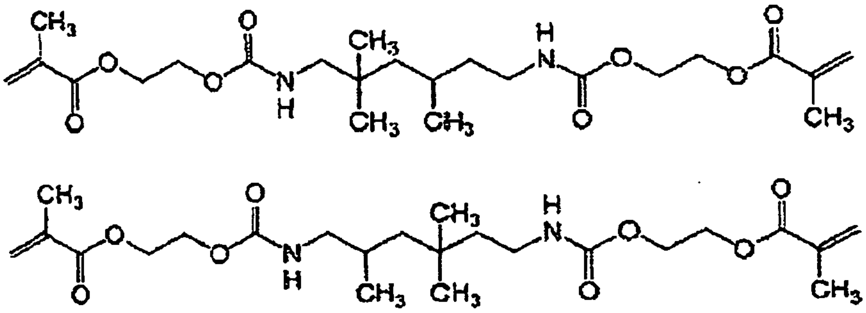

Polimerizable Compound (1) [Mixture of above mentioned metamer]

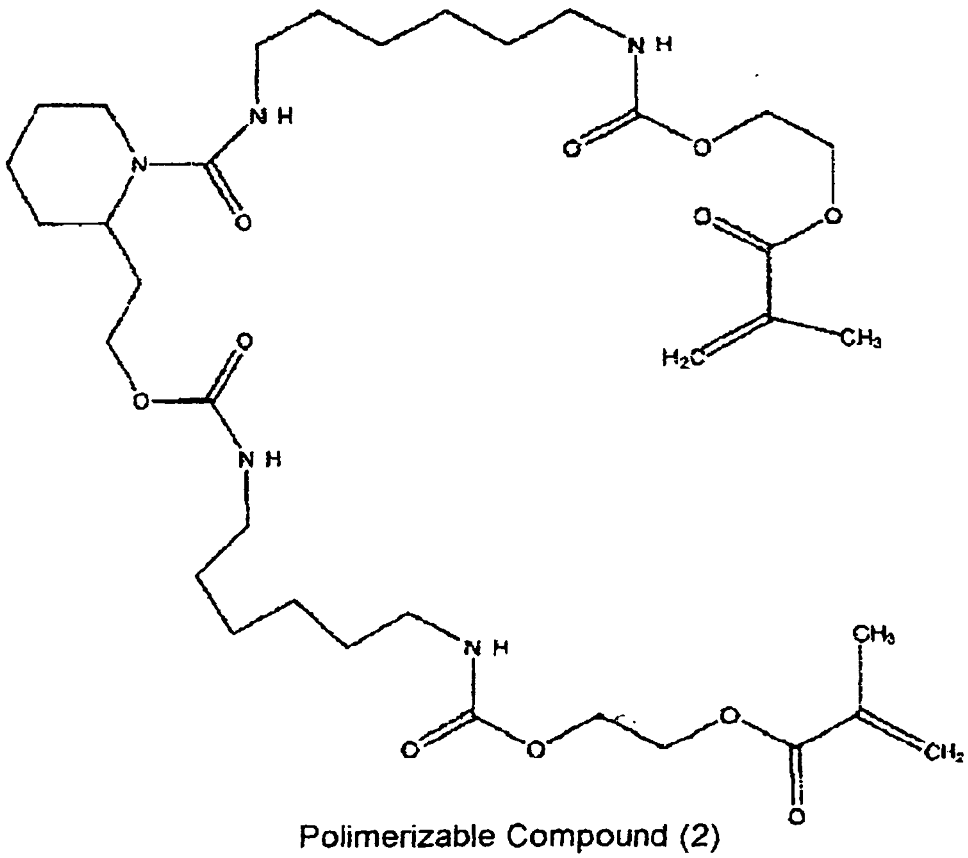

Polimerizable Compound (2)

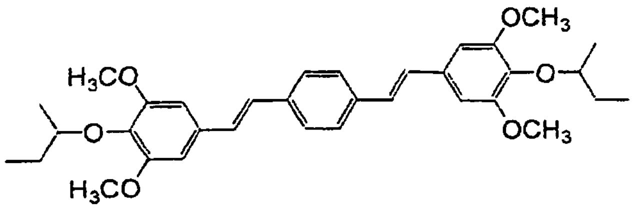

Sensitizing dye (1)

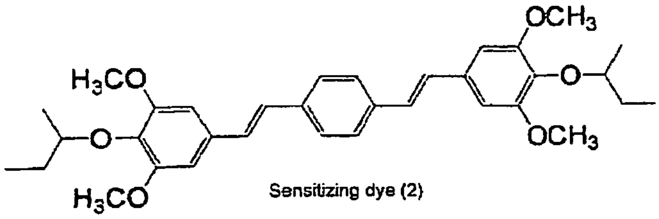

Sensitizing dye (2)

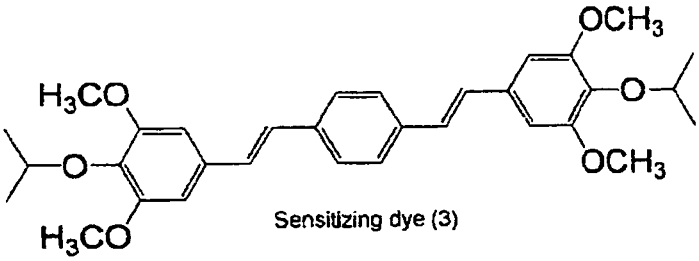

Sensitizing dye (3)

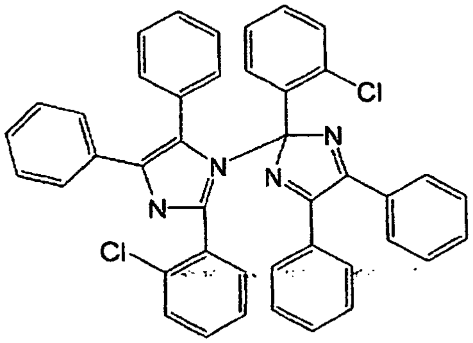

Polymerization initiator ( 1 )

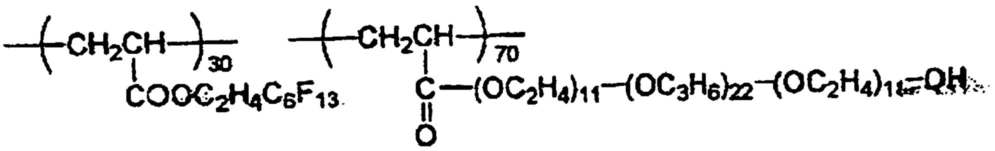

Fluorine-based surfactant (F-1)

Formation of protective layer

The above photosensitive layer was coated with protective layer coating liquid 2 having the composition below using a bar and dried in an oven at 125°C for 70 sec, thus forming a protective layer with a dry coat weight of 1.2 g/$m^2$ and thereby giving lithographic printing plate precursor 12.

Protective layer coating solution 2

PVA-205: 0.658 parts by weight
(partially hydrolyzed polyvinyl alcohol, Kuraray Co., Ltd., degree of saponification = 86.5 to 89.5 mol %, viscosity = 4.6 to 5.4 mPa·s (20°C, in 4 wt% aqueous solution)) PVA-105: 0.142 parts by weight
(fully hydrolyzed polyvinyl alcohol, Kuraray Co., Ltd., degree of saponification = 98.0 to 99.0 mol %, viscosity = 5.2 to 6.0 mPa·s (20°C, in 4 wt% aqueous solution)) Poly(vinylpyrrolidone/vinyl acetate (1/1)) (molecular weight 70,000): 0.001 parts by weight
Surfactant (Emalex 710, Nihon-Emulsion Co., Ltd): 0.002 parts by weight
Water: 13 parts by weight

Developer 1-10

Water: 88.6 parts by weight
Nonionic surfactant (W-1): 2.4 parts by weight
Nonionic surfactant (W-2): 2.4 parts by weight
Nonionic surfactant (Emalex 710, Nihon-Emulsion Co., Ltd): 1.0 parts by weight
Phenoxypropanol: 1.0 parts by weight
Octanol: 0.6 parts by weight
*N*-(2-Hydroxyethyl)morpholine: 1.0 parts by weight
Triethanolamine: 0.5 parts by weight
Sodium gluconate: 1.0 parts by weight
Trisodium citrate: 0.5 parts by weight
Tetrasodium ethylenediamine tetraacetate: 0.05 parts by weight
Polystyrenesulfonic acid (Versa TL77 (30% solution), Alco chemical): 1.0 parts by weight
Enzyme (compound described in table):5.0 parts by weight

The pH of the developer having the composition above was adjusted to 7.0 by adding phosphoric acid.

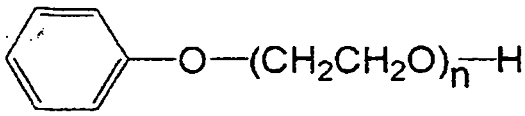

n =13-28

(W-1)

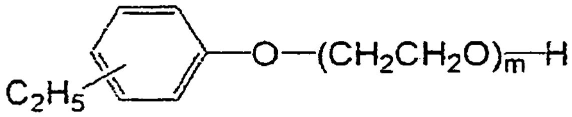

m=12-26

(W-2)

Evaluation

Plate making was carried out by the same method as in Example 1-1 using the lithographic printing plate and the developer obtained, and developability, printing durability, staining resistance, and development residue were evaluated. Developability and printing durability of Example 1-61 were based on Comparative Example 1-11 below. Here, the developer used in Comparative Example 1-11 was as in Example 1-61 except that the enzyme was not added. The results are shown in Table 4 below.

Table 4

| | Lithographic printing plate precursor | Developer | | | Developability | Printing durability | Staining resistance | Ethylenically unsaturated compound development residue (20th day) |
|---|---|---|---|---|---|---|---|---|
| | | Developer composition | Enzyme added | pH | | | | |
| Ex. 1-61 | 12 | Developer 1-10 | Enzyme 8 | 7.0 | 1.0 | 1.0 | Good | Good |
| Comp. Ex. 1-11 | 12 | Developer 1-10 | None | 7.0 | 1.0 | 1.0 | Good | Poor |

Examples 2-1 to 2-44 and Comparative Examples 2-1 to 2-7

Preparation of support

Support 2 was prepared by the same method as in Example 1-1.

Preparation of photosensitive layer

Photosensitive layer coating solutions 1 to 7 above and photosensitive layer coating solution 11 below were prepared, and lithographic printing plate precursors 1 to 7 and 11 were prepared by the same method as in Example 1-1.

Photosensitive layer coating solution 11

Binder polymer: 0.80 parts by weight
(PVP/VA I-335, ISP, 50 wt% isopropanol solution of vinylpyrrolidone/vinyl acetate copolymer)
Ethylenically unsaturated compound (M-2): 0.75 parts by weight
Radical polymerization initiator (I-1): 0.12 parts by weight
Sensitizing dye (D-2): 0.08 parts by weight
Chain transfer agent (S-3): 0.07 parts by weight
Dispersion (P-1) of ε-phthalocyanine pigment: 0.40 parts by weight
Thermopolymerization inhibitor (K-1): 0.01 parts by weight
Fluorine-based surfactant (F-1): 0.001 parts by weight
1-Methoxy-2-propanol: 6.5 parts by weight
Methyl ethyl ketone: 8.0 parts by weight

Exposure, development, and printing

Each of the lithographic printing plate precursors above was imagewise exposed using a Vx9600 Violet Semiconductor Laser Plate Setter manufactured by FFEI (equipped with an InGaN semiconductor laser, emission wavelength: 405 nm ± 10 nm/output: 30 mW). An image was drawn using an FM screen (TAFFETA 20, FUJIFILM Corporation) with a plate surface exposure of 0.05 mJ/$cm^2$ at a resolution of 2.438 dpi.

Subsequently, after pre-heating was carried out at 100°C for 30 sec, development-processing was carried out in an automatic development processor having the type of structure shown in FIG. 2 using each of the developers having the compositions below, thus giving lithographic printing plates.

The automatic development processor had one brush roller 24 having an outer diameter of 50 mm and having implanted therein fibers of polybutylene terephthalate (bristle diameter: 200 μm, bristle length: 17 mm), and the brush roller was rotated at 200 rpm in the same direction as the transport direction (peripheral speed at brush tip: 0.52 m/sec). The developer temperature was 30°C. Transport of the lithographic printing plate precursor was carried out at a transport speed of 100 cm/min. After development-processing, drying was carried out in a drying section. The drying temperature was 80°C.

The compositions of the developer and replenisher used and enzymes are shown below. Surfactants used in the developer and the replenisher were as follows.
Newcol B13: polyoxyethylene aryl ether
Softazoline LPB-R: lauramidopropyl betaine
Softazoline LAO: lauramidopropylamine oxide
Eleminol MON2: mixture of sodium alkyl diphenyl ether disulfonate and sodium alkyl diphenyl ether monosulfonate
Pionin B-111: lauryltrimethylammonium chloride
Pionin C157K: *N*-lauryldimethyl betaine

Developer 2-1: pH = 9.90

0.1 M sodium carbonate decahydrate aqueous solution: 60.00 parts by weight
0.1 M sodium bicarbonate aqueous solution: 40.00 parts by weight
Newcol B13 (Nippon Nyukazai Co., Ltd.): 3.00 parts by weight

Developer 2-2; pH = 9.90

0.1 M sodium carbonate decahydrate aqueous solution: 60.00 parts by weight
0.1 M sodium bicarbonate aqueous solution: 40.00 parts by weight
Softazoline LPB-R (Kawaken Fine Chemicals Co., Ltd.): 3.00 parts by weight
Softazoline LAO (Kawaken Fine Chemicals Co., Ltd.): 1.00 parts by weight

Developer 2-3; pH = 9.90

0.1 M sodium carbonate decahydrate aqueous solution: 60.00 parts by weight
0.1 M sodium bicarbonate aqueous solution: 40.00 parts by weight
Newcol B13 (Nippon Nyukazai Co., Ltd.): 3.00 parts by weight
Gum Arabic: 2.50 parts by weight
Hydroxyalkylated starch (Penon JE66, Nippon Starch Chemical Co.): 7.00 parts by weight

Developer 2-4; pH = 9.90

0.1 M sodium carbonate decahydrate aqueous solution: 60.00 parts by weight
0.1 M sodium bicarbonate aqueous solution: 40.00 parts by weight
Eleminol MON2 (Sanyo Chemical Industries, Ltd.): 3.00 parts by weight
Gum Arabic: 2.50 parts by weight
Hydroxyalkylated starch (Penon JE66, Nippon Starch Chemical Co.): 7.00 parts by weight

Developer 2-5; pH = 9.90

0.1 M sodium carbonate decahydrate aqueous solution: 60.00 parts by weight
0.1 M sodium bicarbonate aqueous solution: 40.00 parts by weight
Pionin B-111 (Takemoto Oil & Fat Co., Ltd.): 3.00 parts by weight
Gum Arabic: 2.50 parts by weight
Hydroxyalkylated starch (Penon JE66, Nippon Starch Chemical Co.): 7.00 parts by weight

Developer 2-6: pH = 9.90

0.1 M sodium carbonate decahydrate aqueous solution: 60.00 parts by weight
0.1 M sodium bicarbonate aqueous solution: 40.00 parts by weight
Pionin C157K (Takemoto Oil & Fat Co., Ltd.): 3.00 parts by weight

Developer 2-7; pH = 8.00

0.2 M boric acid aqueous solution: 25.00 parts by weight
0.2 M potassium chloride aqueous solution: 25.00 parts by weight
0.1 M sodium hydroxide aqueous solution: 3.90 parts by weight
Water: 46.10 parts by weight
Newcol B13: 5.00 parts by weight

Developer 2-8; pH = 10.90

0.05 M sodium bicarbonate aqueous solution: 50.00 parts by weight
0.1 M sodium hydroxide aqueous solution: 22.00 parts by weight
Water: 28.00 parts by weight
Newcol B13 (Nippon Nyukazai Co., Ltd.): 3.00 parts by weight
Developer 2-9; pH = 9.80
0.20 M diethanolamine aqueous solution: 25 parts by weight
0.20 M hydrochloric acid aqueous solution: 2.87 parts by weight
Water: 72.13 parts by weight
Newcol B13 (Nippon Nyukazai Co., Ltd.): 3.00 parts by weight
Gum Arabic: 2.50 parts by weight
Hydroxyalkylated starch (Penon JE66, Nippon Starch Chemical Co.): 7.00 parts by weight

Developer 2-10; pH = 9.90

0.1 M sodium carbonate decahydrate aqueous solution: 60.00 parts by weight
0.1 M sodium bicarbonate aqueous solution: 40.00 parts by weight
Newcol B13: 3.00 parts by weight
Enzyme 7: 5.00 parts by weight
Gum Arabic: 2.50 parts by weight
Hydroxyalkylated starch (Penon JE66, Nippon Starch Chemical Co.) 7.00 parts by weight

Developer 2-11; pH = 9.90

0.1 M sodium carbonate decahydrate aqueous solution: 60.00 parts by weight
0.1 M sodium bicarbonate aqueous solution: 40.00 parts by weight

Developer 2-12; pH = 6.50

Trisodium citrate dihydrate: 1.00 parts by weight
Newcol B13 (Nippon Nyukazai Co., Ltd.): 14.00 parts by weight
Water: 85.00 parts by weight
10 wt% trisodium phosphate aqueous solution: adjusted to pH = 6.5
Replenisher 1: pH = 7.00
Water: 10.00 parts by weight
Enzyme: 90.00 parts by weight
Replenisher 2: pH = 9.90
0.1 M sodium carbonate decahydrate aqueous solution: 60.00 parts by weight
0.1 M sodium bicarbonate aqueous solution: 40.00 parts by weight
Enzyme: 10.00 parts by weight
Replenisher 3: pH = 9.90
0.1 M sodium carbonate decahydrate aqueous solution: 60.00 parts by weight
0.1 M sodium bicarbonate aqueous solution: 40.00 parts by weight
Newcol B13: 3.00 parts by weight
Enzyme: 10.00 parts by weight

The lithographic printing plates thus obtained were mounted on a SOR-M printing machine (Heidelberg), and printing was carried out at a printing speed of 6,000 sheets per hour using dampening water (EU-3 (etching liquid, FUJIFILM Corporation))/water/isopropyl alcohol = 1/89/10 (ratio by volume)) and TRANS-G(N) black ink (Dai-Nippon

Ink & Chemicals, Inc.).

Evaluation

Each lithographic printing plate precursor was evaluated in terms of developability, printing durability, staining resistance, and development residue.

The developability, printing durability, and staining resistance were evaluated in the same manner as in Example 1-1. Evaluation of the developability and printing durability was carried out with Comparative Example 2-1 as a reference (1.0).

Development residue (ethylenically unsaturated compound residue)

An automatic development processor having the structure shown in FIG. 2 and having a development bath capacity of 5 L was used, and 20 $m^2$ per day of lithographic printing plate precursor was processed for 5 days (corresponding to an amount processed of 20 $m^2/L$). Replenishing with a replenisher containing an enzyme was carried out as follows. Time replenishment was carried out by adding replenisher to the developer tank so that the enzyme was 1.0 wt% relative to the total amount of developer once a day when starting the automatic development processor. Area replenishment was carried out by adding replenisher to the developer tank so that the enzyme became 0.25 wt% relative to the total amount of developer each time the amount of lithographic printing plate precursor processed attained 5 $m^2/L$. Evaporated moisture replenishment was carried out automatically according to the amount of moisture evaporated by placing replenisher in a replenishing water tank instead of water. After processing was carried out for 5 days, the hydrolytic behavior of monomer in the developer was evaluated by measuring a hydrolyzed product (sodium methacrylate) of an ethylenically unsaturated compound appearing in the developer by means of HPLC. One for which the hydrolysis reaction progressed at least 70% was defined as 'Good' (no ethylenically unsaturated compound residue), one for which the hydrolysis reaction progressed at least 20% but less than 70% was defined as 'Fair' (some ethylenically unsaturated compound residue), and one for which the hydrolysis reaction progressed less than 20% was defined as 'Poor' (much ethylenically unsaturated compound residue).

The results obtained are shown in Table 5. In Table 5, replenisher 1 used in Example 2-44 contained enzyme 7 and enzyme 13 at 45.00 parts by weight each.

Table 5

| | Lithographic printing plate precursor | Developer | | Replenisher | | | Develop-ability | Printing durability | Staining resistence | Ethylenically unsaturated compound development residue (20th day) |
|---|---|---|---|---|---|---|---|---|---|---|
| | | Developer composition | pH | Replenisher | Enzyme added | Replenishment method | | | | |
| Ex. 2-1 | 1 | Developer 2-1 | 9.9 | 1 | Enzyme 1 | Time replenishment | 1.1 | 1.0 | Excellent | Good |
| Ex. 2-2 | 1 | Developer 2-1 | 9.9 | 1 | Enzyme 2 | Time replenishment | 1.2 | 1.0 | Excellent | Good |
| Ex. 2-3 | 1 | Developer 2-1 | 9.9 | 1 | Enzyme 3 | Time replenishment | 1.1 | 1.0 | Excellent | Good |
| Ex. 2-4 | 1 | Developer 2-1 | 9.9 | 1 | Enzyme 4 | Time replenishment | 1.0 | 1.0 | Excellent | Good |
| Ex. 2-5 | 1 | Developer 2-1 | 9.9 | 1 | Enzyme 5 | Time replenishment | 1.1 | 1.0 | Excellent | Fair |
| Ex. 2-6 | 1 | Developer 2-1 | 9.9 | 1 | Enzyme 6 | Time replenishment | 1.1 | 1.0 | Excellent | Good |
| Ex. 2-7 | 1 | Developer 2-1 | 9.9 | 1 | Enzyme 7 | Time replenishment | 1.2 | 1.1 | Excellent | Good |
| Ex. 2-8 | 1 | Developer 2-1 | 9.9 | 1 | Enzyme 6 | Time replenishment | 1.1 | 1.1 | Excellent | Fair |
| Ex. 2-9 | 1 | Developer 2-1 | 9.9 | 1 | Enzyme 9 | Time replenishment | 1.1 | 1.1 | Excellent | Fair |
| Ex. 2-10 | 1 | Developer 2-1 | 9.9 | 1 | Enzyme 10 | Time replenishment | 1.1 | 1.0 | Excellent | Fair |
| Ex 2-11 | 1 | Developer 2-1 | 9.9 | 1 | Enzyme 11 | Time replenishment | 1.2 | 1.0 | Excellent | Good |
| Ex 2-12 | 1 | Developer 2-1 | 9.9 | 1 | Enzyme 12 | Time replenishment | 1.1 | 1.0 | Excellent | Fair |
| Ex. 2-13 | 1 | Developer 2-1 | 9.9 | 1 | Enzyme 13 | Time replenishment | 1.1 | 1.0 | Excellent | Good |
| Ex. 2-14 | 1 | Developer 2-1 | 9.9 | 1 | Enzyme 14 | Time replenishment | 1.1 | 1.1 | Excellent | Fair |

(continued)

| | Lithographic printing plate precursor | Developer | | Replenisher | | | Develop-ability | Printing durability | Staining resistence | Ethylenically unsaturated compound development residue (20th day) |
|---|---|---|---|---|---|---|---|---|---|---|
| | | Developer composition | pH | Replenisher | Enzyme added | Replenishment method | | | | |
| Ex. 2-15 | 1 | Developer 2-1 | 9.9 | 1 | Enzyme 15 | Time replenishment | 1.1 | 1.1 | Excellent | Good |
| Ex. 2-15 | 1 | Developer 2-1 | 9.9 | 1 | Enzyme 16 | Time replenishment | 1.1 | 1.0 | Excellent | Good |
| Ex. 2-17 | 1 | Developer 2-1 | 9.9 | 1 | Enzyme 7 | Area replenish | 1.2 | 1.1 | Excellent | Good |
| Ex. 2-18 | 1 | Developer 2-1 | 9.9 | 1 | Enzyme 7 | Evaporated moisture replenishment | 1.2 | 1.1 | Excellent | Good |
| Ex 2-19 | 1 | Developer 2-1 | 9.9 | 2 | Enzyme 7 | Time replenishment | 1.2 | 1.1 | Excellent | Good |
| Ex. 2-20 | 1 | Developer 2-1 | 9.9 | 3 | Enzyme 7 | Time replenishment | 1.2 | 1.1 | Excellent | Good |
| Ex. 2-21 | 1 | Developer 2-2 | 9.9 | 1 | Enzyme 7 | Time replenishment | 1.2 | 1.1 | Excellent ' | Good |
| Ex. 2-22 | 1 | Developer 2-3 | 9.9 | 1 | Enzym 7 | Time replenishment | 1.2 | 1.2 | Excellent | Good |
| Ex. 2-23 | 1 | Developer 2-4 | 9.9 | 1 | Enzyme 7 | Time replenishment | 1.2 | 0.9 | Excellent | Fair |
| Ex. 2-24 | 1 | Developer 2-5 | 9.9 | 1 | Enzyme 7 | Time replenishment | 0.9 | 1.0 | Excellent | Good |
| Ex. 2-25 | 1 | Developer 2-6 | 9.9 | 1 | Enzyme 7 | Time replenishment | 1.2 | 1.1 | Excellent | Good |
| Ex. 2-26 | 1 | Developer 2-7 | 8.0 | 1 | Enzyme 7 | Time replenishment | 0.8 | 1.1 | Excellent | Good |
| Ex. 2-27 | 1 | Developer 2-8 | 10.9 | 1 | Enzyme 7 | Time replenishment | 1.3 | 0.9 | Excellent | Good |

(continued)

| | Lithographic printing plate precursor | Developer | | Replenisher | | | Develop-ability | Printing durability | Staining resistence | Ethylenically unsaturated compound development residue (20th day) |
|---|---|---|---|---|---|---|---|---|---|---|
| | | Developer composition | pH | Replenisher | Enzyme added | Replenishment method | | | | |
| Ex. 2-28 | 1 | Developer 2-9 | 9.8 | 1 | Enzyme 7 | Time replenishment | 1.2 | 1.1 | Excellent | Good |
| Ex. 2-29 | 1 | Developer 2-10 | 9.9 | 1 | Enzyme 7 | Time replenishment | 1.0 | 1.1 | Excellent | Good |
| Ex. 2-30 | 1 | Developer 2-11 | 9.9 | 1 | Enzyme 7 | Time replenishment | 0.9 | 1.1 | Excellent | Good |
| Ex. 2-31 | 11 | Developer 2-12 | 8.5 | 1 | Enzyme 7 | Time replenishment | 0.9 | 1.1 | Excellent | Fair |
| Ex. 2-32 | 2 | Developer 2-1 | 9.9 | 1 | Enzyme 7 | Time replenishment | 1.1 | 0.8 | Excellent | Good |
| Ex. 2-33 | 3 | Developer 2-1 | 9.9 | 1 | Enzyme 7 | Time replenishment | 1.0 | 1.3 | Excellent | Good |
| Ex. 2-34 | 4 | Developer 2-1 | 9.9 | 1 | Enzyme 7 | Time replenishment | 1.0 | 1.5 | Excellent | Good |
| Ex. 2-35 | 4 | Developer 2-1 | 9.9 | 1 | Enzyme 10 | Time replenishment | 0.9 | 1.5 | Excellent | Good |
| Ex. 2-36 | 5 | Developer 2-1 | 9.9 | 1 | Enzyme 11 | Time replenishment | 0.9 | 1.4 | Excellent | Fair |
| Ex. 2-37 | 5 | Developer 2-1 | 9.9 | 1 | Enzyme 7 | Time replenishment | 0.9 | 1.0 | Excellent | Good |
| Ex. 2-38 | 5 | Developer 2-1 | 9.9 | 1 | Enzyme 10 | Time replenishment | 0.9 | 1.0 | Excellefa | Fair |
| Ex 2-39 | 5 | Developer 2-1 | 9.9 | 1 | Enzyme 11 | Time replenishment | 1.0 | 1.1 | Excellent | Fair |
| Ex. 2-40 | 6 | Developer 2-1 | 9.9 | 1 | Enzyme 11 | Time replenishment | 1.0 | 1.1 | Excellent | Fair |
| Ex 2-41 | 7 | Developer 2-1 | 9.9 | 1 | Enzyme 11 | Time replenishment | 0.9 | 1.0 | Excellent | Fair |

(continued)

| | Lithographic printing plate precursor | Developer | | Replenisher | | | Develop-ability | Printing durability | Staining resistence | Ethylenically unsaturated compound development residue (20th day) |
|---|---|---|---|---|---|---|---|---|---|---|
| | | Developer composition | pH | Replenisher | Enzyme added | Replenishment method | | | | |
| Ex. 2-42 | 11 | Developer 2-12 | 6.5 | 1 | Enzyme 18 | Time replenishment | 1.0 | 1.0 | Excellent | Fair |
| Ex. 2-43 | 11 | Developer 2-12 | 6.5 | 1 | Enzyme 9 | Time replenishment | 1.0 | 1.0 | Good | Fair |
| Ex. 2-44 | 1 | Developer 2-1 | 9.9 | 1 | Enzyme 7 Enzyme 13 | Time replenishment | 1.2 | 1.1 | Excellent | Good |
| Comp. Ex. 2-1 | 1 | Developer 2-1 | 9.9 | None | None | None | 1.0 | 1.0 | Excellent | Poor |
| Comp. Ex. 2-2 | 1 | Developer 2-8 | 10.9 | None | None | None | 1.0 | 1.0 | Excellent | Poor |
| Comp. Ex 2-3 | 11 | Developer 2-12 | 6.5 | None | None | None | 0.8 | 1.1 | Excellent | Poor |
| Comp. Ex. 2-4 | 2 | Developer 2-1 | 9.9 | None | None | None | 1.2 | 1.3 | Excellent | Poor |
| Comp. Ex. 2-5 | 3 | Developer 2-1 | 9.9 | None | None | None | 1.0 | 0.8 | Excellent | Poor |
| Comp. Ex. 2-6 | 4 | Developer 2-1 | 9.9 | None | None | None | 1.0 | 1.5 | Excellent | Poor |
| Comp. Ex 2-7 | 5 | Developer 2-1 | 9.9 | None | None | None | 0.9 | 1.0 | Excellent | Poor |

As shown in Table 5, by carrying out development-processing while supplying enzyme to the developer, even though a nearly neutral developer was used, development residue derived from the ethylenically unsaturated compound generated in the developer could be suppressed while maintaining developability, printing durability, and staining resistance. Furthermore, from the viewpoint of printing durability, it is more preferable to use a monomer having a urethane skeleton.

Examples 2-45 to 2-78 and Comparative Examples 2-8 to 2-11

Formation of lithographic printing plate precursors 8 to 10

Formation of photosensitive layer and protective layer

Aluminum supports were coated with the above-mentioned photosensitive layer coating solutions 8 to 10 in the same manner as for the lithographic printing plate precursor 2-1 using a wire bar and dried using a hot air dryer at 100°C for 60 sec to thus form a photosensitive layer at a dry coat weight of 1.4 $g/m^2$, and they were further coated with the same protective layer coating solution 1 as for the lithographic printing plate precursor 2-1 at a dry coat weight of 1.25 $g/m^2$ using a bar and dried at 125°C for 70 sec to thus form a protective layer, thereby forming lithographic printing plate precursors 8 to 10.

Exposure, development, and printing

The lithographic printing plate precursors were subjected to imagewise exposure in a plate setter (Creo Trendsetter 3244VX: equipped with a water-cooled 40 W IR semiconductor laser) under conditions of an output of 9 W, a drum outer face rotational speed of 210 rpm, and a resolution of 2,400 dpi. Subsequently, after pre-heating was carried out at 100°C for 30 sec within 30 sec after the exposure, development-processing was carried out in an automatic development processor having the structure shown in FIG. 2 using the developer and replenisher described above in the same manner as in Example 2-1.

The lithographic printing plates thus obtained were mounted on a SOR-M printing machine (Heidelberg), and printing was carried out at a printing speed of 6,000 sheets per hour using dampening water (EU-3 (etching liquid, FUJIFILM Corporation))/water/isopropyl alcohol = 1/89/10 (ratio by volume)) and TRANS-G(N) black ink (Dai-Nippon Ink & Chemicals, Inc.).

Evaluation

Developability, printing durability, staining resistance, and development residue were evaluated using the lithographic printing plates obtained in the same manner as in Example 2-1.

The results thus obtained are shown in Table 6.

Table 6

| | Litnographic printing plate precursor | Developer | | Replenisher | | | Developability | Printing durability | Stanning resistance | Ethylenically unsaturated compound development residue (20th day) |
|---|---|---|---|---|---|---|---|---|---|---|
| | | Developer composition | pH | Replenisher | Enzyme added | Replenishment method | | | | |
| Ex. 2-45 | 8 | Developer 2-1 | 9.9 | 1 | Enzyme 1 | Time replenishment | 1.0 | 1.1 | Excellent | Good |
| Ex. 2-46 | 8 | Developer 2-1 | 9.9 | 1 | Enzyme 2 | Time replenishment | 1.1 | 1.0 | Excellent | Good |
| Ex. 2-47 | 8 | Developer 2-1 | 9.9 | 1 | Enzyme 3 | Time replenishment | 1.0 | 1.0 | Excellent | Good |
| Ex. 2-48 | 8 | Developer 2-1 | 9.9 | 1 | Enzyme 4 | Time replenishment | 0.9 | 1.0 | Excellent | Good |
| Ex. 2-49 | 8 | Developer 2-1 | 9.9 | 1 | Enzyme 5 | Time replenishment | 1.0 | 1.0 | Excellent | Fair |
| Ex. 2-50 | 8 | Developer 2-1 | 9.9 | 1 | Enzyme 6 | Time replenishment | 1.0 | 1.0 | Excellent | Good |
| Ex. 2-51 | 8 | Developer 2-1 | 9.9 | 1 | Enzyme 7 | Time replenishment | 1.1 | 1.1 | Excellent | Good |
| Ex. 2-52 | 8 | Developper 2-1 | 9.9 | 1 | Enzyme 8 | Time replenishment | 1.0 | 1.1 | Excellent | Fair |
| Ex. 2-53 | 8 | Developer 2-1 | 9.9 | 1 | Enzyme 10 | Time replenishment | 1.0 | 1.1 | Excellent | Fair |
| Ex. 2-54 | 8 | Developer 2-1 | 9.9 | 1 | Enzyme 11 | Time replenishment | 1.0 | 1.0 | Excellent | Fair |
| Ex. 2-55 | 8 | Developer 2.1 | 9.9 | 1 | Enzyme 12 | Time replenishment | 1.0 | 1.0 | Excellent | Good |
| Ex. 2-56 | 8 | Developer 2-1 | 9.9 | 1 | Enzyme 13 | Time replenishment | 1.0 | 1.0 | Excellent | Fair |
| Ex. 2-57 | 8 | Developer 2-1 | 9.9 | 1 | Enzyme 14 | Time replenishement | 1.0 | 1.0 | Excellent | Good |

(continued)

| | Litnographic printing plate precursor | Developer | | Replenisher | | | Developability | Printing durability | Stanning resistance | Ethylenically unsaturated compound development residue (20th day) |
|---|---|---|---|---|---|---|---|---|---|---|
| | | Developer composition | pH | Replenisher | Enzyme added | Replenishment method | | | | |
| Ex 2-58 | 8 | Developer 2-1 | 9.9 | 1 | Enzyme 15 | Time replenishment | 1.0 | 1.1 | Excellent | Fair |
| Ex. 2-59 | 8 | Developer 2-1 | 9.9 | 1 | Enzyme 16 | Time replenishement | 1.0 | 1.1 | Excellent | Gooo |
| Ex. 2-60 | 8 | Developer 2-1 | 9.9 | 1 | Enzyme 17 | Time replenishment | 1.0 | 1.0 | Excellent | Good |
| Ex. 2-61 | 8 | Developer 2-1 | 9.9 | 1 | Enzyme 7 | Area replenish | 1.1 | 1.1 | Excellent | Good |
| Ex. 2-62 | 8 | Developer 2-1 | 9.9 | 1 | Enzyme 7 | Evaporated moisture replenishment | 1.1 | 1.1 | Excellent | Good |
| Ex. 2-63 | 8 | Developer 2-1 | 9.9 | 1 | Enzyme 7 | Time replenishment | 1.1 | 1.1 | Excellent | Good |
| Ex. 2-64 | 8 | Developer 2-1 | 9.9 | 2 | Enzyme 7 | Time replenishment | 1.1 | 1.1 | Excellent | Good |
| Ex. 2-65 | 8 | Developer 2-2 | 9.9 | 3 | Enzyme 7 | Time replenishment | 1.0 | 1.0 | Excellent | Good |
| Ex. 2.66 | 8 | Developer 2-3 | 9.9 | 1 | Enzyme 7 | Time replenishment | 0.9 | 1.2 | Excellent | Good |
| Ex. 2-67 | 8 | Developer 2-4 | 9.9 | 1 | Enzyme 7 | Time replenishment | 1.2 | 0.9 | Good | Good |
| Ex. 2-68 | 8 | Developer 2-5 | 9.9 | 1 | Enzyme 7 | Time replenishement | 0.9 | 1.0 | Excellent | Good |
| Ex. 2-69 | 8 | Developer 2-6 | 9.9 | 1 | Enzyme 7 | Time replenishment | 1.2 | 1.1 | Excellent | Good |
| Ex. 2-70 | 8 | Developer 2-7 | 8.0 | 1 | Enzyme 7 | Time replenishment | 0.8 | 1.1 | Excellent | Good |

(continued)

| | Litnographic printing plate precursor | Developer | | Replenisher | | | Developability | Printing durability | Stanning resistance | Ethylenically unsaturated compound development residue (20th day) |
|---|---|---|---|---|---|---|---|---|---|---|
| | | Developer composition | pH | Replenisher | Enzyme added | Replenishment method | | | | |
| Ex. 2-71 | 8 | Developer 2-8 | 10.9 | 1 | Enzyme 7 | Time replenishment | 1.3 | 1.0 | Excellent | Good |
| Ex. 2-72 | 8 | Developer 2-9 | 9.8 | 1 | Enzyme 7 | Time replenishment | 1.2 | 1.1 | Excellent | Good |
| Ex 2-73 | 8 | Developer 2-10 | 9.9 | 1 | Enzyme 7 | Time replenishment | 1.2 | 1.1 | Excellent | Good |
| Ex. 2-74 | 8 | Developer 2-11 | 9.9 | 1 | Enzyme 7 | Time replenishment | 0.9 | 1.1 | Excellent | Good |
| Ex. 2-75 | 9 | Developer 2-1 | 6.5 | 1 | Enzyme 7 | Time replenishment | 1.1 | 0.8 | Excellent | Good |
| Ex. 2-76 | 10 | Developer 2-1 | 9.9 | 1 | Enzyme 7 | Time replenishment | 0.9 | 12 | Excellent | Good |
| Ex 2.77 | 10 | Developer 2-1 | 9.9 | 1 | Enzyme 10 | Time replenishment | 0.8 | 1.1 | Excellent | Good |
| Ex 2-78 | 10 | Developer 2-1 | 9.9 | 1 | Enzyme 11 | Time replenishement | 0.8 | 1.1 | Excellent | Good |
| Comp. Ex. 2-8 | 8 | Developer 2-1 | 9.9 | None | None | None | 1.0 | 1.0 | Excellent | Poor |
| Comp. Ex. 2-9 | 8 | Developer 2-8 | 9.9 | None | None | None | 1.0 | 1.0 | Excellent | Poor |
| Comp. Ex. 2-10 | 9 | Developer 2-1 | 9.9 | None | None | None | 1.1 | 0.8 | Excellent | Poor |
| Comp. Ex 2-11 | 10 | Developer 2-1 | 9.9 | None | None | None | 0.9 | 1.1 | Excellent | Poor |

As shown in Table 6, by carrying out development-processing while supplying enzyme to the developer, even though a nearly neutral developer was used, development residue derived from the ethylenically unsaturated compound generated in the developer could be suppressed while maintaining developability, printing durability, and staining resistance. Furthermore, from the viewpoint of printing durability, it is more preferable to use a monomer having a urethane skeleton.

Example 2-79 and Comparative Example 2-12

Developer 2-13

Water: 88.6 parts by weight
Nonionic surfactant (W-1): 2.4 parts by weight
Nonionic surfactant (W-2): 2.4 parts by weight
Nonionic surfactant (Emalex 710, Nihon-Emulsion Co., Ltd): 1.0 parts by weight
Phenoxypropanol: 1.0 parts by weight
Octanol: 0.6 parts by weight
*N*-(2-Hydroxyethyl)morpholine: 1.0 parts by weight
Triethanolamine: 0.5 parts by weight
Sodium gluconate: 1.0 parts by weight
Trisodium citrate: 0.5 parts by weight
Tetrasodium ethylenediamine tetraacetate: 0.05 parts by weight
Polystyrenesulfonic acid (Versa TL77 (30% solution), Alco chemical): 1.0 parts by weight

The pH of the developer having the composition above was adjusted to 7.0 by adding phosphoric acid.

Evaluation

Developability, printing durability, staining resistance, and development residue were evaluated using the lithographic printing plate precursor 12 and the developer 2-13 above by the same method as in Example 2-1. In addition, developability and printing durability of Example 2-13 were based on Comparative Example 2-12 below. Here, a replenisher used in Comparative Example 2-12 was the same as one in Example 2-13 except that enzyme was not added.
The results obtained are shown in Table 7.

Table 7

| | Lithographic printing plate precursor | Developer | | Replenisher | | | Developability | Printing durability | Staining resistance | Ethylenically unsaturated compound development residue ($20^{th}$ day) |
|---|---|---|---|---|---|---|---|---|---|---|
| | | Developer composition | pH | Replenisher | Enzyme added | Replenishment method | | | | |
| Ex. 2-79 | 12 | Developer 2-13 | 7.0 | 1 | Enzyme | Time replenishment | 1.0 | 1.0 | Good | Good |
| Comp. Ex. 2-12 | 12 | Developer 2-13 | 7.0 | 1 | None | Time replenishement | 1.0 | 1.0 | Good | Poor |

Reference Signs List

| | |
|---|---|
| 4 | Lithographic printing plate precursor |
| 6 | Development section |
| 10 | Drying section |
| 16 | Transport roller |
| 20 | Development tank |
| 22 | Transport roller |
| 24 | Brush roller |
| 26 | Squeegee roller |
| 28 | Backup roller |
| 36 | Guide roller |
| 38 | Skewer roller |
| 50 | Developer tank |
| 51 | Overflow opening |
| 52 | Upper limit liquid level meter |
| 53 | Lower limit liquid level meter |
| 55 | Supply pump |
| 71 | Water tank |
| 72 | Water replenishment pump |
| C1, C2 | Circulation pipeline |
| C3 | Replenishment pipeline |

**Claims**

1. A developer for a lithographic printing plate precursor, comprising

   (a) an enzyme selected from the EC3 group
   and
   (b) a surfactant.

2. The developer for a lithographic printing plate precursor according to Claim 1, wherein the enzyme is selected from the EC3.1 group or the EC3.4 group.

3. The developer for a lithographic printing plate precursor according to Claim 1 or 2, wherein the enzyme is selected from the group consisting of EC3.1.1.3 (triacylglycerol lipase), EC3.4.11.1 (leucine aminopeptidase), EC3.4.21.62 (subtilisin), EC3.4.21.63 (oryzin), EC3.4.22.2 (papain), EC3.4.22.32 (stem bromelain), EC3.4.23.18 (aspergillo pepsin I), EC3.4.24.25 (vibriolysin), EC3.4.24.27 (thermolysin), and EC3.4.24.28 (bacillolysin).

4. The developer for a lithographic printing plate precursor according to any one of Claims 1 to 3, wherein the enzyme has an optimum pH in an alkaline region.

5. The developer for a lithographic printing plate precursor according to any one of Claims 1 to 4, wherein the developer has a pH of at least 6.5 but no greater than 11.

6. The developer for a lithographic printing plate precursor according to any one of Claims 1 to 5, wherein the developer further comprises a water-soluble polymer compound.

7. The developer for a lithographic printing plate precursor according to any one of Claims 1 to 6, wherein the developer has buffer capacity.

8. A process for making a lithographic printing plate, comprising:

   (A) a step of preparing a lithographic printing plate precursor comprising above a support a photosensitive layer comprising

(i) a binder polymer,
(ii) an ethylenically unsaturated compound comprising at least one type selected from the group consisting of an ester bond, an amide bond, a tertiary amino group, a urethane bond, a urea bond, a thiourethane bond, and a thiourea bond, and
(iii) a radical polymerization initiator;

(B) an exposure step of exposing the lithographic printing plate precursor;
and
(C) a development step of removing the photosensitive layer of a non-exposed area of the lithographic printing plate precursor;

the development step (C) being carried out by means of a developer as defined in any one of the Claims 1 to 7.

**9.** The plate making process according to Claim 8, wherein the development step (C) is a step in which development-processing is carried out while supplying the enzyme to the developer.

**10.** The plate making process according to Claim 8 or 9, wherein the developer further comprises a water-soluble polymer compound.

**11.** The plate making process according to any one of the Claim 8 to 10, wherein the development step is carried out using a single solution.

**12.** A replenisher for lithographic printing plate precursor development, comprising an enzyme selected from the EC3 group.

**Patentansprüche**

**1.** Entwickler für einen Lithographiedruckplattenvorläufer, umfassend

(a) ein aus der EC3-Gruppe ausgewähltes Enzym und
(b) ein Tensid.

**2.** Entwickler für einen Lithographiedruckplattenvorläufer gemäß Anspruch 1, worin das Enzym aus der EC3.1-Gruppe oder EC3.4-Gruppe ausgewählt ist.

**3.** Entwickler für einen Lithographiedruckplattenvorläufer gemäß Anspruch 1 oder 2, worin das Enzym ausgewählt ist aus der Gruppe, bestehend aus EC3.1.1.3 (Triacylglycerollipase), EC3.4.11.1 (Leucin-Aminopeptidase), EC3.4.21.62 (Subtilisin), EC3.4.21.63 (Oryzin), EC3.4.22.2 (Papain), EC3.4.22.32 (Stembromelain), EC3.4.23.18 (Aspergillopepsin I), EC3.4.24.25 (Vibriolysin), EC3.4.24.27 (Thermolysin) und EC3.4.24.28 (Bacillolysin).

**4.** Entwickler für einen Lithographiedruckplattenvorläufer gemäß irgendeinem der Ansprüche 1 bis 3, worin das Enzym einen optimalen pH-Wert im alkalischen Bereich aufweist.

**5.** Entwickler für einen Lithographiedruckplattenvorläufer gemäß irgendeinem der Ansprüche 1 bis 4, worin der Entwickler einen pH-Wert von mindestens 6,5, jedoch nicht größer als 11 aufweist.

**6.** Entwickler für einen Lithographiedruckplattenvorläufer gemäß irgendeinem der Ansprüche 1 bis 5, worin der Entwickler ferner eine wasserlösliche Polymerverbindung umfasst.

**7.** Entwickler für einen Lithographiedruckplattenvorläufer gemäß irgendeinem der Ansprüche 1 bis 6, worin der Entwickler eine Pufferfähigkeit aufweist.

**8.** Verfahren zur Herstellung einer Lithographiedruckplatte, umfassend:

(A) einen Schritt zur Herstellung eines Lithographiedruckplattenvorläufers, der oberhalb eines Trägers eine fotoempfindliche Schicht umfasst, umfassend

(i) ein Bindepolymer,
(ii) eine ethylenisch ungesättigte Verbindung, die mindestens eines aufweist, das ausgewählt ist aus der Gruppe, bestehend aus einer Esterbindung, einer Amidbindung, einer tertiären Aminogruppe, einer Urethanbindung, einer Harnstoffbindung, einer Thiourethanbindung und einer Thioharnstoffbindung, und
(iii) einen Initiator der radikalischen Polymerisation;

(B) einen Belichtungsschritt zum Belichten des Lithographiedruckplattenvorläufers; und
(C) einen Entwicklungsschritt zum Entfernen der fotoempfindlichen Schicht in einem nichtbelichteten Bereich des Lithographiedruckplattenvorläufers;

worin der Entwicklungsschritt (C) mit einem Entwickler durchgeführt wird, wie er in irgendeinem der Ansprüche 1 bis 7 definiert ist.

**9.** Plattenherstellungsverfahren gemäß Anspruch 8, worin der Entwicklungsschritt (C) ein Schritt ist, worin eine Entwicklungsverarbeitung durchgeführt wird, während das Enzym zu dem Entwickler zugeführt wird.

**10.** Plattenherstellungsverfahren gemäß Anspruch 8 oder 9, worin der Entwickler ferner eine wasserlösliche Polymerverbindung umfasst.

**11.** Plattenherstellungsverfahren gemäß irgendeinem der Ansprüche 8 bis 10, worin der Entwicklungsschritt durchgeführt wird unter Verwendung einer einzigen Lösung.

**12.** Nachfüllmaterial für die Entwicklung eines Lithographiedruckplattenvorläufers, umfassend ein Enzym, das aus der EC3-Gruppe ausgewählt ist.

## Revendications

**1.** Révélateur pour un précurseur de plaque d'impression lithographique, comprenant

(a) une enzyme sélectionnée dans le groupe EC3
et
(b) un surfactant.

**2.** Révélateur pour un précurseur de plaque d'impression lithographique selon la revendication 1, dans lequel l'enzyme est sélectionnée dans le groupe EC3.1 ou le groupe EC3.4.

**3.** Révélateur pour un précurseur de plaque d'impression lithographique selon la revendication 1 ou 2, dans lequel l'enzyme est sélectionnée dans le groupe constitué d'EC3.1.1.3 (triacylglycérol lipase), d'EC3.4.11.1 (leucine aminopeptidase), d'EC3.4.21.62 (subtilisine), d'EC3.4.21.63 (oryzine), d'EC3.4.22.2 (papaïne), d'EC3.4.22.32 (bromélaïne souche), d'EC3.4.23.18 (aspergillo pepsine I), d'EC3.4.24.25 (vibriolysine), d'EC3.4.24.27 (thermolysine), et d'EC3.4.24.28 (bacillolysine).

**4.** Révélateur pour un précurseur de plaque d'impression lithographique selon l'une quelconque des revendications 1 à 3, dans lequel l'enzyme a un pH optimum dans une région alcaline.

**5.** Révélateur pour un précurseur de plaque d'impression lithographique selon l'une quelconque des revendications 1 à 4, dans lequel le révélateur a un pH d'au moins 6,5 mais de pas plus de 11.

**6.** Révélateur pour un précurseur de plaque d'impression lithographique selon l'une quelconque des revendications 1 à 5, dans lequel le révélateur comprend en outre un composé polymère soluble dans l'eau.

**7.** Révélateur pour un précurseur de plaque d'impression lithographique selon l'une quelconque des revendications 1 à 6, dans lequel le révélateur a une capacité de tampon.

**8.** Procédé de fabrication d'une plaque d'impression lithographique, comprenant :

(A) une étape de préparation d'un précurseur de plaque d'impression lithographique comprenant, au-dessus

d'un support, une couche photosensible comprenant

(i) un polymère de liaison,
(ii) un composé à insaturation éthylénique comprenant au moins un type sélectionné dans le groupe constitué d'une liaison ester, d'une liaison amide, d'un groupe amino tertiaire, d'une liaison uréthane, d'une liaison urée, d'une liaison thiouréthane et d'une liaison thiourée, et
(iii) un initiateur de polymérisation radicale ;

(B) une étape d'exposition consistant à exposer le précurseur de plaque d'impression lithographique ; et
(C) une étape de révélation consistant à retirer la couche photosensible d'une zone non exposée du précurseur de plaque d'impression lithographique ; l'étape de révélation (C) étant réalisée au moyen d'un révélateur tel que défini dans l'une quelconque des revendications 1 à 7.

**9.** Procédé de fabrication de plaque selon la revendication 8, dans lequel l'étape de révélation (C) est une étape dans laquelle un traitement par révélation est réalisé tout en apportant l'enzyme jusqu'au révélateur.

**10.** Procédé de fabrication de plaque selon la revendication 8 ou 9, dans lequel le révélateur comprend en outre un composé polymère soluble dans l'eau.

**11.** Procédé de fabrication de plaque selon l'une quelconque des revendications 8 à 10, dans lequel l'étape de révélation est réalisée en utilisant une seule solution.

**12.** Régénérateur pour révélation de précurseur de plaque d'impression lithographique comprenant une enzyme sélectionnée dans le groupe EC3.

*FIG.1*

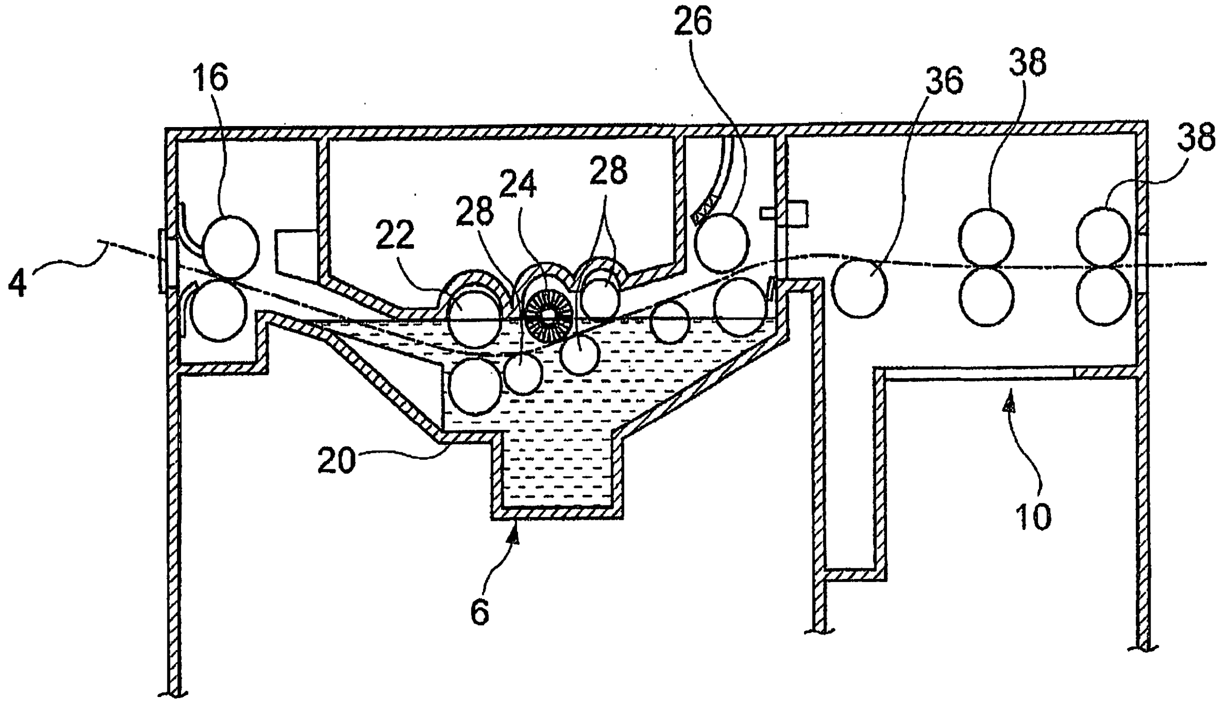

FIG.2

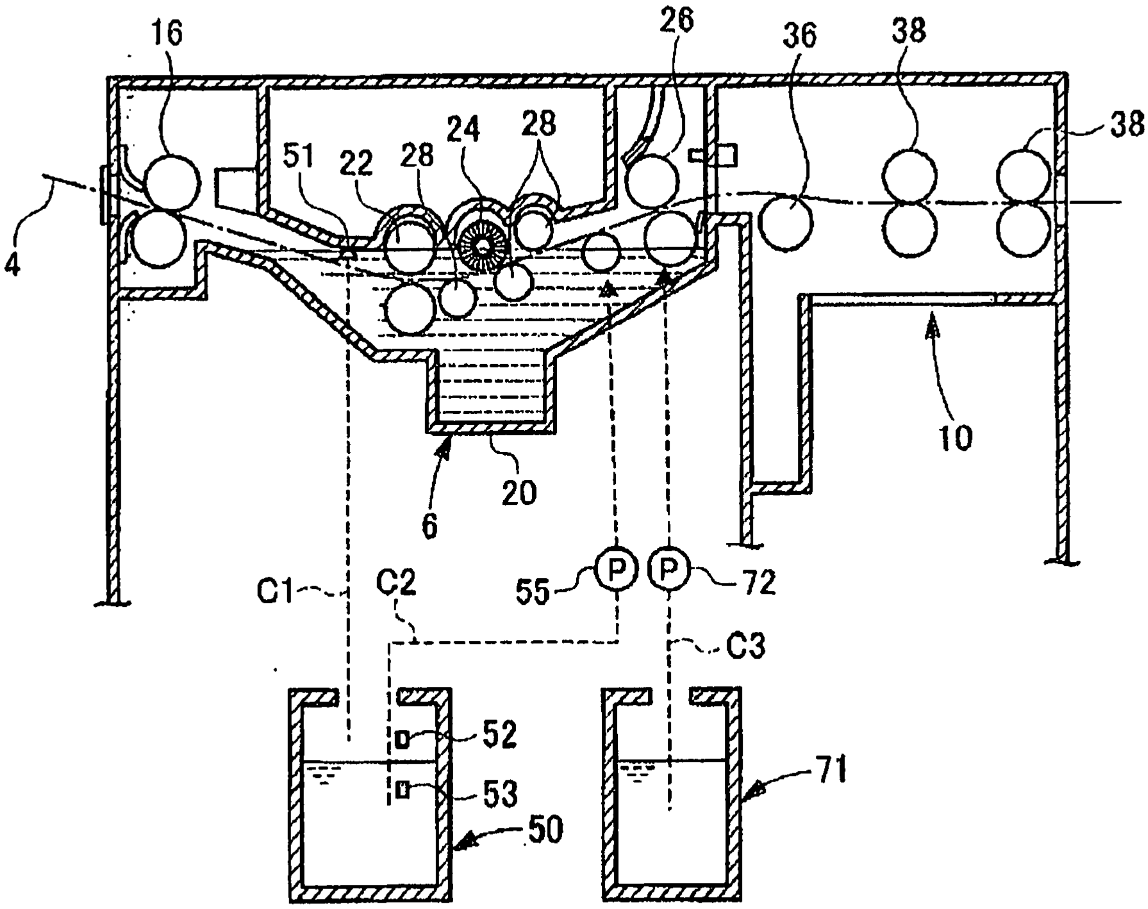

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11065126 A
- EP 1868036 A
- JP 2007538279 W
- JP 9281707 A
- JP 2007206217 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 46027926 B
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 4537377 B
- JP 4486516 B
- JP 2002148790 A
- JP 2001343742 A
- JP 2007171406 A
- JP 2007206216 A
- JP 2007225701 A
- JP 2007225702 A
- JP 2007316582 A
- JP 2007328243 A
- JP 2007058170 A
- JP 2007 A
- JP 316582 A
- JP 2001133969 A
- JP 2002278057 A
- JP 2001277740 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 B
- GB 930422 A
- US 3111407 A
- GB 952807 A
- GB 967074 A
- JP 62293247 A
- JP 2008276155 A
- US 3458311 A
- JP 55049729 B
- US 292501 A
- US 44563 A
- JP 10282679 A
- JP 2304441 A
- JP 5045885 A
- JP 6035174 A
- JP 2008203359 A
- JP 2008276166 A
- JP 2000089478 A

**Non-patent literature cited in the description**


- *Nippon Secchaku Kyokaishi,* 1984, vol. 20 (7), 300-308
- Senryo Binran. 1970
- Saishin Ganryo Binran. Karaa Indekkusu. 1977
- Saishin Ganryo Ouyo Gijutsu. CMC Publishing, 1986
- Insatsu Inki Gijutsu. CMC Publishing, 1984
- Insatsu Inki Gijutsu. Kinzoku Sekken no Seishitsu to Ouyo. CMC Publishing, 1984